# EUROPEAN PATENT SPECIFICATION

(11) **EP 1 415 474 B1**
(45) Date of publication and mention of the grant of the patent: **14.06.2006**
(21) Application number: 01977284.7
(22) Date of filing: 28.09.2001
(51) Int. Cl.: H04N 7/24

(54) **Method and compressor for compressing packet timestamp information**
Verfahren und Kompressor zur Komprimierung von Zeitstempelinformation von Paketen
Procédé et compresseur pour la compression d'information d'horodatage dans des paquets

(30) Priority: 28.09.2000 US 236120 P; 12.10.2000 US 239703 P
(43) Date of publication of application: 06.05.2004
(73) Proprietor: Nokia Corporation, 02150 Espoo (FI)
(72) Inventor: LEON, David, Irving, TX 75038 (US); KHIEM, Le, Coppell, TX 75019 (US)
(74) Representative: Henningsson, Gunnar
(86) International application number: PCT/US2001/030562
(87) International publication number: WO 2002/028107

(56) References cited:
- BORMANN C ET AL: "RObust Header Compression (ROHC) <draft-ietf-rohc-rtp-02.txt>" INTERNET DRAFT, 18 September 2000 (2000-09-18), pages 1-111, XP002249800 cited in the application

## Description

### FIELD OF THE INVENTION

The invention relates to robust header compression. State-of-the-art robust header compression scheme compress the RTP/UDP/IP headers to typically one byte for audio streams and two bytes for video streams. This new scheme compresses the RTP/UDP/IP headers of some video streams to one byte.

### BACKGROUND OF THE INVENTION

The current problem of header compression is that, for some media such as video, both compressed sequence number (SN) and compressed timestamp (TS) have to be sent in most, if not all compressed packets. The invention allows one to send only the SN, and derive TS from SN. The invention is defined by the appended claims.

### SUMMARY OF THE INVENTION

The new scheme takes advantage of the pattern observed in the media stream to allow the compressor to get into the highest compression state (SO or second order state) more often.

Other advantages will be readily appreciated, as the invention becomes better understood by reference to the following detailed description and the accompanying drawings.

### BRIEF DESCRIPTION OF THE DRAWINGS

FIG. 1 shows typical cases of TS as a function of SN for audio;
FIG. 2 shows typical cases of TS as a function of SN for video;
FIG. 3A shows SO pattern, TS as a function of SN;
FIG. 3B shows IP-ID as a function of SN;
FIG. 3C shows M bit as a function of SN; and
FIG. 4 is a logic diagram showing the compressor logical states.

### DETAILED DESCRIPTION OF THE INVENTION

Header compression framework:

For an overview of the robust compression framework, refer to Robust header compression (ROHC), draft-ietf-rohc-rtp-02, draft internet Request For Comments (RFC), which is attached as an appendix hereto. This will be referred to hereafter as the current scheme or ROHC. The compression can be in three different states: initialization, first order, second order. In the initialization state, the compressor sends full header packets (no compression). In first order state, it sends FO packets which contain only encoded dynamically changing fields. A typical FO header size is two bytes or more. In SO state, it sends only an encoded SN. The SO state is defined relative to a pattern that a series of header fields follow. There are different modes in which the compression scheme can operate. In reliable mode, the compressor makes sure, through decompressor acknowledgements, that the decompressor is synchronized before going to a higher compression state. In unidirectional or optimistic mode, if the compressor estimates that under all likelihood the decompressor is synchronized, it then goes to a higher compression state. Optimistic and unidirectional mode require that the decompressor be able, for example through the use of a checksum, to check that the compressor and decompressor are actually synchronized.

### SO pattern:

The current pattern is defined as:
□ second order difference (relative to the SN) of TS being null
□ second order difference of IP-ID being null
□ All remaining fields being constant.

This proves to be very well suited to audio. For a typical audio stream, the pattern should be verified for the packets generated during a talkspurt (i.e. when actual speech is detected and encoded by the encoder). Since no or very few (comfort noise) packets are usually generated during silence, this results in the first few packets of a talkspurt to be sent as FO packets and the rest of the packets sent as SO. However, this pattern is not suited to video.

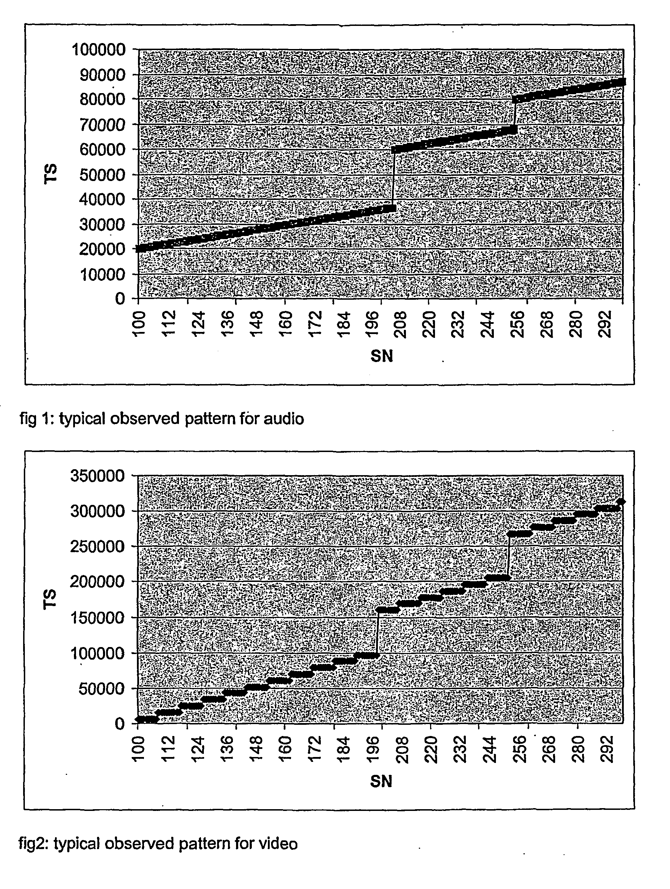

This can be seen on figure 1 and 2, which show typical cases of TS as a function of SN for respectively audio and video. In figure 1, it is clear that the second order difference is zero over long period of times. However in figure 2, timestamp jumps are much more frequent (at every frame boundary) and the second order difference is null only over short period of times (the packets belonging to a given frame which all have the same timestamps).

As a consequence, it might happen that in case of video, the compression state is stuck in FO. In the reliable mode, if the link ROUND-TRIP TIME (RTT) (round trip time) is more than the frame skip (ie the time between two coded frames), the compressor can not reliably get in SO (second order) state. Even in the case of a very fast RTT or in optimistic mode, the compression state would go back to FO at every frame boundary.

As can be seen from figure 2, TS is a staircase function of SN. This staircase function could be a pattern used for SO. However to qualify as a pattern, this function has to be fully known. In other words, the length of a step and the jump between steps should be constant over a large enough period of time, i.e. several times the RTT. We argue here that this can be the case, at least when B frames are not used. B frames are considered later in this document. In effect, payload formats for video encoding are such that a given RTP packet may not contain video data from two different frames. Two consecutive (as generated by the sender application) RTP packets will either have the same RTP timestamp if they carry data from the same picture or their timestamp difference will reflect the time interval between their respective frame sampling instants. Therefore, in order to be predictable, the number of packets per frame and the frame skip should be constant. We show hereafter, that in many cases a video encoder can keep these parameters constant.

For the sake of robustness, video applications can choose to packetize a video frame so that it contains a constant number of macro-bloks or in other words every video frame is sliced identically. This is much as an audio packet covers a given length of audio. The only good reason (at least we can think of) why the sending application would choose to do otherwise is if it wanted to limit the maximum packet size. This would imply that some frames may have more packets than the usual number of packets per frame. However, the number of such frames will often be limited. For example, an intra frame could be sent in a higher number of packets. This would imply that the compression goes to FO when these packets are compressed.

An encoder is given a target frame rate. As long as the encoder matches its target frame rate, the timestamp jump will be constant. However, encoder implementations usually only match an average target frame rate and the frame skip may be variable. Nevertheless, at least in the streaming case, an encoder may use a higher buffer (higher delay) which provides greater flexibility to the rate control and maintain the target frame-rate throughout the connection (or at least over a long period of time). The invention is expected to be useful for the encoders that have been so designed.

In addition, the RTP marker bit should be set only for the last packet of a frame. This can thus also be derived from the pattern.

We therefore define a pattern as:
□ TS is some function f of SN, where f is more general than just linear extrapolation. For example, f can be a staircase function of SN which has constant length steps and constant jumps between steps.
□ The marker bit is also some function g of the SN. For example, the marker bit is set only for the last packet of each step
□ IP-ID second order difference is null (same as audio)

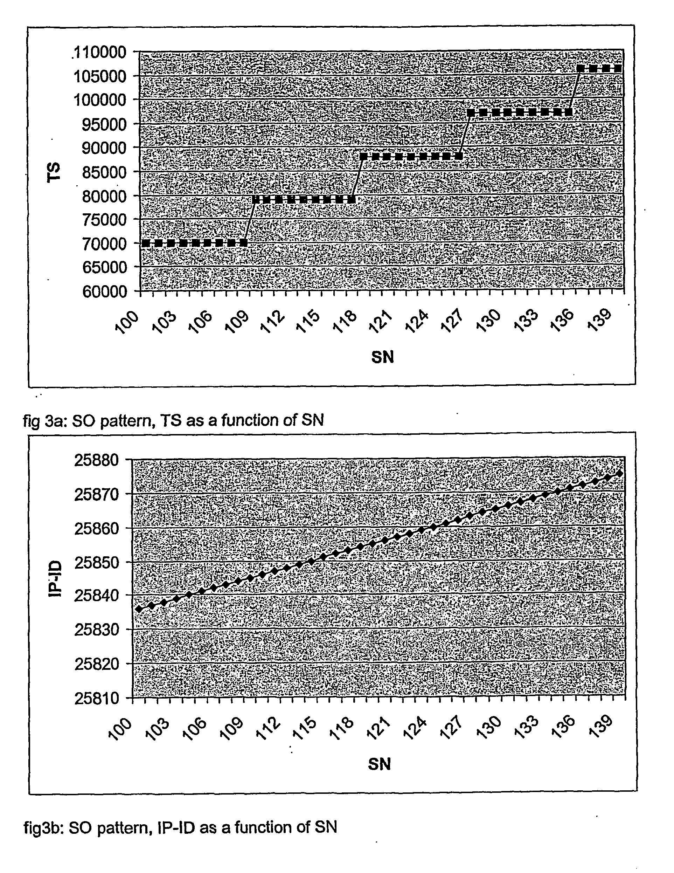

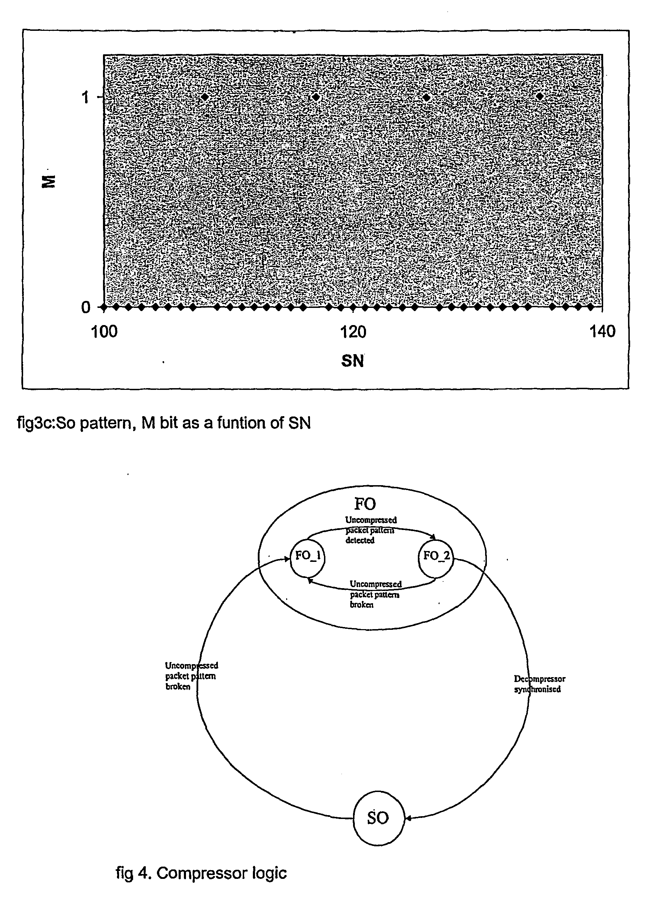

Using the example of video, this pattern is shown on FIGS. 3a, 3b, 3c for a series of 40 packets where the frame rate is 10 (frames per second) fps and the number of packets per frame is 9.

### Compressor and decompressor logic

The only modification to the current scheme introduced by the new pattern is relative to how the compressor and decompressor transitions between the FO and SO state. The compressor is the one making the decision as to which state to operate. The decompressor follows the compressor decisions. It operates in FO state when receiving FO packets and it operates in SO state when receiving SO packets. The compressor logic is shown on figure 4. The

FO state is here conceptually divided up into two sub-states FO_1 and FO_2.

The compressor enters FO in FO_1 and moves to FO_2 if a pattern is detected. The compressor goes from FO_2 to SO when the decompressor is synchronized, that is when the decompressor would be able to decompress SO packets.

The issues peculiar to the new scheme are therefore:
□ How the decompressor decompresses packets in SO state
□ How the compressor acquires the pattern
□ How the compressor knows the decompressor is synchronized in order to get into SO state

We examine hereafter each of these issues.

### SO packets decompression

In SO state, the decompressor must know the pattern functions f and g, in order to decompress SO packets. Again using the video example, the decompressor must know n, the number of packets per frame and TS_inc the timestamp increment between two frames. In addition, it must have previously successfully decompressed a packet which was a first packet frame.

Let call SN_0, TS_0 the sequence number and timestamp of such a packet.

For any incoming SO packet, the decompressor decompresses SN as in the current scheme. If n and m are the quotient and modulo of SN-SN_0 by q, i.e. SN-SN_0=q*n+m, the decompressor computes the packet TS according TS=TS_0+q*TS_inc. The marker bit M is set only if m=n-1. All other fields are obtained as in the current scheme.

### Pattern detection

The compressor can determine the function by observation of the stream/learning or API or some other means. Again using the video example, and assuming stream observation, the new pattern requires getting enough packets from the sender before the decision can be made. This in turn requires to buffer a copy of a certain number of past packets.

The pattern could be detected by searching in this buffer for three packets whose (SN,TS,M,IP-ID) are such that the second order IP-ID differences are null and (SN_1,TS_1,M_1) (SN_2,TS_2,M_2) (SN_3,TS_3,M_3) are such that: $SN_ 2 = SN_ 1 + 1$ $TS_ 3 = TS_ 2$ $M_ 1 = 1$ $M_ 2 = 0$ $M_ 3 = 1$

This implies that SN_2 is a first packet frame and TS_inc=TS_2-TS_1 and The number of packets per frame is n=SN_3-SN_2

There is a particular case where the pattern can be detected by two packets (SN_1,TS_1,M_1) (SN_2,TS_2,M_2) such that: $SN_ 2 = SN_ 1 + 1$ $M_ 1 = 1$ $M_ 2 = 1$

In that case, there is only one packet per frame.

### Decompressor synchronization

In the current scheme, the compressor needs only to get two ACKs from the decompressor to make sure that the latter is synchronized. The decompressor derives from the last two received packets the first order differences required to decompress SO packets.

However, with the new pattern, this is not enough. There are several ways the compressor may make sure the decompressor is synchronized. We suggest here three of them.
□ After detecting the pattern, the compressor can explicitly send the pattern functions f and g to the decompressor using in-band signaling. Again using the video example, the compressor sends n and TS_inc, along with an indication that the marker bit is set only for the last packet of each step. The compressor has just then to make sure that the decompressor has received a packet with a marker bit set (first frame packet). It then knows that the decompressor has all the information needed to decompress the packet. After receiving an FO header carrying the pattern description, the receiver should try to acknowledge packets with the marker bit set so that the compressor can start to send SO packets as soon as possible. Pros: decompressor logic is kept low (no need to perform pattern detection). The compressor does not have to know beforehand if the decompressor is not capable of interpreting the in-band signaling; it can be signaled by a REJECT from the decompressor, with cause "Not recognized". Cons: additional overhead, changes to the current packet format.
□ Alternatively, the compressor can observe the acks received from the decompressor to determine if the decompressor has acquired the pattern functions f and g. The decompressor is also performing pattern detection on the decompressed packets in FO mode. When the pattern is acquired, this will be signaled in the subsequent ACKs sent to the compressor. When the compressor gets enough ACKs to indicate that the pattern has been detected, it can start sending SO packets. Pros: the overhead is kept at a minimum. The in-band signaling format does not have to be standardized. Cons: the decompressor has to perform pattern detection which incurs more complexity and higher delays in the cases where the link loses packets used for detection; The pattern functions have to be standardized. The compressor must also know if the decompressor is capable of detecting the function f (the reception of ACKs alone does not ensure that the decompressor has acquired the function); this could be done by some capability exchange or negotiation.
□ The decompressor performs pattern detection and the compressor also performs pattern detection for the packets which have been acknowledged by the decompressor. In other words, the compressor tries to find if the pattern can be detected using only the packets it is certain the decompressor has received. The decompressor should then choose to acknowledge packets which are known to be enough to detect the pattern, for example the triplet shown above. Pros: no modification needed to the packet format. The same packet formats can be used for the audio pattern and the video pattern. Cons: extra-complexity, delay before entering SO, reduces the freedom of the decoder to choose whether or not to ACK a packet.

### B and PB frames:

We presented the pattern as a typical pattern for video. However, in the case where B frames are used, this pattern is not followed. We don't consider B frames as a typical case for the following reasons:
□ B frames are used only by a limited number of codecs. They are not used in MPEG 4 simple profile.
□ For low bit-rate video conferencing, B-frames are considered not suitable.

This is because the P frame needs to be received before the B-frame can be decoded. For a typical 10 fps frame rate, this would mean an additional 100 ms to the end-to-end delay.

In the case where B-frames are used, there could still be a typical pattern if the encoder chooses to encode a fixed number of B-frames per number of encoded frame, for instance every other frame is a B-frame.

### Conclusion:

This scheme could be beneficial to many applications. There is no penalty if an application does not follow the pattern. In addition, if such a scheme was standardized, it could be an incentive for applications to choose a packetization strategy that is header compression friendly, i.e. which follows the SO pattern. In particular, designers of future video application for 3G mobile terminals could take this into account.

### APPENDIX - DRAFT RFC Robust Header Compression

### draft-ietf-rohc-rtp-02.txt

### RObust Header Compression (ROHC) <draft-ietf-rohc-rtp-02.txt>

### Status of this memo

This document is an Internet-Draft and is in full conformance with all provisions of Section 10 of RFC2026.

Internet-Drafts are working documents of the Internet Engineering Task Force (IETF), its areas, and its working groups. Note that other groups may also distribute working documents as Internet-Drafts.

Internet-Drafts are draft documents valid for a maximum of six months and may be updated, replaced, or obsoleted by other documents at any time. It is inappropriate to use Internet-Drafts as reference material or cite them other than as "work in progress".

The list of current Internet-Drafts can be accessed at http://www.ietf.org/ietf/lid-abstracts.txt

The list of Internet-Draft Shadow Directories can be accessed at http://www.ietf.org/shadow.html

This document is a product of the IETF ROHC WG. Comments should be directed to its mailing list, rohc@cdt.luth.se.

### Abstract

Existing header compression schemes do not work well when used over links with significant error rates, especially when the round-trip time of the link is long. For many bandwidth limited links where header compression is essential, such characteristics are common.

A header compression framework and a highly robust and efficient header compression scheme is introduced in this document, adaptable to the characteristics of the link over which it is used and also to the properties of the packet streams it compresses.

### Revision History

- 02: Major changes after 48th IETF
- 01: Minor editorial changes for 48th IETF
- 00: Document created from ROHC submissions

**Table of contents**

| | |
|---|---|
| Status of this memo | 1 |
| Abstract | 2 |
| Revision History | 2 |
| Table of contents | 3 |
| 0. ROHC WG internal short-term time plan | 7 |
| 1. Introduction | 8 |
| 2. Terminology | 10 |
| 3. Background | 14 |
| 3.1. Header compression fundamentals | 14 |
| 3.2. Existing header compression schemes | 14 |
| 3.3. Requirements on a new header compression scheme | 16 |
| 3.4. Classification of header fields | 16 |
| 4. Header compression framework | 18 |
| 4.1. Operating assumptions | 18 |
| 4.2. Dynamicity | 19 |
| 4.3. Compression and decompression states | 20 |
| 4.3.1. Compressor states | 20 |
| 4.3.1.1. Initiation and Refresh (IR) State | 21 |
| 4.3.1.2. First Order (FO) State | 21 |
| 4.3.1.3. Second Order (SO) State | 21 |
| 4.3.2. Decompressor states | 22 |
| 4.4. Modes of operation | 22 |
| 4.4.1. Unidirectional mode - U-mode | 23 |
| 4.4.2. Bi-directional optimistic mode - O-mode | 24 |
| 4.4.3. Bi-directional reliable mode - R-mode | 24 |
| 4.5. Encoding methods | 24 |
| 4.5.1. Least Significant Bits (LSB) encoding | 24 |
| 4.5.2 Window-based LSB encoding (W-LSB encoding) | 26 |
| 4.5.3 Scaled RTP Timestamp encoding | 27 |
| 4.5.4 Timer-Based Compression of RTP Timestamp | 29 |
| 4.5.5 Offset IP-ID encoding | 31 |
| 4.5.6. Self-contained variable-length values | 32 |
| 4.5.7. Encoded values across several fields in compressed headers | 32 |
| 5. The protocol | 34 |
| 5.1. Data structures | 34 |
| 5.1.1. Per-channel parameters | 34 |
| 5.1.2. Per-CID parameters, profiles | 34 |
| 5.1.3. Contexts | 34 |
| 5.2. Packet types | 34 |
| 5.2.1. Packet formats from compressor to decompressor | 35 |
| 5.2.2. Feedback packets from decompressor to compressor | 36 |
| 5.2.3. Parameters needed for mode transition | 36 |
| 5.3. Operation in unidirectional mode | 37 |
| 5.3.1. Compressor states and logic (U-mode) | 38 |
| 5.3.1.1. State transition logic (U-mode) | 37 |
| 5.3,1.1.1. Optimistic approach, upwards transition | 37 |
| 5.3.1.1.2. Timeouts, downward transition | 38 |
| 5.3.1.1.3. Need for updates, downward transition | 38 |
| 5.3,1.2. Compression logic and packets used (U-mode) | 38 |
| 5.3.1.3. Feedback in unidirectional mode | 38 |
| 5.3.2. Decompressor states and logic (U-mode) | 39 |
| 5.3.2.1. State transition logic (U-mode) | 39 |
| 5.3.2.2. Decompression logic (U-mode) | 39 |
| 5.3.2.2.1. Decide whether decompression is allowed | 39 |
| 5.3.2.2.2. Reconstruct and verify the header | 40 |
| 5.3.2.2.3. Causes for CRC mismatches | 40 |
| 5.3.2.2.4. Detection of context damage | 41 |
| 5.3.2.2.5. Repair of SN wrap-around | 41 |
| 5.3.2.2.6. Repair of incorrect SN updates | 42 |
| 5.3.2.3. Feedback in unidirectional mode | 43 |
| 5.4. Operation in bi-directional optimistic mode | 44 |
| 5.4.1. Compressor states and logic (O-mode) | 44 |
| 5.4.1.1. State transition logic | 44 |
| 5.4.1.1.1. Context requests, negative acknowledgements (NACKs) | 44 |
| 5.4.1.1.2. Optional acknowledgements | 44 |
| 5.4.1.2. Compression logic and packets used | 44 |
| 5.4.2. Decompressor states and logic | 45 |
| 5.4.2.1. Decompression logic | 45 |
| 5.4.2.1.1. Timer-based timestamp decompression | 45 |
| 5.4.2.2. Feedback logic | 45 |
| 5.5. Operation in bi-directional reliable mode | 46 |
| 5.5.1. Compressor states and logic | 46 |
| 5.5.2. Decompressor states and logic | 46 |
| 5.5.2.1. Decompression logic | 46 |
| 5.5.2.2. Feedback logic | 46 |
| 5.6. Mode transitions | 48 |
| 5.6.1. Compression and decompression during mode transitions | 48 |
| 5.6.2. Transition from Unidirectional to Optimistic mode | 49 |
| 5.6.3. From Optimistic to Reliable mode | 50 |
| 5.6.4. From Unidirectional to Reliable mode | 50 |
| 5.6.5. From Reliable to Optimistic mode | 50 |
| 5.6.6. Transition to Unidirectional mode | 51 |
| 5.7. Packet formats | 53 |
| 5.7.1. Packet type 0: UO-0, R-0, R-0-CRC | 53 |
| 5.7.2. Packet type 1 (R-mode): R-1, R-1-TS, R-1-ID | 53 |
| 5.7.3. Packet type 1 (UO-modes): UO-1, UO-1-ID, UO-1-TS | 55 |
| 5.7.4. Packet type 2: UOR-2 | 56 |
| 5.7.5. Extension formats | 57 |
| 5.7.6. Feedback packets: FEEDBACK-3 and FEEDBACK-4 | 60 |
| 5.7.7 IR and IR-DYN packets | 62 |
| 5.7.7.1 Basic structure of the IR packet | 62 |
| 5.7.7.2. Basic structure of the IR-DYN packet | 63 |
| 5.7.7.3. Initialization of IPv6 Header [IPv6] | 64 |
| 5.7.7.4. Initialization of IPv4 Header [IPv4, section 3.1] | 65 |
| 5.7.7.5. Initialization of UDP Header [RFC-768] | 65 |
| 5.7.7.6. Initialization of RTP Header [RTP] | 66 |
| 5.7.7.7. Minimal Encapsulation header [RFC-2004, section 3.1] | 67 |
| 5.8. List-Based Compression | 68 |
| 5.8.1. CSRC compression | 68 |
| 5.8.1-1. Transformation Classification for CSRC List | 68 |
| 5.8.1.2. Encoding Schemes | 68 |
| 5.8.1.3. Format of compressed CSRC list | 69 |
| 5.8.1.3.1 Insertion Only Scheme | 69 |
| 5.8.1.3.1.1 R-mode | 69 |
| 5.8.1.3.1.2 UO-modes | 70 |
| 5.8.1.3.2 Removal Only Scheme | 71 |
| 5.8.1.3.2.1 R-mode | 71 |
| 5.8.1.3.2.2 UO-mode | 71 |
| 5.8.1.3.3 Generic Scheme | 72 |
| 5.8.1.3.3.1 R-mode | 72 |
| 5.8.1.3.3.2 UO-mode | 73 |
| 5.8.2. Header Compression for IPv6 Extension Headers | 73 |
| 5.8.2.1. Terminology | 74 |
| 5.8.2.2. Transformation Classification and Encoding Schemes | 74 |
| 5.8.2.2.1 Transformation Classification | 74 |
| 5.8.2.2.2 Encoding Schemes | 75 |
| 5.8.2.2.3 Special Handling | 75 |
| 5.8.2.2.3.1 Special Handling of AH | 75 |
| 5.8.2.2.3.2 Encapsulating Security Payload Header | 76 |
| 5.8.2.2.3.3 Special Handling of Next Header Field | 76 |
| 5.8.2.3. Packet Format | 78 |
| 5.8.2.3.1. Format in extension "11" header | 78 |
| 5.8.2.3.2 Format of compressed IPv6 extension header | 79 |
| 5.8.2.3.2.1 Insertion Only Scheme | 79 |
| 5.8.2.3.2.1.1 R-mode | 79 |
| 5.8.2.3.2.2 Removal Only Scheme | 80 |
| 5.8.2.3.2.2.1 R-mode | 80 |
| 5.8.2.3.2.3 Content Change Only Scheme | 81 |
| 5.8.2.3.2.3.1 R-mode | 81 |
| 5.8.2.3.2.3.2 UO-mode | 82 |
| 5.8.2.3.2.4 Uncompressed Scheme (common to R-mode and UO-modes) | 82 |
| 5.9. Header compression CRCs, coverage and polynomials | 83 |
| 5.9.1. IR & IR-DYN packet CRCs | 83 |
| 5.9.2. CRCs in compressed packets | 83 |
| 6. Implementation issues | 84 |
| 6.1. Reverse decompression | 84 |
| 6.2. RTCP | 85 |
| 7. Further work | 86 |
| 7.3. Tunneling | 86 |
| 7.3.1. Header Compression for IPv4 Tunneling Header | 86 |
| 7.3.1.1. Mobile IPv4 Tunneling Header Fields Type | 86 |
| 7.3.1.2. Compression of Tunneling Headers in MIPv4 | 87 |
| 7.3.1.2.1. IP in IP Encapsulation in IPv4 | 87 |
| 7.3.1.2.2. Minimum Encapsulation in IPv4 | 87 |
| 7.3.1.2.3. Generic Routing Encapsulation in IPv4 | 87 |
| 7.4. non-RTP UDP traffic | 88 |
| 8. Section 8 has been removed | 90 |
| 9. Security considerations | 90 |
| 10. Acknowledgements | 90 |
| 11. Intellectual property considerations | 91 |
| 12. References | 92 |
| 13. Authors' addresses | 93 |
| Appendix A. Detailed classification of header fields | 94 |
| A.1. General classification | 94 |
| A.1.1. IPv6 header fields | 95 |
| A.1.2. IPv4 header fields | 96 |
| A.1.3. UDP header fields | 98 |
| A.1.4. RTP header fields | 99 |
| A.1.5. Summary for IP/UDP/RTP | 100 |
| A.2. Analysis of change patterns of header fields | 100 |
| A.2.1. IPv4 Identification | 102 |
| A.2.2. IP Traffic-Class / Type-Of-Service | 103 |
| A.2.3. IP Hop-Limit / Time-To-Live | 104 |
| A.2.4. UDP Checksum | 104 |
| A.2.5. RTP CSRC Counter | 104 |
| A.2.6. RTP Marker | 104 |
| A.2.7. RTP Payload Type | 104 |
| A.2.8. RTP Sequence Number | 104 |
| A.2.9. RTP Timestamp | 104 |
| A.2.10. RTP Contributing Sources (CSRC) | 105 |
| A.3. Header compression strategies | 105 |
| A.3.1. Do not send at all | 105 |
| A.3.2. Transmit only initially | 106 |
| A.3.3. Transmit initially, but be prepared to update | 106 |
| A.3.4. Be prepared to update or send as-is frequently | 106 |
| A.3.5. Guarantee continuous robustness | 106 |
| A.3.6. Transmit as-is in all packets | 107 |
| A.3.7. Establish and be prepared to update delta | 107 |
| Appendix E - Encoding Examples | 108 |
| E.1. Basic VLE | 108 |
| E.2. Timer-Based VLE | 109 |

(Editor's note: The TOC has not necessarily been updated.

I have marked text I consider questionable by making it italic, and text that I think simply should be deleted by striking it through.)

### 0. ROHC WG internal short-term time plan

This document captures the state of the ROHC RTP specification as on September 18, 2000. For information, the ROHC WG internal short-term time plan is as follows:
- 18 September: ROHC-02 completed (this document)

### Draft review and discussion

Complementary contributions created
- 29 September: Cutoff for draft review and discussion
- 02 October: ROHC-03 completed
- 04 October: Judge whether draft ready for last call

If not judged ready for WG last call at this point:
- 04 October: Identify what is missing/incorrect

Further discussion and contributions
- 13 October: Cutoff for "second" draft review and discussion
- 16 October: ROHC-04 Completed

WG Last call at completion of ROHC-03 or ROHC-04, respectively (depending on progress as indicated above)

### 1. Introduction

During the last five years, two communication technologies in particular have become commonly used by the general public: cellular telephony and the Internet. Cellular telephony has provided its users with the revolutionary possibility of always being reachable with reasonable service quality no matter where they are. The main service provided by the dedicated terminals has been speech. The Internet, on the other hand, has from the beginning been designed for multiple services and its flexibility for all kinds of usage has been one of its strengths. Internet terminals have usually been general-purpose and have been attached over fixed connections. The experienced quality of some services (such as Internet telephony) has sometimes been low.

Today, IP telephony is gaining momentum thanks to improved technical solutions. It seems reasonable to believe that in the years to come, IP will become a commonly used way to carry telephony. Some future cellular telephony links might also be based on IP and IP telephony. Cellular phones may have become more general-purpose, and may have IP stacks supporting not only audio and video, but also web browsing, email, gaming, etc.

One of the scenarios we are envisioning might then be the one in Figure 1.1, where two mobile terminals are communicating with each other. Both are connected to base stations over cellular links, and the base stations are connected to each other through a wired (or possibly wireless) network. Instead of two mobile terminals, there could of course be one mobile and one wired terminal, but the case with two cellular links is technically more demanding.

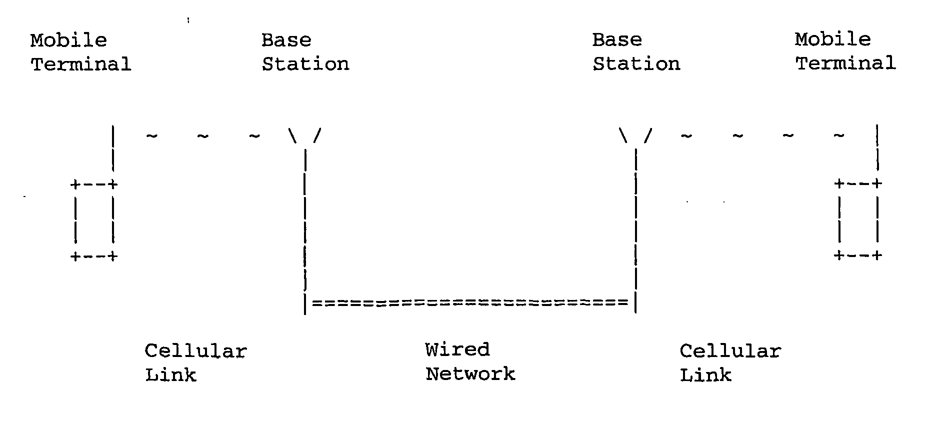

It is obvious that the wired network can be IP-based. With the cellular links, the situation is less clear. IP could be terminated in the fixed network, and special solutions implemented for each supported service over the cellular link. However, this would limit the flexibility of the services supported. If technically and economically feasible, a solution with pure IP all the way from terminal to terminal would have certain advantages. However, to make this a viable alternative, a number of problems have to be addressed, in particular problems regarding bandwidth efficiency.

For cellular phone systems, it is of vital importance to use the scarce radio resources in an efficient way. A sufficient number of users per cell is crucial, otherwise deployment costs will be prohibitive [CELL]. The quality of the voice service should also be as good as in today's cellular systems. It is likely that even with support for new services, lower quality of the voice service is acceptable only if costs are significantly reduced.

A problem with IP over cellular links when used for interactive voice conversations is the large header overhead. Speech data for IP telephony will most likely be carried by RTP [RTP]. A packet will then, in addition to link layer framing, have an IP [IPv4] header (20 octets), a UDP [UDP] header (8 octets), and an RTP header (12 octets) for a total of 40 octets. With IPv6 [IPv6], the IP header is 40 octets for a total of 60 octets. The size of the payload depends on the speech coding and frame sizes being used and may be as low as 15-20 octets.

From these numbers, the need for reducing header sizes for efficiency reasons is obvious. However, cellular links have characteristics that make header compression as defined in [IPHC,CRTP,PPPHC] perform less than well. The most important characteristic is the lossy behavior of cellular links, where a bit error rate (BER) as high as le-3 must be accepted to keep the radio resources efficiently utilized [CELL]. In severe operating situations, the BER can be as high as 1e-2. The other problematic characteristic is the long round-trip time (RTT) of the cellular link, which can be as high as 100-200 milliseconds [CELL]. An additional problem is that the residual BER is nontrivial, i.e., lower layers can sometimes deliver frames containing undetected errors. A viable header compression scheme for cellular links must be able to handle loss on the link between the compression and decompression point as well as loss before the compression point.

Bandwidth is the most costly resource in cellular links. Processing power is very cheap in comparison. Implementation or computational simplicity of a header compression scheme is therefore of less importance than its compression ratio and robustness.

### 2. Terminology

The key words "MUST", "MUST NOT", "REQUIRED", "SHALL", "SHALL NOT", "SHOULD", "SHOULD NOT", "RECOMMENDED", "MAY", and "OPTIONAL" in this document are to be interpreted as described in RFC 2119.

### BER

Bit Error Rate. Cellular radio links can have a rather high BER. In this document BER is usually given as a probability, but one also needs to consider the error distribution as bit errors are not independent.

### Cellular links

Wireless links between mobile terminals and base stations. The BER and the RTT are rather high in order to achieve an efficient system overall.

### Compression efficiency

The performance of a header compression scheme can be described with three parameters, compression efficiency, robustness and compression transparency. The compression efficiency is determined by how much the header sizes are reduced by the compression scheme.

### Compression transparency

The performance of a header compression scheme can be described with three parameters, compression efficiency, robustness and compression transparency. The compression transparency is a measure for how well the scheme ensures that the decompressed headers are semantically identical to the original headers. If all decompressed headers are semantically identical to the corresponding original headers, the transparency is 100 per cent. Compression transparency is high when damage propagation is low.

### Context

The context is the state which the compressor uses to compress a header and which the decompressor uses to decompress a header. The context basically contains the uncompressed version of the last header sent (compressor) or received (decompressor) over the link, except for fields in the header that are included "as-is" in compressed headers or can be inferred from, e.g., the size of the link-level frame. The context can also contain additional

When the context of the decompressor is not consistent with the context of the compressor, header decompression may fail to reproduce the original header. This situation can occur when the context of the decompressor has not been initialized properly or when packets have been lost or damaged between compressor and decompressor. Packets for which the decompressor detects they cannot be decompressed due to inconsistent contexts are said to be lost due to context damage.

### Context repair mechanism

To avoid excessive context damage, a context repair mechanism is needed. Context repair mechanisms can be based on explicit requests for context updates, periodic updates sent by the compressor, or methods for local repair at the decompressor side.

### Damage propagation

Generation of incorrect decompressed headers due to damage to previous packet(s).

### Loss propagation

Failure to decompress headers due to loss of previous frame(s).

### Error detection

Detection of errors. If error detection is not perfect, there will be residual errors.

### Error propagation

Damage propagation or loss propagation.

### FLR

Frame Loss Rate, given as a probability that a frame is lost on the channel between compressor and decompressor. (In contrast, frames lost due to context damage contribute to the packet loss rate.)

### Frame

Packet emitted by the compressor/received by the decompressor. Note that, in this document, there is no relationship to other (e.g. physical layer) frame concepts such as radio frames. compression framework introduced in this document. The profile concept makes use of profile identifiers to separate different profiles which are used when setting up the compression scheme. All variations and parameters of the header compression scheme that are not part of the context state are handled by different profile identifiers.

(Editor's note: the profile concept is not finalized yet -- this text is based on the current state of the present document.)

### Packet

Generally, a unit of transmission and reception (protocol data unit). Specifically, when contrasted to "frame", the packet compressed and then decompressed by ROHC. Also called "uncompressed packet".

### Pre-HC links

Pre-HC links are all links a packet has traversed before the header compression point. If we consider a path with cellular links as first and last hops, the Pre-HC links for the compressor at the last link are the first cellular link plus the wired links in between.

### Residual error

Error introduced during transmission and not detected by lower-layer error detection schemes.

### Robustness

The performance of a header compression scheme can be described with three parameters, compression efficiency, robustness and compression transparency. A robust scheme tolerates errors on the link over which header compression takes place (including both frame losses and residual bit errors) without losing additional packets, introducing additional errors, or using more bandwidth.

### RTT

Round-trip time -- The time it takes to send a packet from compressor to decompressor and back again from decompressor to compressor.

### Spectrum efficiency

Radio resources are limited and expensive. Therefore they must be used efficiently to make the system economically feasible. In cellular systems this is achieved by maximizing the number of users served within each cell, while the quality of the provided services is kept at an acceptable level. A consequence of efficient spectrum use is a high rate of errors (frame loss and residual bit errors), even after channel coding with error correction.

### Timestamp stride

The timestamp stride (TS STRIDE) is the increase in the timestamp value between two consecutive packets.

### 3. Background

This chapter provides a background to the subject of header compression. The fundamental ideas are described together with descriptions of existing header compression schemes, their drawbacks and requirements and motivation for new header compression solutions.

### 3.1. Header compression fundamentals

The main reason why header compression can be done at all is the fact that there is significant redundancy between header fields, both within the same packet header but in particular between consecutive packets belonging to the same packet stream. By sending static field information only initially and utilizing dependencies and predictability for other fields, the header size can be significantly reduced for most packets.

In general, header compression methods maintain a context, which is essentially the uncompressed version of the last header sent over the link, plus some additional information, at both compressor and decompressor. Compression and decompression are done relative to the context. When compressed headers carry differences from the previous header, each compressed header will update the context of the decompressor. In this case, when a packet is lost between compressor and decompressor, the context of the decompressor will be brought out of sync since it is not updated correctly. A header compression method must have a way to repair the context, i.e., bring it into sync, after such events.

### 3.2. Existing header compression schemes

The original header compression scheme, CTCP [VJHC], was invented by Van Jacobson. CTCP compresses the 40 octet IP+TCP header to 4 octets. The CTCP compressor detects transport-level retransmissions and sends a header that updates the context completely when they occur. This repair mechanism does not require any explicit signaling between compressor and decompressor.

A general IP header compression scheme, IP header compression [IPHC], improves somewhat on CTCP and can compress arbitrary IP, TCP, and UDP headers. When compressing non-TCP headers, IPHC does not use delta encoding and is robust. When compressing TCP, the repair mechanism of CTCP is augmented with a link-level nacking scheme which speeds up the repair. IPHC does not compress RTP headers.

CRTP [CRTP, IPHC] by Casner and Jacobson is a header compression scheme that compresses 40 octets of IPv4/UDP/RTP headers to a minimum of 2 octets when no UDP checksum is present. If the UDP checksum is present, the minimum CRTP header is 4 octets. CRTP cannot use the same repair mechanism as CTCP since UDP/RTP does not retransmit. Instead, CRTP uses explicit signaling messages from decompressor to compressor, called CONTEXT_STATE messages, to indicate that the context is out of sync. The link roundtrip time will thus limit the speed of this context repair mechanism.

On lossy links with long roundtrip times, such as most cellular links, CRTP does not perform well. Each lost packet over the link causes several subsequent packets to be lost since the context is out of sync during at least one link roundtrip time. This behavior is documented in [CRTPC]. For voice conversations such long loss events will degrade the voice quality. Moreover, bandwidth is wasted by the large headers sent by CRTP when updating the context. [CRTPC] found that CRTP did not perform well enough for a lossy cellular link. It is clear that CRTP alone is not a viable header compression scheme for IP telephony over cellular links.

To avoid losing packets due to the context being out of sync, CRTP decompressors can attempt to repair the context locally by using a mechanism known as TWICE. Each CRTP packet contains a counter which is incremented by one for each packet sent out by the CRTP compressor. If the counter increases by more than one, at least one packet was lost over the link. The decompressor then attempts to repair the context by guessing how the lost packet(s) would have updated it. The guess is then verified by decompressing the packet and checking the UDP checksum - if it succeeds, the repair is deemed successful and the packet can be forwarded or delivered. TWICE has got its name from the observation that when the compressed packet stream is regular, the correct guess is to apply the update in the current packet twice. [CRTPC] found that even with TWICE, CRTP doubled the number of lost packets. TWICE improves CRTP performance significantly. However, there are several problems with using TWICE:
1) It becomes mandatory to use the UDP checksum:
   - the minimal compressed header size increases by 100% to 4 octets.
   - most speech codecs developed for cellular links tolerate errors in the encoded data. Such codecs will not want to enable the UDP checksum, since they do want damaged packets to be delivered.
   - errors in the payload will make the UDP checksum fail when the guess is correct (and might make it succeed when it is wrong).
2) Loss in an RTP stream that occurs before the compression point will make updates in CRTP headers less regular. Simple-minded versions of TWICE will then perform badly. More sophisticated versions would need more repair attempts to succeed.

### 3.3. Requirements on a new header compression scheme

The major problem with CRTP is that it is not sufficiently robust against packets being damaged between compressor and decompressor. A viable header compression scheme must be less fragile. This increased robustness must be obtained without increasing the compressed header size; a larger header would make IP telephony over cellular links economically unattractive.

A major cause of the bad performance of CRTP over cellular links is the long link roundtrip time, during which many packets are lost when the context is out of sync. This problem can be attacked directly by finding ways to reduce the link roundtrip time. Future generations of cellular technologies may indeed achieve lower link roundtrip times. However, these will probably always be rather high [CELL]. The benefits in terms of lower loss and smaller bandwidth demands if the context can be repaired locally will be present even if the link roundtrip time is decreased. A reliable way to detect a successful context repair is then needed.

One might argue that a better way to solve the problem is to improve the cellular link so that packet loss is less likely to occur. Such modifications do not appear to come for free, however. If links were made (almost) error free, the system might not be able to support a sufficiently large number of users per cell and might thus be economically infeasible [CELL].

One might also argue that the speech codecs should be able to deal with the kind of packet loss induced by CRTP, in particular since the speech codecs probably must be able to deal with packet loss anyway if the RTP stream crosses the Internet. While the latter is true, the kind of loss induced by CRTP is difficult to deal with. It is usually not possible to completely hide a loss event where well over 100 ms worth of sound is completely lost. If such loss occurs frequently at both ends of the end-to-end path, the speech quality will suffer.

A detailed description of the requirements specified for ROHC may be found in [REQ].

### 3.4. Classification of header fields

As mentioned earlier, header compression is possible due to the fact that there is much redundancy between header field values within packets, but especially between consecutive packets. To utilize these properties for header compression, it is important to understand the change patterns of the various header fields.

All header fields have been classified in detail in appendix A. The fields are first classified on a high level and then some of them are studied more in detail. Finally, the appendix concludes with recommendations about how the various fields should be handled by header compression algorithms. The main conclusion that can be drawn is that most of the header fields can easily be compressed away since they never or seldom change. Only 5 fields, with a combined size of about 10 octets, need more sophisticated mechanisms. Those fields are:
- IPv4 Identification (16 bits) - IP-ID
- UDP Checksum (16 bits)
- RTP Marker (1 bit) - M-bit
- RTP Sequence Number (16 bits) - SN
- RTP Timestamp (32 bits) - TS

The analysis in Appendix A reveals that the values of the TS and IP-ID fields can usually be predicted from the RTP Sequence Number, which increments by one for each packet emitted by an RTP source. M-bit is also usually the same, but needs to be communicated explicitly occasionally. The UDP checksum should not be predicted and is sent as-is when enabled.

The way ROHC RTP compression operates, then, is to first establish functions from SN to the other fields, and then reliably communicate the SN. Whenever a functions from SN to another field changes, i.e., the existing function gives a result which is different from the field in the header to be compressed, additional information is sent to update the parameters of that function.

### 4. Header compression framework

### 4.1. Operating assumptions

The cellular links which are a primary target for ROHC have a number of characteristics that are briefly described here. ROHC requires functionality from lower layers which is outlined here and more thoroughly described in the lower layer requirements document [LLG].

### Channels

ROHC header-compressed packets flow on channels. Unlike most fixed links, some cellular radio links can have several channels connecting the same pair of nodes. Each channel can have different characteristics in terms of error rate, bandwidth, etc.

### Context identifiers

On some channels, the ability to transport multiple packet streams is required. It can also be feasible to have channels dedicated to individual packet streams. Therefore, ROHC uses a distinct context identifier space per channel and eliminates context identifiers completely in channels where only a single packet stream is compressed.

### Packet type indication

Packet type indication is done in the header compression scheme itself. Unless the link already has a way of indicating packet types which can be used, such as PPP, this provides smaller compressed headers, overall. It may also be less difficult to allocate a single packet type, rather than many, in order to run ROHC over links such as PPP.

### Reordering

The channel between compressor and decompressor is not assumed to reorder packets, i.e., the decompressor receives packets in the same order as the compressor sends them. Reordering before the compression point, however, is dealt with.

### Packet length

ROHC is designed under the assumption that lower layers can provide the length of a compressed packet. ROHC packets do not contain length information for the payload.

### Framing

The link layer must provide framing, which makes it possible to distinguish frame boundaries and individual frames.

### Error detection/protection

The ROHC scheme has been designed to cope with residual errors in the headers delivered to the decompressor. CRCs and sanity checks are used to prevent or reduce damage propagation. However, it is RECOMMENDED that lower layers deploy error detection for ROHC headers and do not deliver ROHC headers with a high residual error rate.

Without giving a hard limit on the residual error rate acceptable to ROHC, it is noted that for a residual bit error rate of at most 1E-5, the ROHC scheme has been designed not to increase the number of damaged headers, i.e., the number of damaged headers due to damage propagation is designed to be less than the number of damaged headers caught by the ROHC error detection scheme.

### Negotiation

In addition to the packet handling mechanisms above, the link layer MUST provide a way to negotiate header compression parameters. (For unidirectional links, this negotiation may be performed out-of-band or even a-priori.)

### 4.2. Dynamicity

[[This section will contain introductory text to the dynamic state information maintained in the protocol entities running the ROHC protocol, e.g., which parameters are established in per-channel negotiation, which constitute the stream (i.e., changing them creates a different stream), and which are part of the per-stream context and thus changeable during the lifetime of the stream.]]

### Channel setup.

### (configured or negotiated at or before channel setup time):

Set of acceptable profiles.
MAX-HEADER.
Size of CID space.

### Stream setup:

### (negotiated at stream setup time.)

Profile. Change of profile implies new stream.

### Per-stream context:

### (changeable during lifetime of a stream)

Context in :
Current value of all header fields. (from this one can deduce
   IPv4 header present,
   UDP checksum enabled)
Additional context not in header:
   TS STRIDE
   IP-ID in network byte order?
   IP-ID is random?
   A number of old reference headers.
   Compressor & decompressor state.

### 4.3. Compression and decompression states

Header compression with ROHC can be characterized as an interaction between two state machines, one compressor machine and one decompressor machine. The compressor and the decompressor have three states each, which in many ways are related to each other even if the meaning of the states are slightly different for the two parties. Both machines start in the lowest compression state and transits gradually to higher states. Transitions need not be synchronized between the two machines and normally the compressor is the only one that temporarily may transit back to lower states.

Subsequent sections present an overview of the state machines and their corresponding states respectively, starting with the compressor.

### 4.3.1. Compressor states

For ROHC compression, the three compressor states are the Initiation and Refresh (IR), First Order (FO), and Second Order (SO) states. The compressor starts in the lowest compression state (IR) and transits gradually to higher compression states. The compressor will always operate in the highest possible compression state, under the constraint that the compressor is sufficiently confident that the decompressor has the information necessary to decompress a header compressed according to that state.

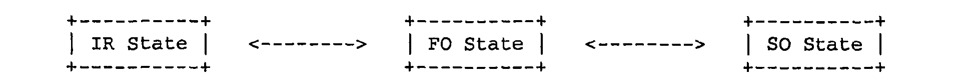

Decisions about transitions between the various compression states are taken by the compressor based on:
- variations in packet headers.
- positive feedback from decompressor (Acknowledgements - ACKs)
- negative feedback from decompressor (Negative ACKs - NACKs)
- periodic timeouts (when feedback is not present)

How transitions are performed is explained in detail in chapter 5 for each mode of operation.

### 4.3.1.1. Initiation and Refresh (IR) State

The purpose of the IR state is to initialize the static parts of the context at the decompressor or to recover after failure. In this state, the compressor sends complete header information. This includes all static and non-static fields in uncompressed form plus some additional information. Refreshes may also be performed on non-static information only.

The compressor should stay in IR state until it is rather confident that the decompressor has received the information correctly.

### 4.3.1.2. First Order (FO) State

The purpose of the FO state is to efficiently communicate irregularities in the packet stream. When operating in this state, the compressor rarely sends complete information and the information sent is usually compressed at least partially. The difference between IR and FO should therefore be clear.

The compressor enters this state when the headers of the packet stream does not conform to their previous pattern, and it stays there until it is confident that the decompressor has acquired all the parameters of the new pattern. Fields that are always irregular do not require FO since they must be communicated in all packets and is therefore part of what is a uniform pattern.

Since packets sent in the FO state usually carry context updating information, successful transmission of the FO information may be of vital importance for successful decompression of subsequent packets. The decompression process is sensitive to loss of, or damage of, FO packets in transit.

### 4.3.1.3. Second Order (SO) State

This is the state where compression is optimal. The compressor enters SO state when the header to be compressed is completely predictable given the SN, and the compressor is sufficiently confident that the decompressor has acquired all parameters of the functions from SN to other fields. Packets sent in SO state are almost independent of each other and error sensitivity is therefore low. However, successful decompression of packets sent in SO state requires that the information sent in preceding FO state operations has been successfully received by the decompressor.

The amount of information sent in the SO state is usually fixed. However, it may vary on a long term basis since the compressor can decide to increase the information amount to send in the SO state by using a different, larger header format. The basic requirement is however that packets sent in the SO state must be almost independent of each other for decompression.

The compressor leaves this state and goes back to the FO state when the header no longer conforms to the uniform pattern and can not be independently compressed based on previous context information.

### 4.3.2. Decompressor states

The decompressor starts in its lowest compression state, "No Context" and gradually transits to higher states. The decompressor state machine normally never leaves the "Full Context" state when it once has started to work in that state.

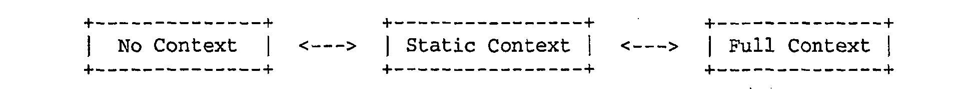

When initially working in the "No Context" state, the decompressor has never successfully decompressed any packet. When a packet once has been decompressed correctly (upon reception of an initialization packet with static and dynamic information, for example), the decompressor can transit all the way to "Full Context" state, and only upon repeated failures will it transit back to lower states. However, when that happens it first transits back to "Static Context" state. There, reception of an FO packet is normally sufficient to enable transition to "Full Context" state again. Only when decompression of several FO packet fails in the "Static Context" state will the decompressor go all the way back to the "No Context" state.

When state transitions are performed is explained in detail in chapter 5.

### 4.4. Modes of operation.

The ROHC scheme has three modes of operation, called Unidirectional, Bi-directional Optimistic, and Bi-directional Reliable mode.

It is important to understand the difference between states, as described in previous chapter, and modes, since they are abstractions orthogonal to each other. The state abstraction is the same for all modes of operation, while each mode has its specific ways to operate in the various states and to make decisions about transitions between states.

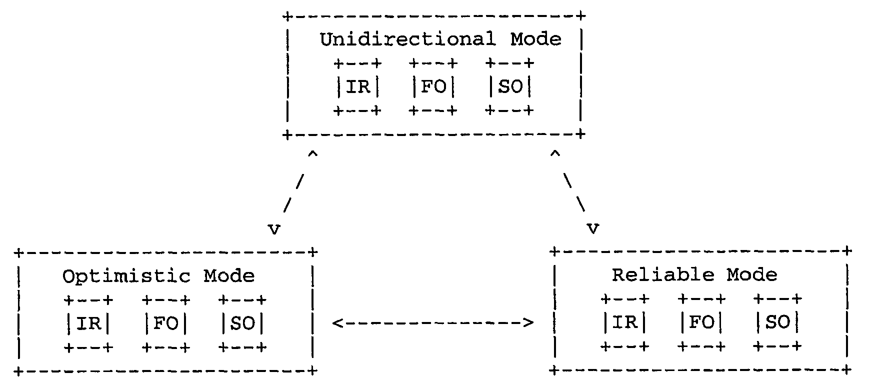

Which mode to operate in depends on the environment the compression is performed in considering link parameters such as feedback abilities, error probabilities and distributions, header size variation effects, etc. All ROHC implementations MUST implement and support all the three modes of operation. The three modes are briefly described in the following subsections.

Detailed descriptions of the three modes of operation regarding compression and decompression logic are given in chapter 5. The mode transition mechanisms are also described in chapter 5.

### 4.4.1. Unidirectional mode - U-mode

When in the unidirectional mode of operation, packets are sent in one direction only; from compressor to decompressor. This mode therefore makes ROHC usable over links where a return path from decompressor to compressor is not available or is undesirable.

In U-mode, transitions between compressor states are performed based only on periodic timeouts and irregularities in the header field change patterns in the compressed packet stream. Due to the periodic refreshes and the lack of feedback for initiation of error recovery, compression in the unidirectional mode will be less efficient and have a slightly higher probability for loss propagation compared to any of the bi-directional modes.

Compression with ROHC MUST start in the unidirectional mode. Transition to any of the bi-directional modes can be performed as soon as a packet has reached the decompressor and it has replied with a feedback packet indicating that a mode transition is desired (see chapter 5).

### 4.4.2. Bi-directional optimistic mode - O-mode

The bi-directional optimistic mode is similar to the unidirectional mode. The difference is that a feedback channel is used to send error recovery requests and (optionally) acknowledgments of significant context updates from decompressor to compressor (not for sequence number updates only). Periodic refreshes are not used in the bi-directional optimistic mode.

O-mode is designed for optimal compression efficiency and sparse usage of the return channel while maintaining reasonable robustness. Loss of compressor-decompressor synchronization and introduction of loss propagation is rare even under high error rates. When loss propagation does occur, the amount is rather insignificant. Nevertheless, this mode is not completely robust and with extremely high error rates loss propagation can occur.

### 4.4.3. Bi-directional reliable mode - R-mode

The bi-directional reliable mode differs in many ways from the previous two. The most important differences regarding implementation and functionality is a more intensive usage of the feedback channel and a stricter logic at both the compressor and the decompressor. Feedback is sent to acknowledge all context updates, including updates of the sequence number field. However, not every packet updates the context in reliable mode.

The chief advantage of R-mode is almost complete robustness against packet loss between compressor and decompressor. Loss propagation can never occur due to header compression when operating in this mode. The price is slightly higher overhead in some cases and the additional feedback traffic introduced.

### 4.5. Encoding methods

This chapter describes the encoding methods that are used for different header fields. How the methods are applied to each field (e.g. values of associated parameters) is specified in the packet format chapter.

### 4.5.1. Least Significant Bits (LSB) encoding

Least Significant Bits (LSB) encoding is used for header fields whose values are usually subject to small changes. With LSB encoding, the k least significant bits of the field value are transmitted instead of the original field value, where k is a positive integer. After receiving the k LSBs, the decompressor derives the original value using a previously received value as reference (v ref).

The scheme is guaranteed to be correct if the compressor and the decompressor agree on an interpretation interval
1) in which the original value resides, and
2) in which the original value is the only value that has the exact same k LSBs as those transmitted.

The interpretation interval can be described as a function f(v_ref, k). Let $f ( v _ref , k ) = [ v _ref - p , v _ref + ( 2 ^ k - 1 ) - p ]$ where p is an integer.

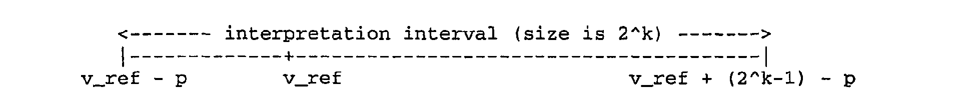

The function f has the following property: for any value k, k LSBs will uniquely identify a value in f(v ref, k). This satisfies condition 2) above.

The parameter p is introduced so that the interpretation interval can be shifted with respect to v_ref. Choosing a good value for p will yield more efficient encoding for fields with certain characteristics. For example, if a field value observed by the compressor always increases, p should be set to 0, and the interval becomes [v_ref, v_ref + 2^k - 1]. Because LSB encoding in ROHC will be applied to header fields whose values increase except in uncommon situations (such as packet mis-ordering or RTP TS for video), only two values will be assigned to p: p1 = 0 or p2 = 2^(k-2) - 1. The latter gives the interpretation interval [v_ref - (2^(k-2) - 1), v_ref + 3*2^(k-2)], which can handle small negative changes while using 3/4 of the interval for positive changes. See section 5.7 for further details.

The following is a simplified procedure for LSB compression and decompression, it is modified for robustness and damage propagation protection in the next subsection:
1) The compressor (decompressor) always uses v_ref_c (v ref d), the last value that has been compressed (decompressed), as v ref;
2) When compressing a value v, the compressor calculates the minimal (for efficiency) but sufficient (for correctness) value of k such that v falls into the interval f(v_ref_c, k). Let this procedure be represented as a function k = g(v, v_ref). Note that more than k LSBs may be sent to fit the packet format (see packet format section);
3)When receiving m LSBs, the decompressor uses the interpretation interval f(v ref d, m), called interval d. It picks as the decompressed value the one in interval_d whose LSBs match the received m bits.

The scheme is complicated by two factors: packet loss between the compressor and decompressor, and transmission errors undetected by the lower layer. In the former case, the compressor and decompressor will lose the synchronization of v_ref, and thus also of the interpretation interval. If v is still covered by the intersection(interval_c, interval_d), decompression will be correct. Otherwise, incorrect decompression will happen. The next section will address this issue further.

In the case of undetected transmission errors, the corrupted LSBs will give an incorrectly decompressed value that will later be used as v_ref d, which in turn is likely to lead to damage propagation. This problem is addressed by using a secure reference, i.e., a reference value whose correctness is verified by a protecting CRC. Consequently, the procedure 1) above is modified as follows:
1) a) the compressor always uses as v_ref_c the last value that has been compressed and sent with a protecting CRC.
   b) the decompressor always uses as v_ref_d the last correct value, as verified by a succeeding CRC.
Note that in U/0 mode, 1) b) is modified so that if decompression fails using the last correct value, another decompression attempt is made using the last but one correct value. This procedure dampens damage propagation when a small CRC fails to detect a damaged value.

### 4.5.2 Window-based LSB encoding (W-LSB encoding)

This section describes how to modify the simplified algorithm in 4.5.1 to achieve robustness.

The compressor may not be able to determine the exact value of v_ref_d that will be used by the decompressor for a particular value v, since some candidates for v ref d may have been lost or damaged. However, by using feedback or by making reasonable assumptions the compressor can limit the candidate set. The compressor then calculates k such that no matter which v_ref_d in the candidate set the decompressor uses, v is covered by the resulting interval_d.

Since the decompressor always uses the last received value where the CRC succeeded as the reference, the compressor maintains a sliding window (VSW) containing the candidates for v ref d. VSW is initially empty. The following operations are performed on VSW by the compressor:
1) After sending a value v (compressed or uncompressed) protected by a CRC, the compressor adds v to the VSW;
2) For each value v being compressed, the compressor chooses k = max(g(v, v_min), g(v, v_max)), where v_min and v_max are the minimal and maximal value in VSW, and g is the function defined in the previous section;
3) When the compressor has sufficient confidence that a certain value v will not be used as a reference by the decompressor, the window is advanced by removing v and all values older than v. The confidence may be obtained by various means. In R mode an ACK from the decompressor implies that values older than the ACKed one can be removed from VSW. In U/O mode there is always a CRC to verify correct decompression, and a VSW with a limited maximum width is used. The window width is an optimization parameter determined during implementation.

Note that the decompressor follows the procedure described in the previous section, except that in R mode it MUST ACK each value received with a CRC (refer to compression/decompression logic section for details).

### 4.5.3 Scaled RTP Timestamp encoding

The RTP Timestamp (TS) will usually not increase by an arbitrary number from packet to packet. Instead, the increase is normally an integral multiple of some unit (TS_STRIDE). For example, in the case of audio, the sample rate is normally 8Khz and one voice frame may cover 20 ms. Furthermore, each voice frame is usually carried in one RTP packet. In this case, the RTP increment is always n * 160 (= 8000 * 0.02), for some integer n. Note that silence periods has no impact on this as the sample clock at the source normally keeps running without changing either frame rate or frame boundaries.

For the case of video, there is usually a TS_STRIDE as well when we consider the video frame level. The sample rate for most video codecs is 90Khz. If the video frame rate is fixed, say to 30 frames/second, the TS will increase by n * 3000 (= n * 90000 / 30) between video frames. Note that a video frame is normally divided into several RTP packets to achieve robustness against packet loss. In this case several RTP packets will carry the same TS.

When using scaled RTP Timestamp encoding, the TS is downscaled by a factor of TS_STRIDE before compression. This saves floor(log2(TS_STRIDE)) bits for each compressed TS. The following equality holds between TS and TS SCALED: $T S = T S SCALED ∗ T S STRIDE + T S OFFSET$

TS STRIDE is explicitly, and TS OFFSET implicitly, communicated to the decompressor. The following algorithm is used:
1. Initialization: The compressor sends to the decompressor the value of TS_STRIDE (e.g., via in-band signaling, see packet format section) and the absolute value of one or several TS. The latter are used by the decompressor to initialize TS_OFFSET to (absolute value) modulo TS_STRIDE. Note that TS OFFSET is the same regardless of which absolute value is used, as long as the unscaled TS value does not wrap around, see 4) below.
2. Compression: After initialization, the compressor no longer compresses the original TS values. Instead, it compresses the down-scaled values: TS_SCALED = TS / TS_STRIDE. The compression method could be either W-LSB encoding or the timer-based encoding described in the next section.
3. Decompression: When receiving the compressed value of TS_SCALED, the decompressor first derives the value of the original TS_SCALED. The original RTP TS is then calculated as TS = TS_SCALED * TS_STRIDE + TS_OFFSET.
4. Wrap around: Wrap around of the unscaled 32-bit TS will invalidate the current value of TS_OFFSET used in the equation above. For example, let's assume TS_STRIDE = 160 = 0xA0 and the current TS = 0xFFFFFFF0. TS_OFFSET is then 0x50 = 80. Then if the next RTP TS = 0x00000130 (i.e., the increment is 160 * 2 = 320), the new TS_OFFSET should be 0x00000130 modulo 0xA0 = 0x90 = 144. The compressor is not required to re-initialize TS OFFSET at wrap around. Instead, the decompressor MUST detect wrap around of the unscaled TS (which is trivial) and update TS_OFFSET to $TS OFFSET + ( Wrapped around unscaled TS ) modulo TS STRIDE$

This scaling method can be applied to many frame-based codecs. However, the value of TS_STRIDE might change during a session, for example due to adaptation strategies. If that happens, the unscaled TS is compressed until re-initialization of the new TS_STRIDE and TS_OFFSET is completed.

### 4.5.4 Timer-Based Compression of RTP Timestamp

The RTP timestamp [RFC 1889] is defined to identify the number of the first sample used to generate the payload. When RTP packets carry payloads corresponding to a fixed sampling interval, the sampling is done at a constant rate, and packets are generated in lock-step with sampling, the timestamp will closely follow a linear pattern as a function of the time of day. This is the case for interactive speech. The linear ratio is determined by the source sample rate. The linear pattern can be complicated by packetization (e.g., in the case of video where a video frame usually corresponds to several RTP packets) or frame re-arrangement (e.g., MPEG B-frames are sent out-of-order by some video codecs).

With a fixed sample rate of 8KHz, 20 ms in time domain is equivalent to an increment of 160 in the unscaled TS domain, and to an increment of 1 in the scaled TS domain with TS STRIDE=160.

As a consequence, the (scaled) TS of headers coming to the decompressor will follow a linear pattern as a function of time of day, with some deviation due to the delay jitter between the source and the decompressor. In normal operation, i.e., no crashes or failures, the delay jitter will be bounded to meet the requirements of conversational real-time traffic. Hence, by using a local clock the decompressor can obtain an approximation of the (scaled) TS in the header to be decompressed by considering its arrival time. The approximation can then be refined with the k LSBs of the (scaled) TS carried in the header. The required value of k to ensure correct decompression is a function of the jitter between the source and decompressor.

If the compressor knows the potential jitter introduced between compressor and decompressor, it can determine k by using a local clock to estimate jitter in packet arrival times, or alternatively it can use a fixed k and discard packets arriving too much out of time.

The advantages of this scheme include:
a) The size of the compressed TS is constant and small. In particular, it does NOT depend on the length of silence intervals. This is in contrast to other TS compression techniques, which at the beginning of a talk-spurt requires sending a number of bits dependent on the duration of the preceding silence interval.
b) No synchronization is required between the clock local to the compressor and the clock local to the decompressor.

Note that although this scheme can be made to work using both scaled and unscaled TS, it is preferable in practice to combine it with scaled TS encoding because of the less demanding requirement on the clock resolution, e.g., 20 ms instead of 1/8 ms. Therefore, the algorithm described below assumes that the clock-based encoding scheme operates on the scaled TS. The case of unscaled TS will be similar, with changes to the scale factors.

Compressor: its major task is to determine the value of k. Its sliding window, TSW, now contains not only potential reference values for the TS, but also their times of arrival at the compressor.
1) The compressor maintains a sliding window TSW = {(T_j, a_j), for each header j that can be used as a reference}, where T_j is the scaled TS for header j, and a_j is the arrival time of header j. The TSW fills the same purpose as the VSW of section 4.5.2.
2) When a new header n arrives with T_n as the scaled TS, the compressor notes the arrival time a_n. It then calculates $Max_Jitter_BC = max { | ( T _n - T _j ) - ( ( a _n - a _j ) / TIME_STRIDE ) | , for all headers j in T S W } ,$ where TIME_STRIDE is the time interval equivalent to one TS_STRIDE, e.g., 20 ms. Max_Jitter_BC is the maximum observed jitter before the compressor, in units of TS_STRIDE, for the headers in TSW.
3) k is calculated as: k = ceiling(log2(2 * J + 1), where J = Max_Jitter_BC + Max_Jitter_CD + 2.
   Max_Jitter_CD is the upper bound of jitter expected on the communication channel between compressor and decompressor (CD-CC). It depends only on the characteristics of CD-CC.
   The factor 2 accounts for the quantization error introduced by the clocks at the compressor and decompressor, which can be +/-1.
   Note that the calculation of k follows the compression algorithm described in section 4.5.1, with p = 2^(k-1) - 1.
4) TSW is subject to the same window operations as in section 4.5.2, 1) and 3), except that the values added and removed are paired with their arrival times.

### Decompressor:

1) The decompressor always uses as reference header the last correctly (as verified by CRC) decompressed header. It maintains the pair (T_ref, a_ref), where T_ref is the scaled TS of the reference header, and a_ref is the arrival time of the reference header.
2) When receiving a compressed header n at time a_n, the approximation of the original scaled TS is calculated as: $T _approx = T _ref + ( a _n - a _ref ) / TIME_STRIDE .$
3) The approximation is then refined by the k LSBs carried in header n, following the decompression algorithm of section 4.5.1, with p = 2^(k-1) - 1.

Note that the algorithm does not assume any particular pattern in the packets arriving to the compressor, i.e., it tolerates reordering before the compressor and non-increasing RTP timestamp behavior. Moreover, the clock resolution can be worse than TIME_STRIDE, in which case the difference, i.e., actual resolution - TIME_STRIDE, is treated as additional jitter in the calculation of k.

### 4.5.5 Offset IP-ID encoding

This section assumes that the Ipv4 stack at the source host assigns IP-ID to the value of a 2-byte counter which is increased by one after each assignment to an outgoing packet. Therefore, the IP-ID field of a particular IPv4 packet flow will increment by 1 from packet to packet except when the source have emitted intermediate packets not belonging to that flow.

For such IPv4 stacks, the RTP SN will increase by 1 for each packet and the IP-ID will increase by at least the same amount. Thus, it is more efficient to compress the offset, i.e., (IP-ID - RTP SN), in stead of IP-ID itself.

The following text describes how to compress/decompress the sequence of offsets using W-LSB encoding/decoding, with p = 0 (see section 4.5.1).

### Compressor:

The compressor uses W-LSB encoding to compresses a sequence of offsets $Offset i = I D i - S N i ,$
where ID i and SN i are the values of the IP-ID and RTP SN of header i. The sliding window contains such offsets and not the values of header fields, but the rules for adding and deleting offsets from the window otherwise follow section 4.5.2.

### Decompressor:

The reference header is the last correctly (as verified by CRC) decompressed header.

When receiving a compressed packet m, the decompressor calculates Offset_ref = ID_ref - SN_ref, where ID_ref and SN_ref are the values of IP-ID and RTP SN in the reference header, respectively. Then W-LSB decoding is used to decompress Offset_m, using the received LSBs in packet m and Offset_ref. Note that m may contain zero LSBs for Offset m, in which case Offset m = Offset ref.

Finally, the IP-ID for packet m is regenerated as $I P - I D for m = decompressed S N of packet m + Offset_ m$

Note that some Ipv4 stacks do not transmit the IP-ID field in network byte order, but instead send the two octets reversed. In this case, the compressor can compress the IP-ID field after swapping the bytes. Consequently, the decompressor also swaps the bytes of the IP-ID after decompression to regenerate the original IP-ID. This requires that the compressor and the decompressor synchronize on the byte order of the IP-ID field (see header format section).

### 4.5.6. Self-contained variable-length values.

The values of TS STRIDE and a few other compression parameters can vary widely. TS STRIDE can be 160 for voice and 90 000 for 1 f/s video. To optimize the transfer of such values, a variable number of octets is used to encode them. The first few bits of the encoded value determines its length.
1 octet: first bit is zero. 7 bits transferred. Up to 127 decimal. Encoded octets in hexadecimal: 00 to 7F
2 octets: first bits 10. 14 bits. Up to 16 383 decimal. Encoded octets in hexadecimal: 80 00 to BF FF
3 octets: first bits 110. 21 bits. Up to 2 097 152 decimal. Encoded octets in hexadecimal: C0 00 00 to DF FF FF
4 octets: first bits 111. 29 bits. Up to 536 870 912 decimal. Encoded octets in hexadecimal: E0 00 00 00 to FF FF FF FF

### 4.5.7. Encoded values across several fields in compressed headers.

When a compressed header has an extension, pieces of an encoded value can be present in more than one field. When an encoded value is split over several fields in this manner, the more significant bits of the value are closer to the beginning of the header. If the number of bits available in compressed header fields exceeds the number of bits of the value, the most significant field is padded with zeroes in its most significant bits.

For example, an unscaled TS value can be transferred using an UOR-2 header (see section 5.7) with an extension of type 3. The Tsc bit of the extension is then unset and the variable length TS field of the extension is 4 octets (see section 4.5.6). The UOR-2 TS field will contain the most significant three bits of the unscaled TS, and the 4-octet TS field in the extension contains the remaining 29 bits.

### 5. The protocol

### 5.1. Data structures

[[Editor's note: This section will mainly be a more detailed, specification-like version of the introductory information in 4.2.]]

### 5.1.1. Per-channel parameters

### 5.1.2. Per-CID parameters, profiles

### 5.1.3. Contexts

### 5.2. Packet types

The ROHC scheme uses six packet types, indicated by the first few bits of the header. The format of a packet type can depend on the mode. Therefore a naming scheme of the form
<modes format is used in>-<packet type number>-<some property> is used to uniquely identify the format when necessary. E.g, UOR-2, R-1. For exact formats of the packet types, see section 5.7.

[Note by Mikael Degermark - the rest of this section is an attempt at describing what packet types can be used when. It started out as an attempt to group packet types together in a way that would make it easier to write the following chapters. I don't seem to have succeeded too well in finding a small number of packet classes. Can we define this table or something similar? It would be very helpful to an implementer. The table should perhaps be moved somewhere else...]

The following table summarizes which format can be used when. If a packet type is surrounded by parenthesis, using that packet type will decrease robustness. If several packet types are indicated, the smallest type which can represent the header to be compressed should be used.

**Header adheres Compressor SN-functions to SN-functions Header format/Mode state established TS/ID others action**

| | | | | | | |
|---|---|---|---|---|---|---|
| UO | SO | Yes | Yes | | Yes | UO-0 |
| | | Yes | | No | | goto FO |
| | FO | Yes | Yes | | Yes | goto SO |
| | | Yes | No | | Yes | UO-1, UOR-2 |
| | | Yes | * | | No | UO-1 Ext, UOR-2 |
| | | No | Yes | | Yes | (UO-0), UO-1, UOR-2 |
| | | No | No | | Yes | *UO-1, UOR-2 |
| | | No | * | | No | *UO-1, UOR-2, |
| | | | | | | IR-DYN |
| | | | | | | |
| R | SO | Yes | Yes | | Yes | R-0, R-0-CRC |
| | | Yes | | No | | goto FO |
| | FO | Yes | | Yes | | goto SO |
| | | Yes | | No | | *R-1, UOR-2 |
| | | No | | Yes | | (R-0-CRC), *R-1, UOR-2 |
| | | No | | No | | *R-1, UOR-2 |

| | | | | | | |
|---|---|---|---|---|---|---|
| *: robustness will suffer unless an PT-1 header is used which gives the correct result also when old SN-functions are used. | | | | | | |

### 5.2.1. Packet formats from compressor to decompressor

Four packet types are used from compressor to decompressor. Three for compressed headers, and one for initialization/refresh. Context identifiers of the appropriate length precede these headers. Exact header formats are found in section 5.7.

### Packet type zero: R-0, R-0-CRC, UO-0.

This, the minimal, packet type is used when parameters of all SN-functions are known by decompressor, and the header to be compressed adheres to those functions. Thus, only the W-LSB encoded RTP SN needs to be communicated.

R-mode: Only if a CRC is present (packet type R-0-CRC) may the header be used as a reference for subsequent decompression.

U-mode and O-mode: A small CRC is present in the UO-0 packet.

### Packet type 1: R-1, R-1-ID, R-1-TS, UO-1, UO-1-ID, UO-1-TS.

This packet type is used when the number of bits needed for the SN exceeds those available in packet type zero, or when the parameters of the SN-functions for RTP TS or IP-ID change.

R-mode: R-1-* packets are not used as references for subsequent decompression. Values for other fields than the RTP TS or IP-ID can be communicated using an extension, but they do not update the context.

U-mode and O-mode: Only the values of RTP SN, RTP TS and IP-ID can be used as references for future compression. Non-updating values can be provided for other fields using an extension (UO-1-ID).

### Packet type 2: UOR-2, UOR-2-ID, UOR-2-TS

This packet type can be used to change the parameters of any SN-function, except for those for most static fields. Headers of packets transferred using packet type 2 can be used as references for subsequent decompression.

### Packet type 5: IR

This packet type communicates the static part of the context, i.e., the value of the constant SN-functions. It can optionally also communicate the dynamic part of the context, i.e., the parameters of the non-constant SN-functions.

### Packet type 6: IR-DYN

This packet type communicates the dynamic part of the context, i.e., the parameters of the non-constant SN-functions.

### 5.2.2. Feedback packets from decompressor to compressor

Feedback packets carry information from decompressor to compressor. The following kinds of feedback is supported. The first three control state and mode transition, and the fourth informs the compressor that the decompressor does not have sufficient resources to decompress a packet stream.
- ACK: : Acknowledges successful decompression of a packet, which means that the context is up to date with a high probability.
- NACK: : Indicates that the dynamic context of the decompressor is out of sync.
- STATIC-NACK :: Indicates that the static context of the decompressor is not valid or has not been established.
- REJECT: : Indicates that compression of this packet stream cannot be supported due to resource constraints.

### 5.2.3. Parameters needed for mode transition

The packet type UOR-2 is common for all modes. It can carry an extension with a mode parameter which can take the values U = Unidirectional, O = Bi-directional Optimistic, and R= Bi-directional Reliable.

Feedback packets of types ACK, NACK, and STATIC-NACK carry sequence numbers and can also carry a mode parameter indicating the desired compression mode: U, O, or R.

As a shorthand, the notation PACKET(mode) is used to indicate which mode value a packet carries. For example, an ACK with mode parameter R is written ACK(R), and an UOR-2 with mode parameter O is written UOR-2(O).

### 5.3. Operation in unidirectional mode

### 5.3.1. Compressor states and logic (U-mode)

Below is the state machine for the compressor in unidirectional mode. Details of the transitions between states and compression logic are given subsequent to the figure.

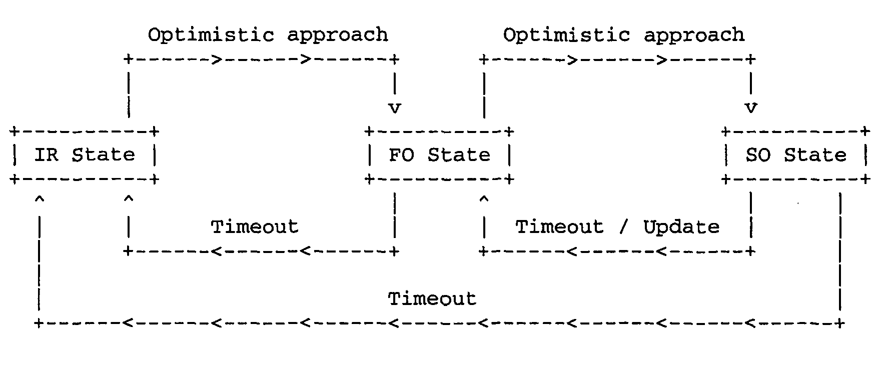

### 5.3.1.1. State transition logic (U-mode)

The transition logic for compression states in unidirectional mode is based on three principles; the optimistic approach principle, timeouts, and the need for updates.

### 5.3.1.1.1. Optimistic approach, upwards transition

Transition to higher compression state in unidirectional mode is carried out according to the optimistic approach principle. This means that the compressor transits to a higher compression state when it is rather confident that the decompressor has received enough information to correctly decompress packets sent according to the higher compression state.

When the compressor is in IR state, it will stay there until it assumes that the decompressor has correctly received the static context information. For transition from FO to SO state, the compressor should be confident that the decompressor has all parameters needed to decompress according to a fixed pattern.

The compressor normally gets its confidence about decompressor status by sending several packets with the same information according to the lower compression state. If the decompressor receives any of these packets, it will be in sync with the compressor. The number of consecutive packets to send for confidence is not defined in this document.

### 5.3.1.1.2. Timeouts, downward transition

By using the optimistic approach described above, there will always be a possibility for failure since the decompressor may not have received sufficient information for correct decompression. Therefore, the compressor must periodically transit to lower compression states. Periodic transition to IR state should be carried out less often than transition to FO state. Two different timeouts should therefore be used for these transitions. For an example of how to implement periodic refreshes, see [IPHC] chapter 3.3.1-3.3.2.

### 5.3.1.1.3. Need for updates, downward transition

In addition to the backward state transitions carried out due to periodic timeouts, the compressor must also immediately transit back to FO state when the header to be compressed does not confirm to the established pattern.

### 5.3.1.2. Compression logic and packets used (U-mode)

The compressor chooses the smallest possible packet format that can communicate the desired changes, and has the required bits for W-LSB encoded values. Sliding windows used in W-LSB encoding have a fixed width.

### 5.3.1.3. Feedback in unidirectional mode

The unidirectional mode of operation is designed to operate over links where a feedback channel is not available. If a feedback channel is available, however, the decompressor MAY send an acknowledgment of successful decompression with the mode parameter set to U (send an ACK(U)). When the compressor receives such a message, it MAY disable or increase the interval between periodic IR refreshes.

### 5.3.2. Decompressor states and logic (U-mode)

Below is the state machine for the decompressor in unidirectional mode. Details of the transitions between states and decompression logic are given subsequent to the figure.

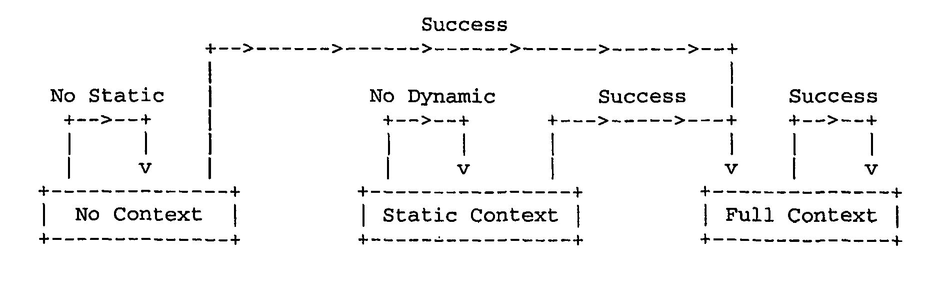

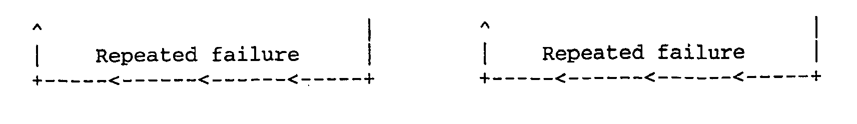

### 5.3.2.1. State transition logic (U-mode)

The state transition logic of the decompressor is much simpler than for the compressor side. It is also common for all the three modes of operation. Successful decompression will always move the decompressor to the Full Context state. Repeated failed decompression will force the decompressor to transit backwards to a lower state. The decompressor does not attempt to decompress headers at all in the No Context and Static Context states unless sufficient information is included in the packet itself.

### 5.3.2.2. Decompression logic (U-mode)

Decompression in unidirectional mode is carried out following three steps which are described in subsequent sections.

### 5.3.2.2.1. Decide whether decompression is allowed

In Full Context state, decompression may be attempted regardless of what kind of packet is received. However, for the other states decompression is not always allowed. In the No Context state, only IR packets, which carry the static information fields may be decompressed. Further, when in the Static Context state, only packets carrying a strong CRC can be decompressed (i.e., IR, IR-DYN, or UOR-2 packets). If decompression may not be performed the packet is discarded, unless the optional delayed decompression mecanism is used, see section x.x.x.

### 5.3.2.2.2. Reconstruct and verify the header

// TWB based on chapter 4.5
LSB interpretation, wrap around correction
All decompressed headers are verified with CRC

### 5.3.2.2.3. Causes for CRC mismatches

A mismatch in the 3-bit CRC can be caused by one or more of:
1. residual bit errors in the current header,
2. a damaged context due to residual bit errors in previous headers, or
3. loss of 16 or more consecutive packets which causes the 4-bit SN to wrap around (which is, in essence, another kind of context damage) .

The 3-bit CRC present in UO-0 and UO-1 headers will reliably detect context damage eventually, since the probability of undetected context damage decreases exponentially with each new header processed. However, residual bit errors in the current header are only detected with good probability, not reliably.

When a CRC mismatch is caused by residual bit errors in the current header (case 1 above), the decompressor should stay in its current state to avoid unnecessary loss of subsequent packets. On the other hand, when the mismatch is caused by a damaged context, the decompressor can attempt to repair the context but if that fails, it must move to a lower state to avoid delivering incorrect headers. When the mismatch is caused by long loss, the decompressor might attempt additional decompression attempts.
- Long loss detection (timer)
- Incorrect wrap around correction
- Repeated reconstruction attempts in case of long loss

// The following text should be compressed and structured so that it
// takes care of the issues listed above in a correct order. Clear,
// simple and ordered principles should be described.

### [Micke's note: have I achieved that?]

In the following sections mechanisms are described that might detect the cause for a CRC mismatch. If these mechanisms fail in finding the reason for the CRC mismatch, additional decompression attempts MUST NOT be performed.

### 5.3.2.2.4. Detection of context damage

Context damage increases the probability of a CRC mismatch. With 3-bit CRCs, the probability of detecting the erroneous header is roughly 7/8. With 7-bit and 8-bit CRCs, the probability is roughly 127/128 and 255/256, respectively.

In the Full Context state, whenever decompression of 4 UO-0 or UO-1 headers have failed out of the last 6 headers, the decompressor moves to the Static Context state. In the Static Context state, whenever decompression of 2 out of the last 3 UOR-2 or IR-DYN packets have failed, the compressor moves to the No Context state. An implementation MAY move to lower states sooner, but SHOULD NOT move to a lower state later than specified here.
[[Editor's note: the exact numbers probably need more discussion.]]

### 5.3.2.2.5. Repair of SN wrap-around

At least 16 headers must be lost for the SN of UO-0 or UO-1 headers to wrap around. The decompressor might be able to detect this situation by using a local clock. The following algorithm can be used:
a.The decompressor notes the arrival time, a_i, of each incoming packet i. Arrival times of packets where decompression fails are discarded.
b.When decompression fails, the decompressor computes INTERVAL = a_i - a_i-1, i.e., the time elapsed between the arrival of the previous correctly decompressed packet and the current packet.
c.If wrap-around has occurred, INTERVAL will correspond to at least 16 inter-packet times. Based on an estimate of the packet inter-arrival time, obtained for example using a moving average of arrival times, TS STRIDE, or TS TIME, the decompressor judges if INTERVAL can correspond to 16 or more inter-packet times.
d.If INTERVAL is judged to be at least 16 packet inter-arrival times, the decompressor adds 16 to the SN of the context and attempts to decompress the packet using the new context.
e.If this decompression succeeds, the decompressor updates the context but SHOULD NOT deliver the packet to upper layers. The following packet is also decompressed and updates the context if its CRC succeeds, but SHOULD be discarded. If decompression of the third packet using the new context also succeeds, the context repair is deemed successful and this and subsequent decompressed packets are delivered to the upper layers.
f.If any of the three decompression attempts in d. and e. fails, the decompressor discards the packets and moves to the Static Context state.

Using this mechanism, the decompressor may be able to repair the context after excessive loss, at the expense of discarding two packets.

### 5.3.2.2.6. Repair of incorrect SN updates

The CRC can fail to detect residual errors in the compressed header because of its limited length, i.e., the incorrectly decompressed packet can happen to have the same CRC as the original uncompressed packet, causing the incorrectly decompressed packet to be accepted and the context being updated. This can lead to an erroneous reference SN being used in W-LSB decoding, as the reference SN is updated for each successfully decompressed header of certain types.

If this happens, the decompressor will detect the incorrect decompression of the following packet with high probability, but it does not know the reason for the failure. The following mechanism allows the decompressor to judge if the context was updated incorrectly by an earlier packet.
1) The decompressor always keeps two decompressed SN: the last one (ref 0) and the one before that (ref -1).
2) When receiving a compressed SN:
   SN curr = decompressed SN using ref 0 as reference value decompress the rest of the header using SN curr
   IF (the header passes the CRC test)
   ref -1 = ref 0
   ref 0 = SN curr
3) ELSE
   SN curr = decompressed SN using ref -1 as reference value decompress rest of header using SN curr
   IF (header passes the CRC test)
   ref0 = SN curr; // note ref-1 unchanged
4) ELSE
   // one of two error situations:
   // 1) bit error in current header,
   // 2) decompression context corrupted. Use 5.3.2.2.4 to
   // distinguish, (e.g., assume context corrupted
   // only after k out of n errors)

The purpose of this algorithm is to repair the context. If the header generated in 3) passes the CRC test, two more headers must also be successfully decompressed before the repair is deemed successful. Of the three successful headers, the first two SHOULD be discarded and only the third delivered to upper layers. If decompression of any of the three headers fail, the decompressor MUST discard that header and the previously generated headers, and move to the Static Context state.

### 5.3.2.3. Feedback in unidirectional mode

To improve performance for the unidirectional mode over a link that does have a feedback channel, the decompressor MAY send an acknowledgment when decompression succeeds. Setting the mode parameter in the ACK packet to U indicates that the compressor is to stay in unidirectional mode. When receiving an ACK(U), the compressor SHOULD reduce the frequency of the IR packets since the static information has been correctly received, but it is not required to stop sending IR packets. If IR packets continue to arrive, the decompressor MAY repeat the ACK(U), but it SHOULD not repeat the ACK continuously.

### 5.4. Operation in bi-directional optimistic mode

### 5.4.1. Compressor states and logic (O-mode)

Below is the state machine for the compressor in bi-directional optimistic mode. Details of each state, the transitions between states and compression logic are given subsequent to the figure.

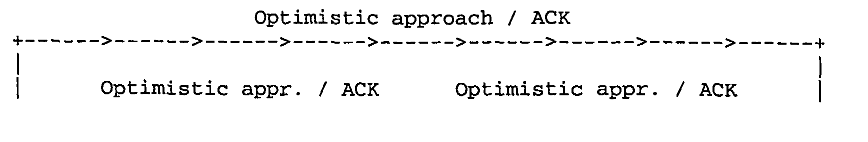

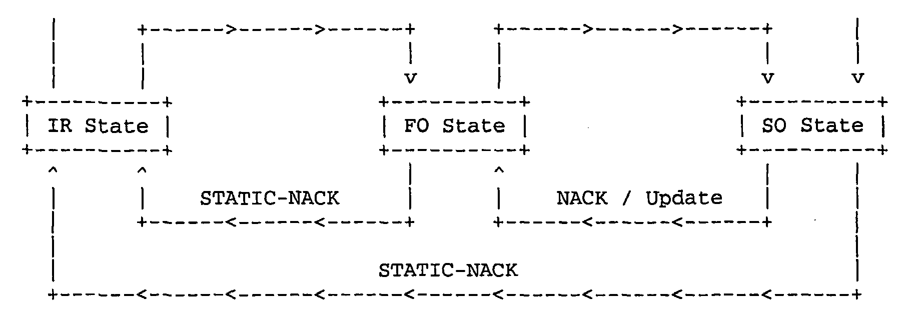

### 5.4.1.1. State transition logic

The transition logic for compression states in bi-directional optimistic mode has much in common with the logic of the unidirectional mode. The optimistic approach principle and transitions because of the need for updates works in the same way as described in chapter 5.3.1. However, in optimistic mode there are no timeouts. Instead, the optimistic mode makes use of feedback from decompressor to compressor both for transitions in the backward direction and for improved forward transition.

### 5.4.1.1.1. Context requests, negative acknowledgements (NACKs)

### 5.4.1.1.2. Optional acknowledgements

### 5.4.1.2. Compression logic and packets used

// Is there a difference from unidirectional mode??

### 5.4.2. Decompressor states and logic

The decompression states and the state transition logic are the same as for the unidirectional case (see section 5.3.2). What differs is the decompression and feedback logic.

### 5.4.2.1. Decompression logic

### 5.4.2.1.1. Timer-based timestamp decompression

NOTE: This mechanism must be described here since it can not be used in unidirectional mode because no indication can be given to the compressor if timer-based method fails.

### 5.4.2.2. Feedback logic

The feedback logic defines what feedback messages to send due to different events when operating in the various states.
// NOTE: Must be rewritten and not refer to FH, FO and IR packets
   - In NC state:: - When a FH packet is correctly decompressed, send an ACK with the mode parameter set to O
   - When an FO or SO packet is received or decompression of a FH packet has failed, send a STATIC-NACK with the mode parameter set to O
   - In SC state:: - When a FH packet is correctly decompressed, send an ACK with the mode parameter set to O
   - When an FO packet is correctly decompressed, optionally send an ACK with the mode parameter set to O
   - When a SO packet is received, send a NACK with the mode parameter set to O
   - When decompression of an FO or FH packet has failed, send a STATIC-NACK with the mode parameter set to O
   - In FC state:: - When a FH packet is correctly decompressed, send an ACK with the mode parameter set to O
   - When an FO packet is correctly decompressed, optionally send an ACK with the mode parameter set to O
   - When an SO packet is correctly decompressed, no feedback should be sent
   - When decompression of an SO, FO or FH packet has failed, send a NACK with the mode parameter set to O

### 5.5. Operation in bi-directional reliable mode

### 5.5.1. Compressor states and logic

Below is the state machine for the compressor in bi-directional reliable mode. Details of each state, the transitions between states and compression logic are given subsequent to the figure. 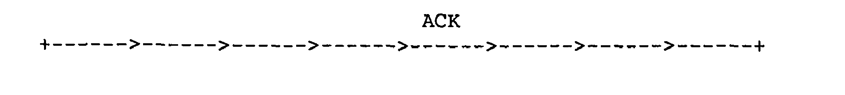 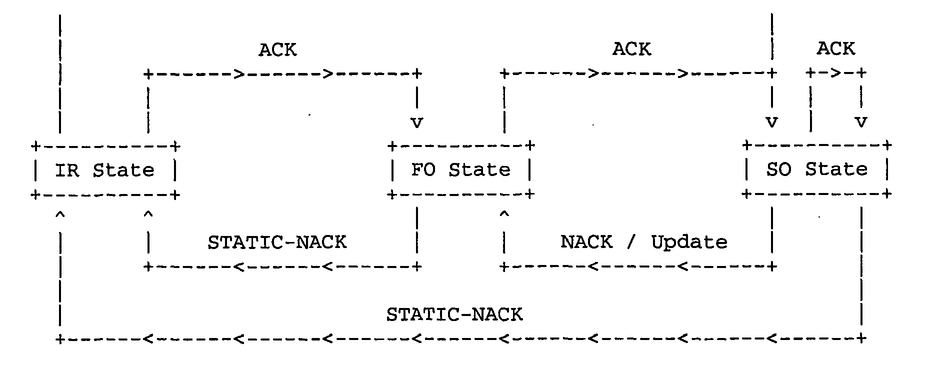
// This chapter should be structured with subchapters in a way
// consistent with 5.3 and 5.4

### 5.5.2. Decompressor states and logic

The decompression states and the state transition logic are the same as for the unidirectional case (see section 5.3.2). What differs is the decompression and feedback logic.

### 5.5.2.1. Decompression logic

### 5.5.2.2. Feedback logic

The feedback logic defines what feedback messages to send due to different events when operating in the various states.
// NOTE: Must be rewritten and not refer to FH, FO and IR packets

- In NC state:: - When a FH packet is correctly decompressed, send an ACK with the mode parameter set to R
- When an FO or SO packet is received or decompression of a FH packet has failed, send a STATIC-NACK with the mode parameter set to R
- In SC state:: - When an FO or FH packet is correctly decompressed, send an ACK with the mode parameter set to R
- When an SO packet is received, send a NACK with the mode parameter set to R
- When decompression of an FO or FH packet has failed, send a STATIC-NACK with the mode parameter set to R
- In FC state:: - When an FO or FH packet is correctly decompressed, send an ACK with the mode parameter set to R
- When an updating SO packet is correctly decompressed, periodically send an ACK with the mode parameter set to R
- When decompression of an SO, FO or FH packet has failed, send a NACK with the mode parameter set to R

### 5.6. Mode transitions

The decision to move from one compression mode to another is taken by the decompressor and the possible mode transitions are shown in the figure below. Subsequent chapters describe how the transitions are performed together with exceptions for the compression and decompression functionality during transitions.

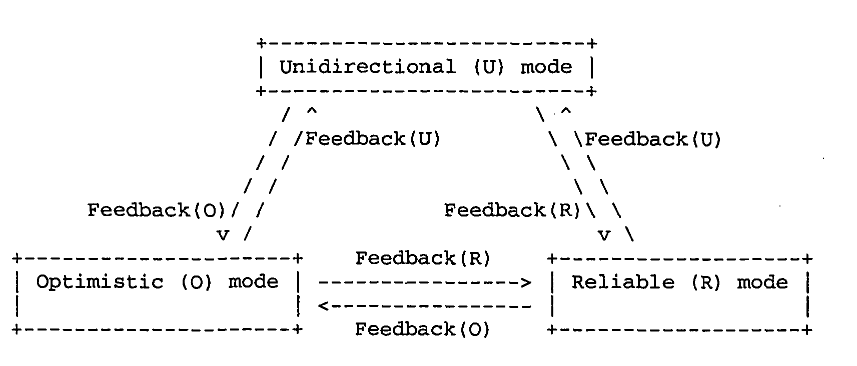

### 5.6.1. Compression and decompression during mode transitions

To be able to work properly, both compressor and decompressor must have a variable for which mode it should be working according to. Subsequent chapters define exactly when to change the value of this mode variable and thereby change the mode of operation. Further, when ROHC transits from one mode to another, there are several cases with special rules for what is allowed to do at the compressor and decompressor sides during the transition phase. These special rules are defined by exception parameters that sets various exception rules to follow. The transition descriptions in subsequent chapters refer to these exception parameters and defines when and to what values they are set. All mode related parameters are listed below with possible values, explanations and rules:

Parameters for the compressor side:
- C_MODE Possible values for the C_MODE parameter are (U)NIDIRECTIONAL, (O)PTIMISTIC and (R)ELIABLE. Initially the value MUST be set to U.
- C_TRANS Possible values for the C_TRANS parameter are (P)ENDING and (D)ONE. Initially the value MUST be set to D. When the parameter is set to P, it is REQUIRED that the compressor only uses packet formats common to all modes and SHALL NOT allow transition to SO state. New mode transition request MUST also be ignored when an already initiated transition is pending.

Parameters for the decompressor side:
- D_MODE Possible values for the D_MODE parameter are (U)NIDIRECTIONAL, (O)PTIMISTIC and (R)ELIABLE. Initially the value MUST be set to U.
- D_TRANS Possible values for the D_TRANS parameter are (I)NITIATED, (P)ENDING and (D)ONE. Initially the value MUST be set to D. New mode transitions are only allowed when the parameter is set to D. When set to I, the decompressor should send a NACK or ACK for all received packets, which it can stop doing when the parameter is set to P or D.

### 5.6.2. Transition from Unidirectional to Optimistic mode

As long as there is a feedback channel available, the decompressor can at any moment decide to initiate transition from unidirectional to bi-directional Optimistic mode. All feedback packets can be used with the mode parameter set to O and the decompressor can then directly start working in Optimistic mode. The compressor transits from unidirectional to optimistic mode as soon as it receives any feedback packet with the mode parameter set to O. The transition procedure is described below:

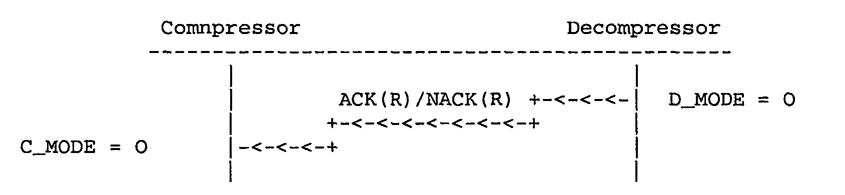

If the feedback packet is lost, the compressor will continue to work in unidirectional mode with periodic refreshes but as soon as the decompressor send another feedback packet, also the compressor will transit to optimistic mode.

### 5.6.3. From Optimistic to Reliable mode

Transition from Optimistic to Reliable mode is only allowed after at least one packet has been correctly decompressed, which means that the static part of the context is established. Either the ACK(R) or the NACK(R) feedback packet is used to initiate the transition and the compressor MUST always run in FO state during transition. The transition procedure is described below:

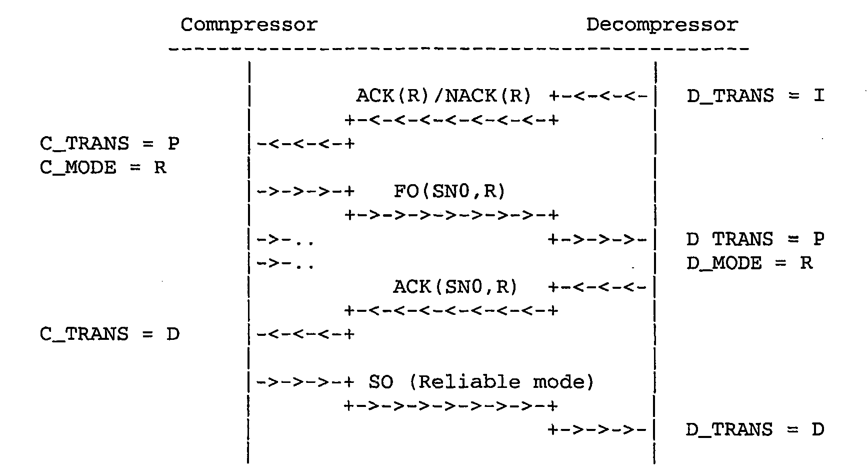

As long as the decompressor has not received an FO packet with the mode transition parameter set to R, it must stay in Optimistic mode. The compressor must stay in FO state until it has received an ACK for an FO packet sent with the mode transition parameter set to R (indicated by the sequence number).

### 5.6.4. From Unidirectional to Reliable mode

Since transition from Unidirectional to Optimistic mode do not require any handshakes, it is possible to transit directly from Unidirectional to Reliable mode, following the same transition procedure in 5.6.3 above.

### 5.6.5. From Reliable to Optimistic mode

Either the ACK(O) or the NACK(O) feedback packet is used to initiate the transition from Reliable to Optimistic mode and the compressor MUST always run in FO state during transition. The transition procedure is described below:

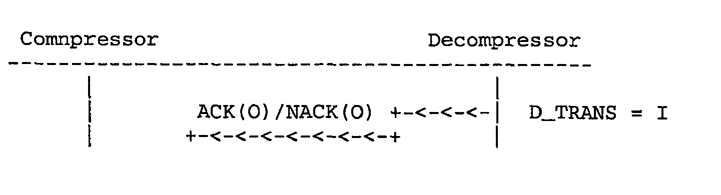

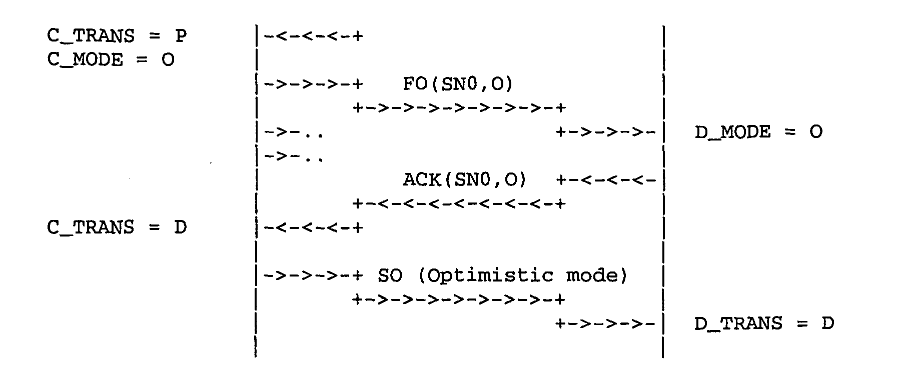

As long as the decompressor has not received an FO packet with the mode transition parameter set to O, it must stay in Reliable mode. The compressor must stay in FO state until it has received an ACK for a FO packet sent with the mode transition parameter set to O (indicated by the sequence number).

### 5.6.6. Transition to Unidirectional mode

It is possible to force transition back to unidirectional mode if the decompressor desires to do so. Independent of which mode it starts from, a three way handshake MUST be carried out to ensure correct transition on the compressor side. The transition procedure is described below:

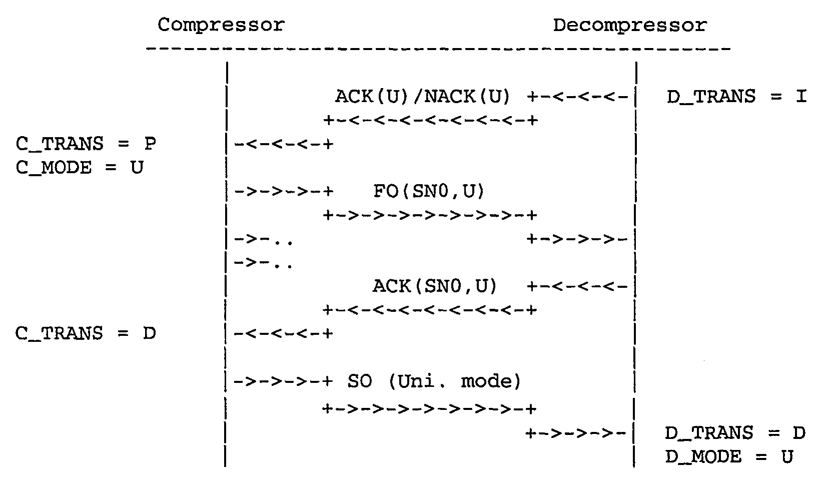

The decompressor must continue to send feedback until it knows that the compressor is ready with the transition.

### 5.7. Packet formats

### 5.7.1. Packet type 0: UO-0. R-0, R-0-CRC

### R-0

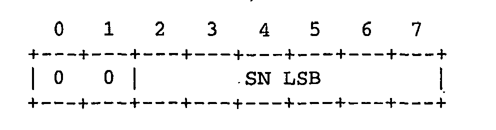

### R-0-CRC

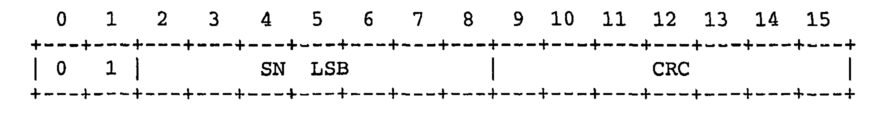

SN LSB: Least significant bits of RTP SN. (Note that, in R-0-CRC, the SN LSB straddles a byte boundary.)
CRC: 7-bit CRC, computed according to section 5.9.2.
Note: R-0 headers MUST NOT update any part of the context. R-0-CRC headers MUST NOT update any part of the context not directly related to the RTP SN.

### UO-0

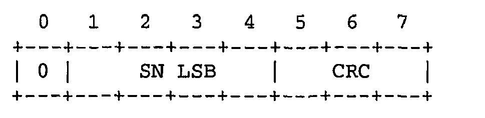

SN LSB: Least significant bits of RTP SN (see section 4.5.1)
CRC: 3-bit CRC (see section 5.9.2)
Note: The UO-0 header MUST update the current value of the RTP SN. The UO-0 header MUST NOT update any part of the context not directly related to the RTP SN.

### 5.7.2. Packet type 1 (R-mode): R-1, R-1-TS, R-1-ID

This packet type is used in R-mode when the RTP SN of the header to be compressed differs so much from the context that the LSB of packet type 0 is too small, or when the functions from RTP SN to RTP timestamp or IP ID change and need to be communicated to the decompressor. It is also possible to give values for other fields by using an Extension.

### R-1

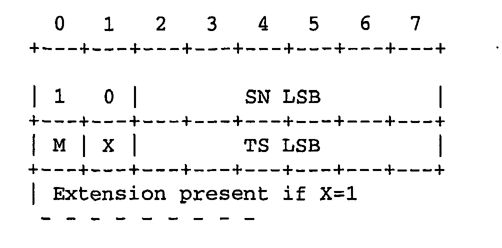

### R-1-ID

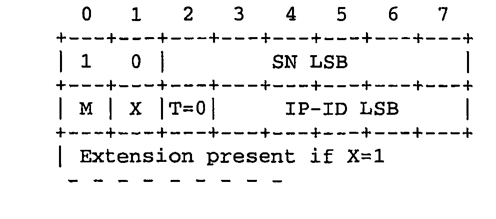

### R-1-TS

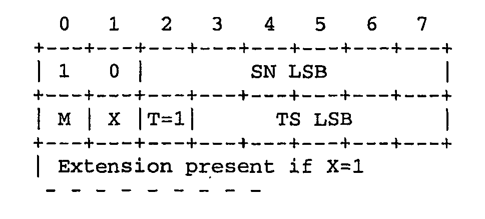

SN LSB: Least significant bits of RTP SN, see section 4.5.1.
M: RTP Marker bit, absolute value.
X: X=0 indicates that no Extension is present,
   X=1 indicates that an Extension is present.
T: T=0 indicates format R-1-ID, T=1 indicates format R-1-TS.
TS LSB: Least significant bits of scaled RTP TS, see section 5.x.x.
IP-ID LSB: Least significant bits of IP-ID offset from SN, see Section 5.x.x.
Extension: See section 5.7.5.
Note: R-1-* headers MUST NOT update any part of the context.

### 5.7.3. Packet type 1 (UO-modes): UO-1, UO-1-ID, UO-1-TS

This packet type is used in U-mode and O-mode when the RTP SN of the header to be compressed differs so much from the context that the RTP LSB of packet type 0 is too small, or when the functions from RTP SN to RTP timestamp or IP ID change and need to be communicated to the decompressor. It is also possible to give non-updating values for other fields by using an Extension.

### UO-1

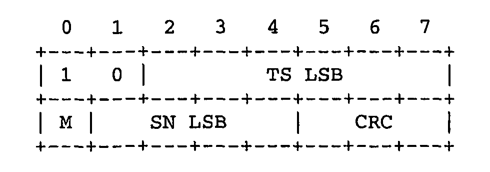

### UO-1-ID

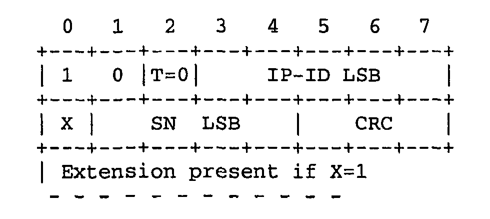

### UO-1-TS

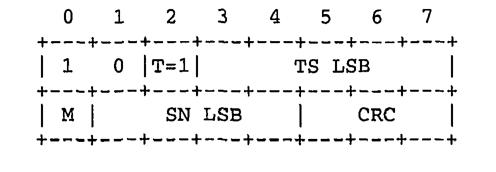

SN LSB: Least significant bits of RTP SN, see section 4.5.1.
M: RTP Marker bit, absolute value.
TS LSB: Least significant bits of scaled RTP TS, see section 5.x.x.
CRC: 3-bit CRC (see section 5.9.2)
IP-ID LSB: Least significant bits of IP-ID offset from SN, see Section 5.x.x.
X: X=0 indicates that no Extension is present,
   X=1 indicates that an Extension is present.
T: T=0 indicates format UO-1-ID, T=1 indicates format UO-1-TS.
Extension: See section 5.7.5.

Note: UO-1-* headers MUST NOT update any part of the context except parts directly related to the RTP SN, RTP TS, and IP-ID. Values provided in Extensions, other than those directly related to RTP SN, RTP TS, and IP-ID, MUST NOT update the context.

### 5.7.4. Packet type 2: UOR-2

This packet type is used in all modes when the changes that need to be communicated, or the RTP SN, cannot fit in the earlier formats. The UOR-2 format always updates (or refreshes) the context.

### UOR-2

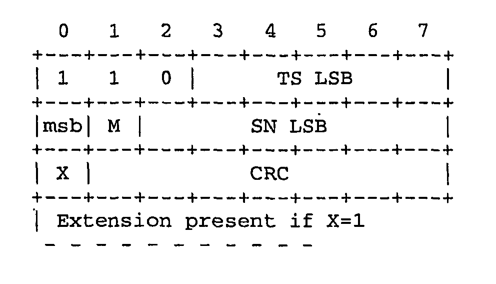

### UOR-2-ID

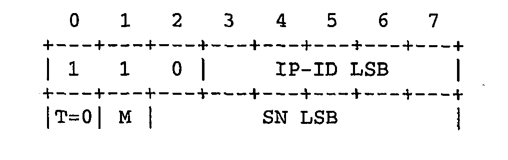

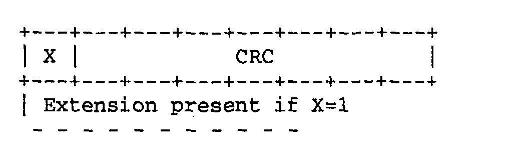

### UOR-2-TS

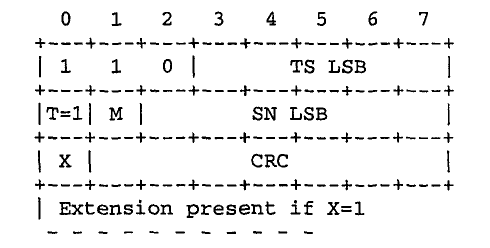

TS LSB: Least significant bits of scaled RTP TS, see section 5.x.x.
msb: One-bit extension of TS LSB field, so that the total size of the LSB of the scaled TS is 6 bits. This is the most significant bit.
M: RTP Marker bit, absolute value.
SN LSB: Least significant bits of RTP SN, see section 4.5.1.
IP-ID LSB: Least significant bits of IP-ID offset from SN, see Section 5.x.x.
X: X=0 indicates that no Extension is present,
   X=1 indicates that an Extension is present.
CRC: 7-bit CRC (see section 5.9.2)
T: T=0 indicates format UOR-2-ID, T=1 indicates format UOR-2-TS.
Extension: See section 5.7.5.

### 5.7.5. Extension formats

Fields in extensions are concatenated with the corresponding field in the base compressed header, if any. Bits in an extension are more significant than bits in the base compressed header.

The TS LSB field is scaled in all extensions, as it is in the base header, except optionally when using extension 3 where the Tsc flag can indicate that the RTP TS LSB field is not scaled. When an extension carries a TS-Stride field, the value of that field is used when scaling the TS LSB field.

In the following three extensions, the interpretation of the fields depend on whether there is a T-bit in the base compressed header, and if so, on the value of that field. If there is no T-bit, T LSB and -T LSB both mean TS LSB. If there is a T-bit,
- T = 1: indicates that T is TS, and
-T is IP-ID.
- T = 0: indicates that T is IP-ID, and
-T is TS.

### Extension 0:

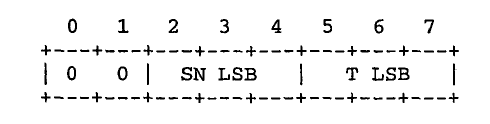

### Extension 1:

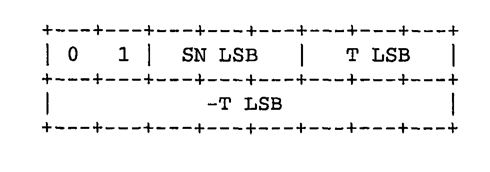

### Extension 2:

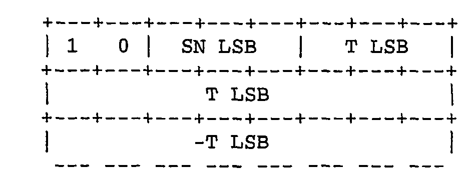

only if T-bit in base comp header.

Extension 3 is a more elaborate extension which can give values for fields other than RTP SN, RTP TS, and IP-ID. Three optional flag octets indicates changes to IP header(s) and RTP header, respectively.

### Extension 3:

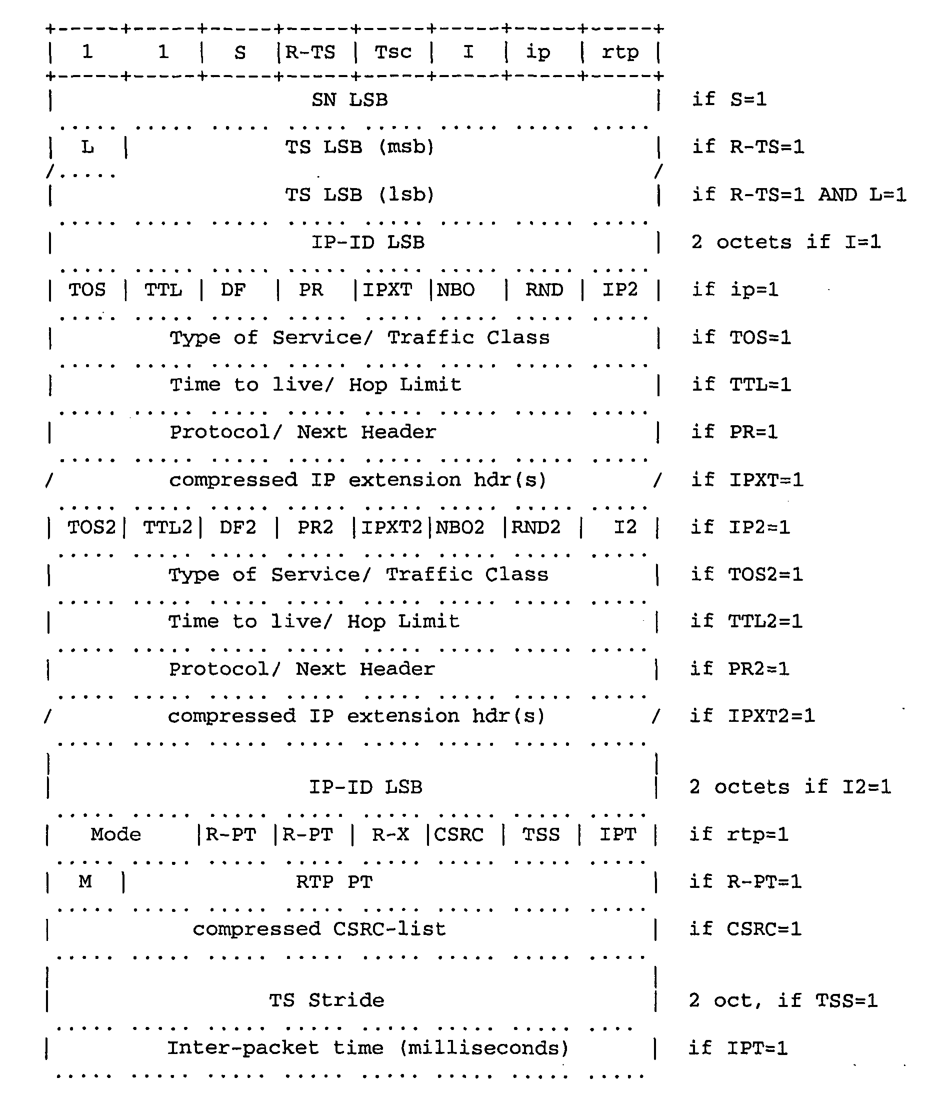

[Note from Micke D: This format can deal with two IP headers, which is what we can expect from Mobile IP. More is overkill, I think.]

### 5.7.6. Feedback packets: FEEDBACK-3 and FEEDBACK-4

When the roundtrip time between compressor and decompressor is large, several packets can be in flight. Therefore, several packets can be received by the decompressor before the compressor can react to a FEEDBACK packet.

The decompressor SHOULD NOT send FEEDBACK packets for each successful decompression, unsuccessful decompression, or packet received in a rejected packet stream. Instead, a compressor SHOULD limit the rate at which FEEDBACK packets are sent.

The following are the formats of the FEEDBACK packets. They are to be preceded with a CID that identifies which context they refer to.

It is anticipated that FEEDBACK packets may be sent interleaved with non-FEEDBACK packets in a channel going from decompressor to compressor. In that case the formats below will be preceded by a CID with whatever size has been negotiated for that channel. If the CIDs of that channel is smaller than the CIDs needed in the FEEDBACK packets, additional bytes of CID MUST be added in the FEEDBACK formats. How many bytes to add is known at channel setup time, and is not explicitly indicated. If the CIDs of the FEEDBACK channel are larger than those of the forward channel, the numerical value of the CID is used to identify the context.

### FEEDBACK-3

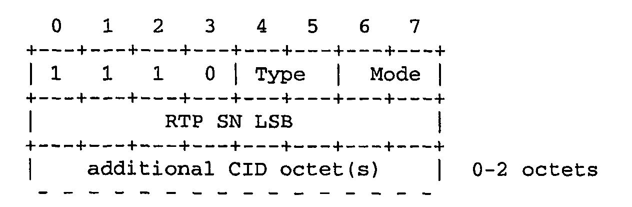

Type: 0= Reserved
1= ACK
2= NACK
3= STATIC-NACK

Mode: 0= Reserved
1= Unidirectional
2= Bi-directional Optimistic
3= Bi-directional Reliable

RTP SN LSB: LSB of the RTP Sequence number of
ACK: the successfully decompressed header which caused the FEEDBACK packet to be emitted,
NACK, STATIC-NACK: the last successfully decompressed header (from context), if any available. Otherwise zero.

Additional CID octet(s): Additional octets of CID if there is a mismatch between the CID spaces of the forward channel and the feedback channel.

### FEEDBACK-4-REJECT

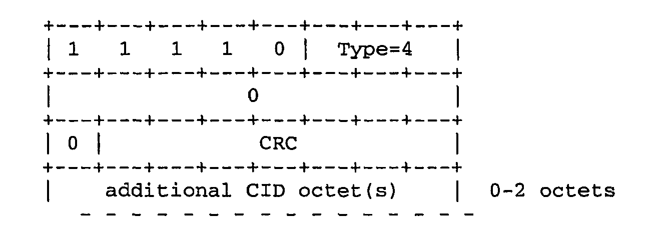

### Type: 4

CRC: CRC computed over the entire FEEDBACK-4-REJECT packet, including CID, using the polynomial for 7-bit CRCs in section 5.9.2. For purposes of CRC calculation, the CRC field MUST be set to zero. When receiving a FEEDBACK-4-REJECT packet, a compressor MUST check the CRC, and check that the zeroed fields of the FEEDBACK-4-REJECT packet are indeed zero. If these checks fail, the packet MUST be discarded and no further action taken.

Additional CID octet(s): Additional octets of CID if there is a mismatch between the CID spaces of the forward channel and the feedback channel.

### FEEDBACK-4

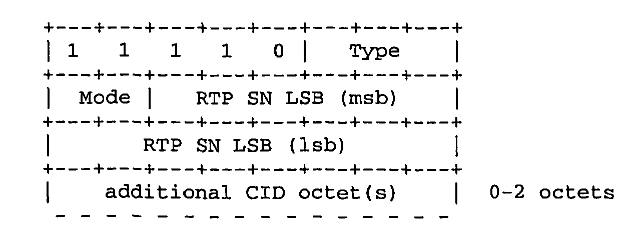

Type: 0, 5-7 = Reserved
1 = ACK
2 = NACK
3 = STATIC-NACK

Mode: 0 = Reserved
1 = Unidirectional
2 = Bi-directional Optimistic
3 = Bi-directional Reliable

RTP SN LSB (msb): Most significant 6 bits of 14-bit RTP SN LSB.

RTP SN LSB (lsb): Least significant 8 bits of 14-bit RTP SN LSB.

Additional CID octet(s): Additional octets of CID if there is a mismatch between the sizes of the CID spaces of the forward channel and the feedback channel.

Note: RTP sequence number to use is the same as for FEEDBACK-3.

### 5.7.7 IR and IR-DYN packets

The subheaders which are compressible are split into a STATIC part and a DYNAMIC part. These parts can be found in sections 5.7.6.3-*.

The structure of a chain of subheaders is determined by each header having a Next Header, or Protocol, field. This field identifies the type of the following header. Each Static part below contains that field and allows parsing of the Static chain.

### 5.7.7.1 Basic structure of the IR packet

This packet type communicates the static part of the context, i.e., the value of the constant SN-functions. It can optionally also communicate the dynamic part of the context, i.e., the parameters of non-constant SN-functions. It can also optionally communicate the payload of an original packet, if any.

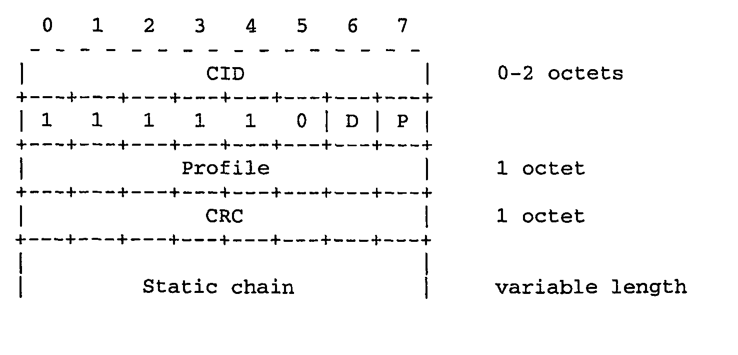

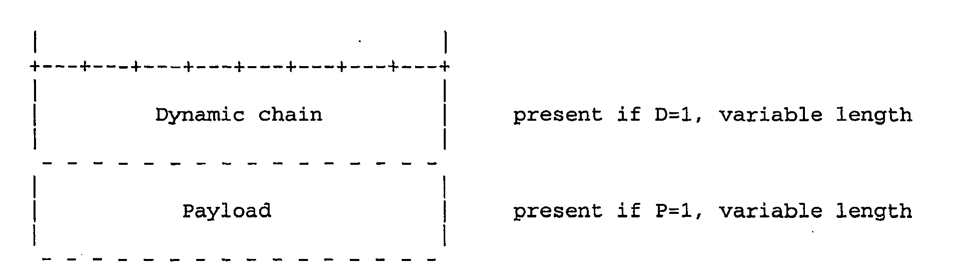

- D:: D=1 indicates that the dynamic chain is present.
- P:: P=1 indicates that a payload is present (could be inferred from static chain plus frame length).
- Profile:: Indicates transport/application of this stream.
- CRC:: 8-bit checksum covering entire IR header, including CID, excluding Payload, computed according to chapter 5.9.x.
- Static chain:: A chain of static subheader information.

Dynamic chain: A chain of dynamic subheader information. What dynamic information is present is inferred from the Static chain.

Payload: payload of corresponding original packet, if any.

### 5.7.7.2. Basic structure of the IR-DYN packet

This packet type communicates the dynamic part of the context, i.e., the parameters of non-constant SN-functions.

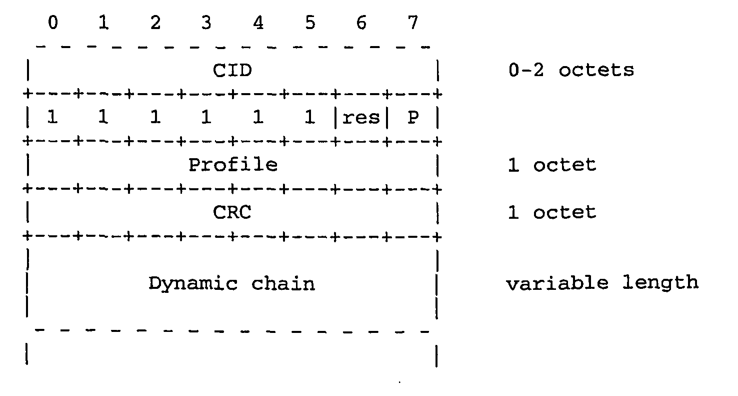

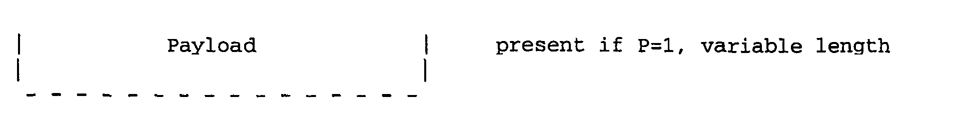

res: Reserved. Set to zero when sending, ignored when received.
P: P=1 indicates that Payload is present.
Profile: Indicates transport/application of this stream.
CRC: 8-bit checksum covering entire IR-DYN header, including CID, excluding Payload.
Dynamic chain: A chain of dynamic subheader information. What
dynamic information is present is inferred from the Static chain of the context.
Payload: payload of corresponding original packet, if any.

### 5.7.7.3. Initialization of IPv6 Header [IPv6]

### Static part:

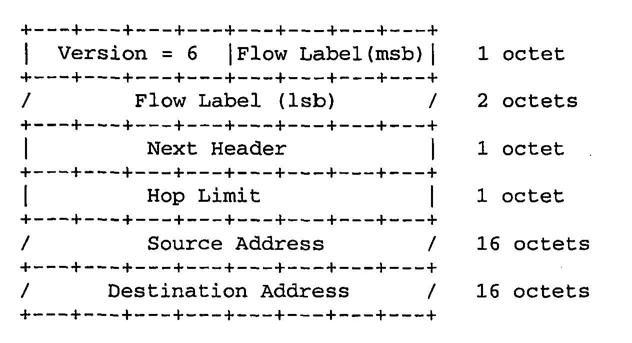

### Dynamic part:

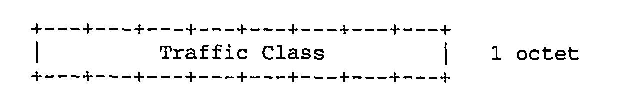

### Eliminated:

### Payload Length

### 5.7.7.4. Initialization of IPv4 Header [IPv4, section 3.1].

### Static part:

Version, Flags, Time to Live, Protocol, Source Address, Destination Address.

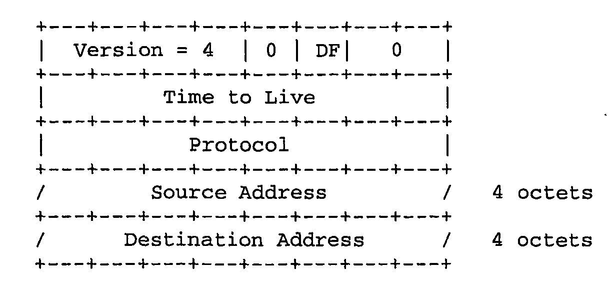

### Dynamic part:

### Type of Service, Identification

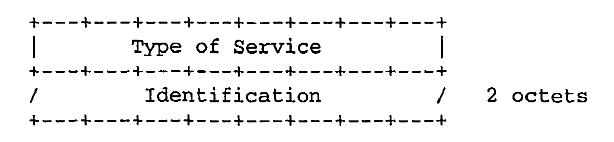

### Eliminated:

- IHL: (must be 5)
- Total Length: (inferred in decompressed packets))
- MF flag: (More Fragments flag, must be 0)
- Fragment Offset: (must be 0)
- Header Checksum: (inferred in decompressed packets)
- Options, Padding: (must not be present)

### 5.7.7.5. Initialization of UDP Header [RFC-768].

### Static part:

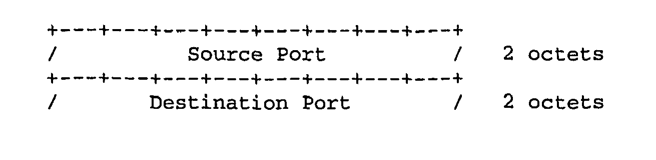

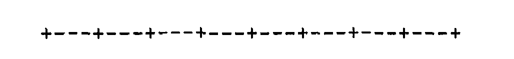

### Dynamic part:

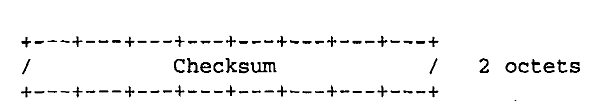

### Eliminated:

### Length

The Length field of the UDP header MUST match the Length field(s) of preceding subheaders, i.e., there must not be any padding after the UDP payload that is covered by the IP Length.

### 5.7.7.6. Initialization of RTP Header [RTP].

### Static part:

P, X, CC, PT, SSRC, CSRC identifiers.

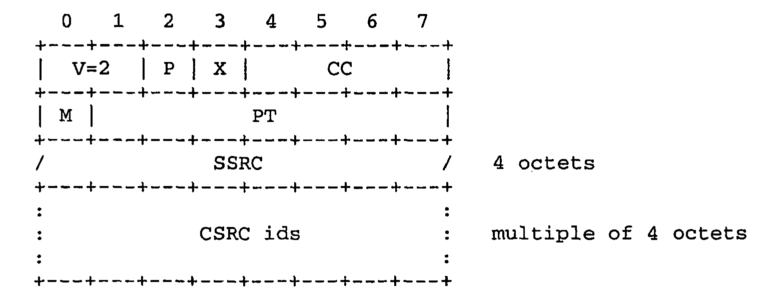

### Dynamic part:

M, sequence number, timestamp, timestamp delta.

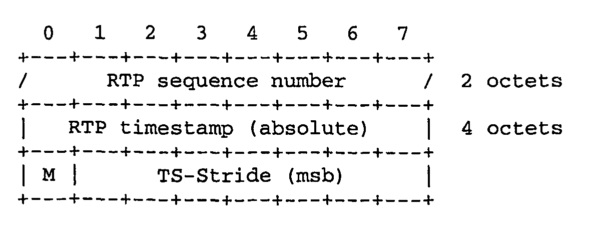

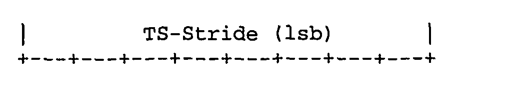

### Eliminated:

Nothing.

### 5.7.7.7. Minimal Encapsulation header [RFC-2004, section 3.1]

### STATIC Part:

### Entire header.

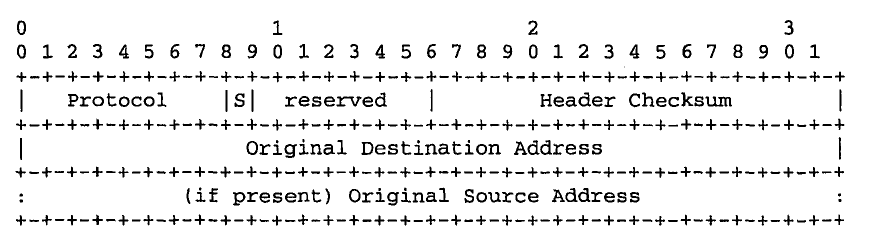

### DYNAMIC Part:

### Empty.

### Eliminated:

Nothing.

### 5.8. List-Based Compression

In two cases, information from the packet to be compressed can be described as an ordered list, that is largely constant between packets, but to which additions and deletions are made occasionally in the course of the packet stream. This section describes the compression scheme for this information, called "list-based compression." The two cases are: CSRC lists in RTP packets, and extension header chains in IP packets.

[[Editor's note: This section still is under active discussion in the mailing list. A somewhat simplified version is believed to emerge soon.]]

### 5.8.1. CSRC compression

The Contributing Source (CSRC) List in a RTP header contains the Synchronization Source (SSRC) identifiers of the contributing sources for the payload in the current packet.

A CSRC list contains at most 15 identifiers, due to the 4-bit size of CSRC Count (CC) field in RTP header. Each 32-bit identifier is chosen randomly by the original synchronization source so that it is globally unique within an RTP session.

The compression scheme introduced here will utilize the facts mentioned above. To maintain transparency, the order of identifiers is preserved during compression. In other words, the CSRC list is really compressed as a list, not as a set.

### 5.8.1.1. Transformation Classification for CSRC List

A given CSRC list (curr_list) can be classified as belonging to one of the following transformation cases when compared with a reference CSRC list (ref_list).
- Transformation Case A: curr_list can be derived from ref_list just by adding some CSRCs; the relative positions of the CSRCs common to curr_list and ref_list are the same.
- Transformation Case B: curr_list can be derived from ref_list just by deleting some CSRCs; the relative positions of the CSRCs common to curr_list and ref_list are the same
- Transformation Case C: All the other transformation cases that are not covered by transformation case A and B.

### 5.8.1.2. Encoding Schemes

To address aforementioned 3 transformation cases, four encoding schemes are used. Each scheme addresses one or more transformation cases mentioned above. The four encoding schemes and the transformation cases they address is listed in the following table.

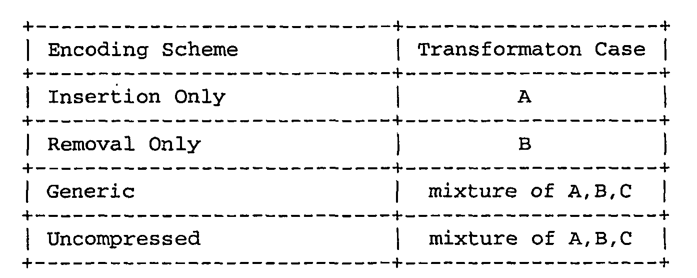

- In the insertion only scheme, compared with CSRC list in the ref_list, the newly added CSRCs in the curr_list are sent along with the positions of the CSRCs in the ref_list, before which the new CSRCs will be inserted.
- In the removal only scheme, the positions of the CSRCs, which are in the ref_list, but not in the curr_list, are sent.
- In the generic scheme, for a given CSRC in the curr_list, it is sent compressed only with a position field if the CSRC is also in the ref_list, or it is sent uncompressed.

All the aforementioned 3 schemes generate compressed format of the CSRC list. The CSRC list can also be sent in an uncompressed format.

### 5.8.1.3. Format of compressed CSRC list

The format of the compressed CSRC list using the four schemes is as follows.

### 5.8.1.3.1 Insertion Only Scheme

### 5.8.1.3.1.1 R-mode

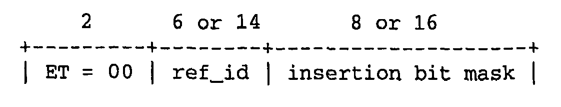

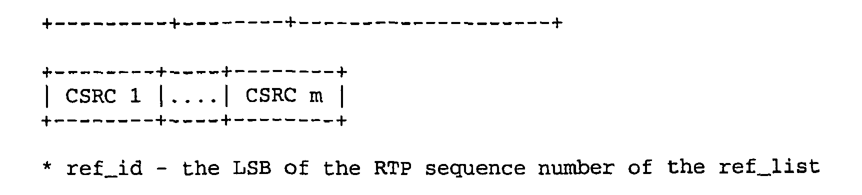

6 bit: "0" + 5-bit LSB of RTP sequence number
14 bit: "1" + 13-bit LSB of RTP sequence number
* insertion bit mask: the bit mask indicating the position of the following CSRCs to be inserted into the ref_list in order to reconstruct the curr_list.

The length of insertion bit mask can be 8 bits or 16 bits.
8 bits: "0" + 7-bit insertion bit mask
16 bits: "1" + 15-bit insertion bit mask

To construct the insertion bit mask and the following inserted CSRC list, the following steps are taken.
** A list of '0' and an empty inserted CSRC list are generated as the starting point. The number of '0's in the '0' list equals the number of CSRCs in the ref_list. The i-th '0' in the '0' list corresponds to the i-th CSRC in the ref_list.
** Comparing the curr_list with the ref_list, if a new CSRC is inserted between the i-th item and the (i+1)-th item in the ref_list, a '1' is inserted between the i-th '0' and (i+1)-th '0' in the original '0' list. The new CSRC should be added to the end of inserted CSRC list. This procedure is repeated until all the m new CSRCs have been processed. If the length of new insertion bit mask is less than 7 bits or 15 bits, additional '0' should be added at the end until it reaches 7 bits or 15 bits.

When the decompressor receives the insertion bit mask, it scans from left to right. When a '0' is observed, the decompressor copies the corresponding CSRC in the ref_list into the curr_list; when a '1' is observed, the decompressor adds the correspondent CSRC into the curr_list.

* CSRC i (i=1..m): the CSRCs to be inserted; assuming that the number of CSRC to be inserted is m.

### 5.8.1.3.1.2 UO-modes

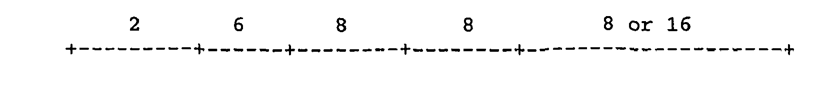

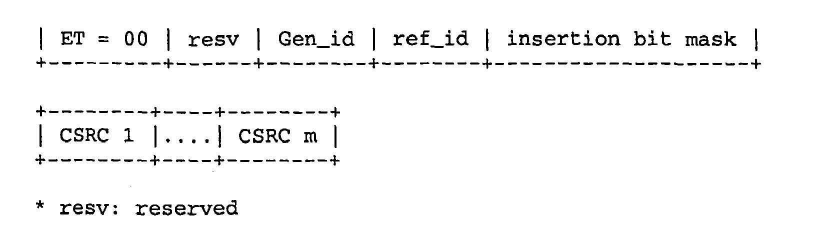

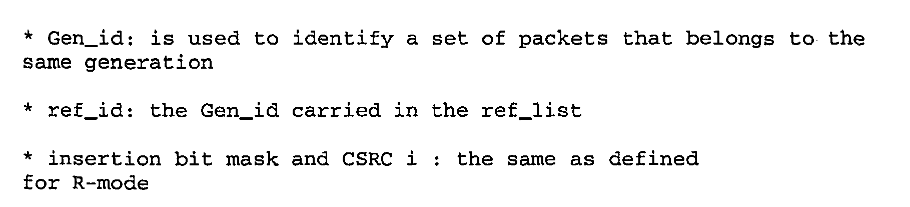

### 5.8.1.3.2 Removal Only Scheme

### 5.8.1.3.2.1 R-mode

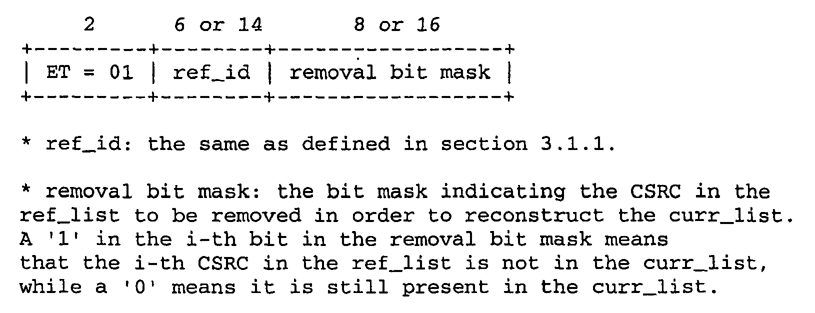

The length of insertion bit mask can be 8 bits or 16 bits.
8 bits: "0" + 7-bit insertion bit mask
16 bits: "1" + 15-bit insertion bit mask

Which format to be used depends on the number of CSRCs in the ref_list. If it is less than 8, then 8-bit removal bit mask can be used; otherwise the 16-bit format is required.

### 5.8.1.3.2.2 UO-mode

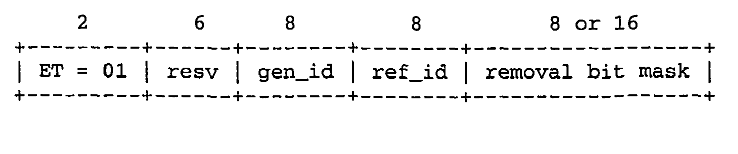

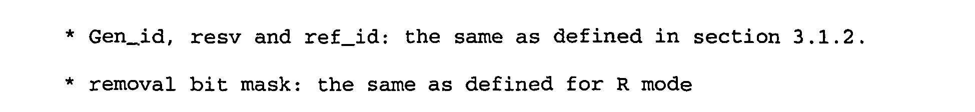

### 5.8.1.3.3 Generic Scheme

### 5.8.1.3.3.1 R-mode

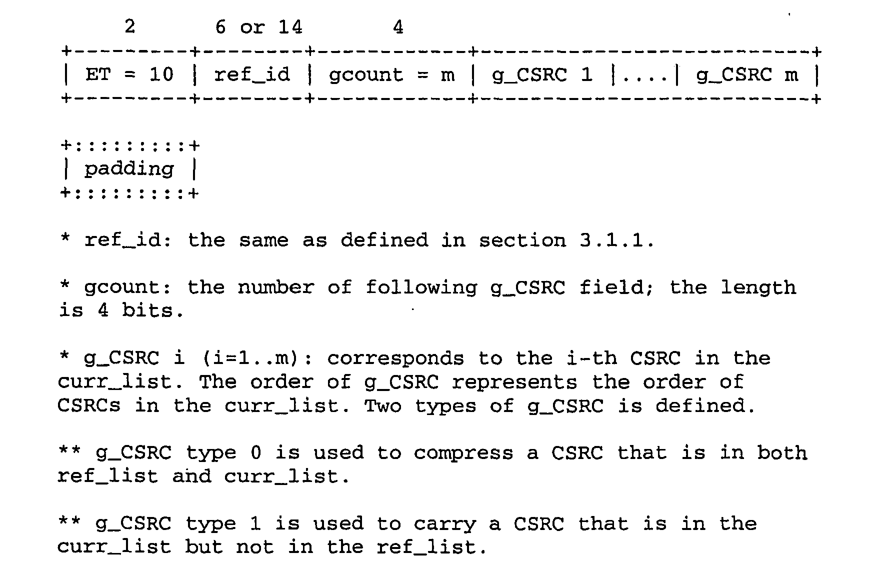

The format of g_CSRC is defined as follows.

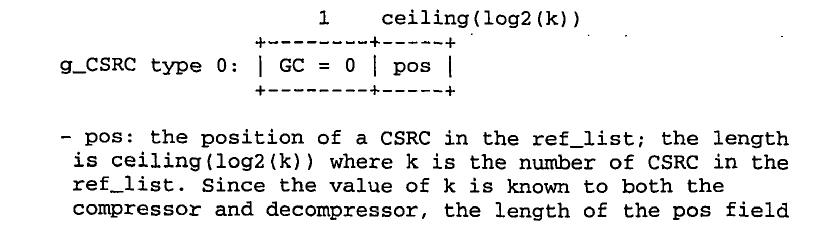

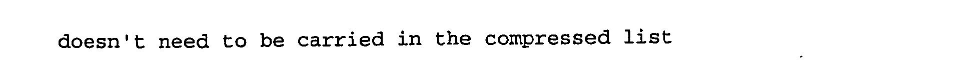

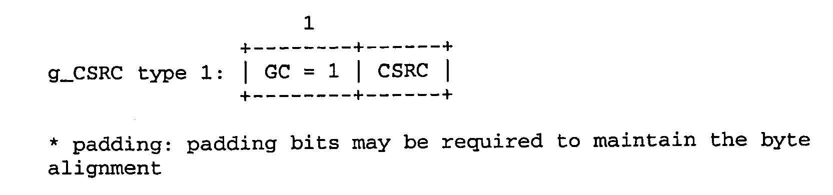

### 5.8.1.3.3.2 UO-mode

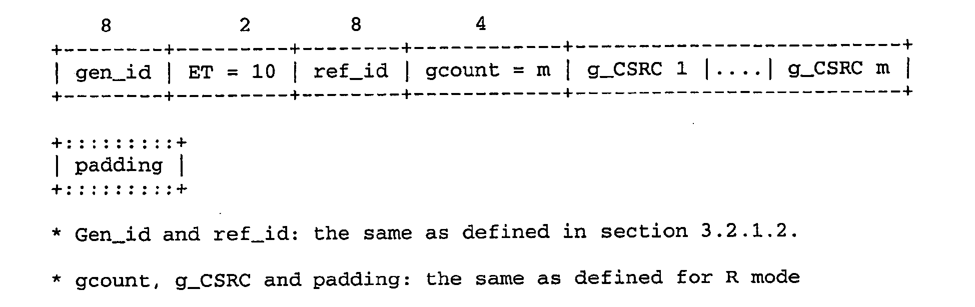

### 3.4 Uncompressed (common to R-mode and UO-modes)

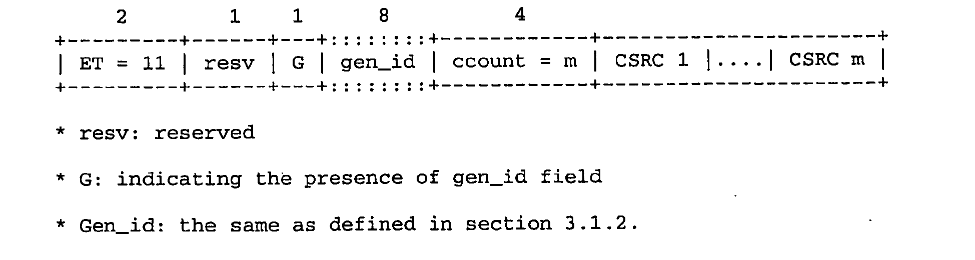

- In R-mode, gen_id is not present.
- During the transition from any mode to U-mode or 0-mode, gen_id should not be sent. The list without gen_id should not be used as a reference to compress and decompress a CSRC list.
- In UO-modes, gen_id is present if it may be used as a reference to compress or decompress the subsequent CSRC list.

* ccount: the number of CSRCs in the CSRC list
* CSRC i (i=1..m): the original CSRC list in the curr_list

### 5.8.2. Header Compression for IPv6 Extension Headers

The IPv6 extension headers are encoded as a list of items. Each item is one of the extension headers. The length of each extension header may vary from each other. When more than one extension header is used in the same packet, the order of these extension headers is recommended in RFC 2460, but not mandatory. Thus, although it is unlikely to happen, the order of the extension headers may vary during the same session. In addition, one or more extension header may be added or removed during the session and the content of each extension header may change. Therefore, the IPv6 extension headers are classified as a list of items and the item list compression mechanism can be applied.

The compression of IPv6 extension headers at the list level is similar to that of the CSRC entries (section 5.8.1). The compressed value of the extension header list is referred to as a compressed extension header list. The compression of IPv6 extension headers at the item level, i.e., the compression scheme used for each type of extension header, is defined in this subsection. The reference extension header used to compress a given extension header is the extension header in the reference list that has the same type. The compressed value of an extension header is referred to as a compressed extension header.

### 5.8.2.1. Terminology

* extension header list: the list of IPv6 extension headers
* compressed extension header: the compressed value of an IPv6 extension header
* compressed extension header list: the list of compressed extension headers
* reference extension header list: the extension header list which is used as the reference to compress an extension header list
* reference extension header: an extension header in the reference list that has the same type and is used as the reference to compress a given extension header

### 5.8.2.2. Transformation Classification and Encoding Schemes

### 5.8.2.2.1 Transformation Classification

A given extension header list (curr_list) can be classified as belonging to one of the following transformation cases when compared with a reference extension header list (ref_list).
- Transformation Case A: curr_list can be derived from ref_list just by adding (inserting) some extension headers; the relative positions of the extension headers common to curr_list and ref_list are the same.
- Transformation Case B: curr_list can be derived from ref_list just by deleting some extension headers; the relative positions of the extension headers common to curr_list and ref_list are the same
- Transformation Case C: curr_list can be derived from ref_list just by modifying the content of some extension headers; the relative positions of the extension headers remain the same.
- Transformation Case D: All the other transformation cases that are not covered by transformation case A, B and C.

### 5.8.2.2.2 Encoding Schemes

To address aforementioned 4 transformation cases, four encoding schemes are used. Each scheme addresses one or more transformation cases mentioned above. The four encoding schemes and the transformation cases they address is listed in the following table.

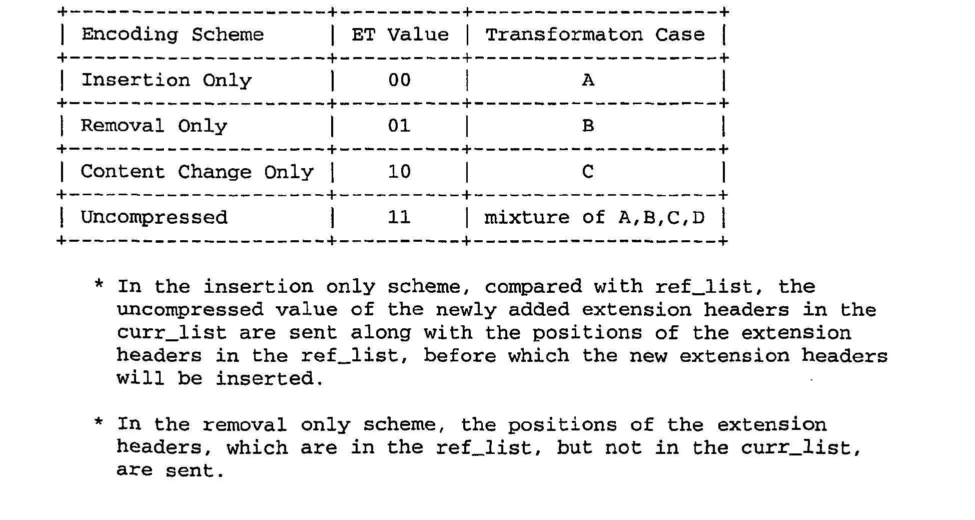

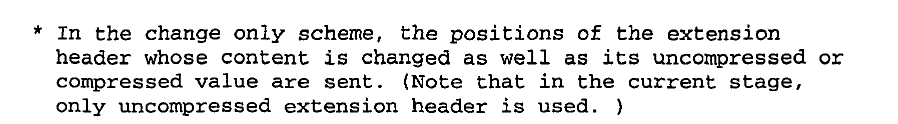

The aforementioned 3 schemes generate compressed format of the extension header list. The curr_list can also be sent in an uncompressed format.

### 5.8.2.2.3 Special Handling

### 5.8.2.2.3.1 Special Handling of AH

The sequence number field in the AH contains a monotonically increasing counter value for a security association. Therefore, when comparing curr_list with ref_list, if the sequence number in AH changes and SPI field doesn't change, the AH is not necessary to be classified as changed.

If the sequence number in the AH linearly increases as RTP sequence number increases, it doesn't need to be sent. The decompressor applies linear extrapolation to reconstruct the sequence number in AH. Otherwise, a compressed sequence number should be included in the IPv6 Extension Headers compression element field in PT2 extension "11" header.

The authentication data field in AH changes from packet to packet and should be sent in every packet. If the uncompressed AH is sent, the authentication data field is sent inside the uncompressed AH; otherwise,

it is sent after the compressed IP/UDP/RTP and IPv6 extension headers and before the payload.

### 5.8.2.2.3.2 Encapsulating Security Payload Header

If Encapsulating Security Payload Header (ESP) is used, the UDP and RTP headers are both encrypted and cannot be compressed. In this case, special compressed packet format needs to be defined in ROHC.

In ESP, the only fields that can be compressed are the SPI and the sequence number.
* In the case that the SPI field changes, the uncompressed ESP is sent.
* In the case that no change happens to the SPI field, the ESP is not considered as changed.

The sequence number in ESP has the same behavior as the same field in AH. If it linearly increases, it doesn't need to be sent. Otherwise, a compressed sequence number should be sent in the IPv6 Extension Headers compression element field in PT2 extension "11" header.

### 5.8.2.2.3.3 Special Handling of Next Header Field

The next header field in an extension header changes whenever the type of the immediately following header changes, e.g., a new extension header is inserted after it, the immediate subsequent extension header is removed from the list, or the order of several extension headers is changed. Thus, in particular, it may not be uncommon that for a given extension header, only the next header field changes but the remaining fields don't change. Therefore, the next header field in each extension header needs to be treated in a special way.

In the case that only the next header field changes, the extension header should be considered as unchanged. The special treatment of the change of the next header field is defined as follows.

* In the case that a subsequent extension header is removed from the list, the new value of the next header field can be obtained from the reference extension header list. For example, assume that the reference extension header list (ref_list) consists of extension header A, B and C (ref_ext_hdr A, B, C), and the current extension header list (curr_list) only consists of extension headers A and C (curr_ext_hdr A, C). The order and value of the next header field of these extension headers are as follows.

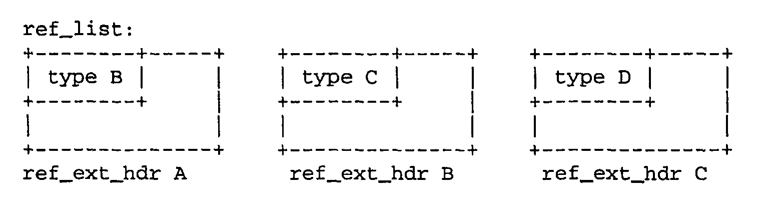

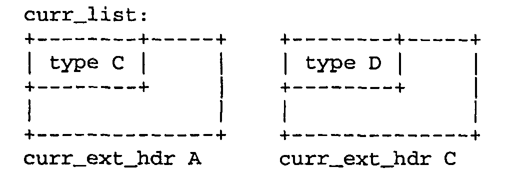

Comparing the curr_ext_hdr A in curr_list and the ref_ext_hdr A in ref_list, the value of next header field is changed from "type B" to "type C" because of removal of extension header B.

The new value of the next header field in curr_ext_hdr A, i.e., "type C" doesn't need to be sent to the decompressor, because when the decompressor detects (by observing the list level encoding) that the immediate following extension header B is removed from the list, it retrieves the next header field in ref_ext_hdr B and use it to replace the next header field in the curr_ext_hdr A.

* In the case that a new extension header is inserted after an existing extension header, the next header field in the new extension header carries the type of itself, instead of the type of extension header that follows. For example, assume that the reference extension header list (ref_list) consists of extension header A and C (ref_ext_hdr A, C), and the current extension header list (curr_list) consists of extension header A, B and C (curr_ext_hdr A, B, C). The order and the value of the next header field of these extension headers are as follows.

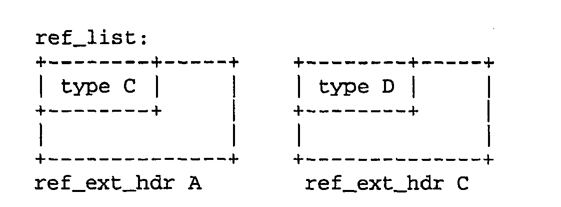

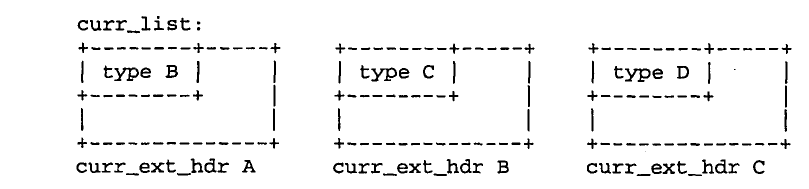

Comparing the curr_list and the ref_list, the value of the next header field in extension header A is changed from "type C" to "type B".

In the compressed extension header list, the uncompressed curr_ext_hdr B is carried in the uncompressed data field in c_item or u_item depending on the list encoding scheme used. However, instead of carrying the type of the next header (type C) in the next header field, the type of curr_ext_hdr B (type B) should be carried. When the decompressor detects (by observing the list level encoding) that a new extension is inserted after curr_ext_hdr A, it will replace the old next header field in ref_ext_hdr A with the type of the inserted extension header, i.e., type B, which is carried in the next header field in the c_item or u_item for extension header B. At the same time, the decompressor also replace the next header field in curr_ext_hdr B with the old value of the next header field in ref_ext_hdr A, i.e., type C.

### 5.8.2.3. Packet Format

### 5.8.2.3.1. Format in extension "11" header

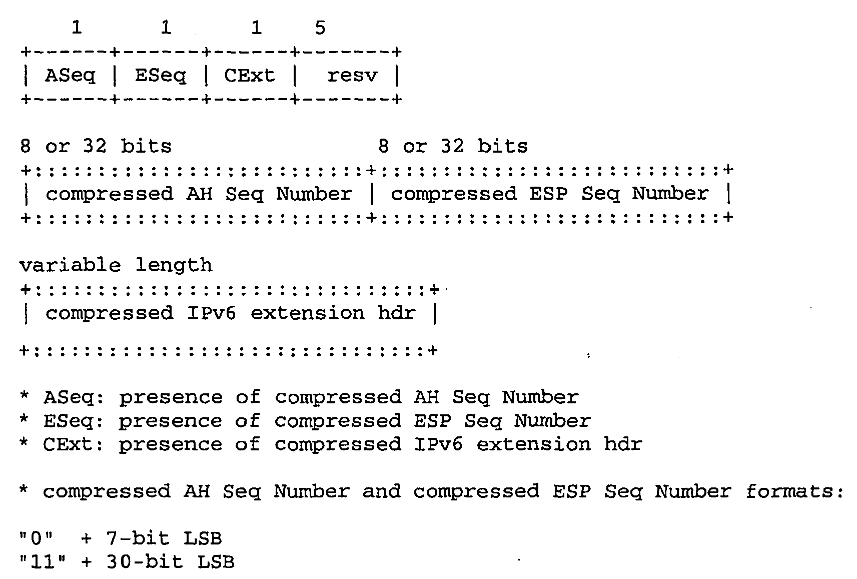

### 5.8.2.3.2 Format of compressed IPv6 extension header

### 5.8.2.3.2.1 Insertion Only Scheme

### 5.8.2.3.2.1.1 R-mode

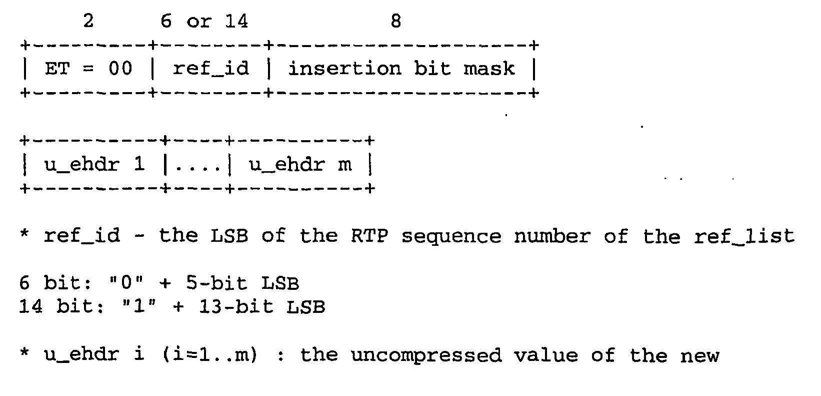

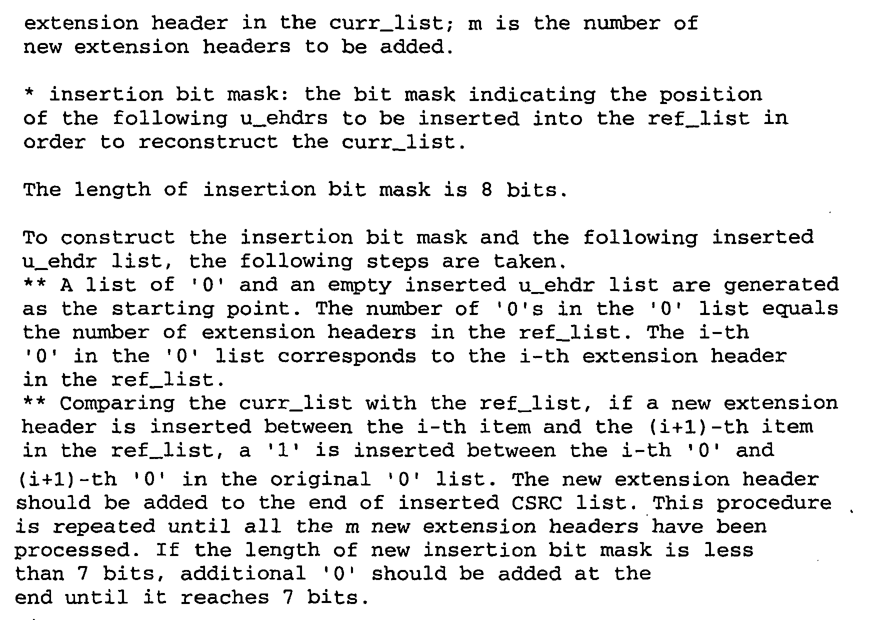

When the decompressor receives the insertion bit mask, it scans from left to right. When a '0' is observed, the decompressor copies the corresponding extension header in the ref_list into the curr_list; when a '1' is observed, the decompressor adds the correspondent u_ehdr into the curr_list.

### 3.2.1.2 UO-modes

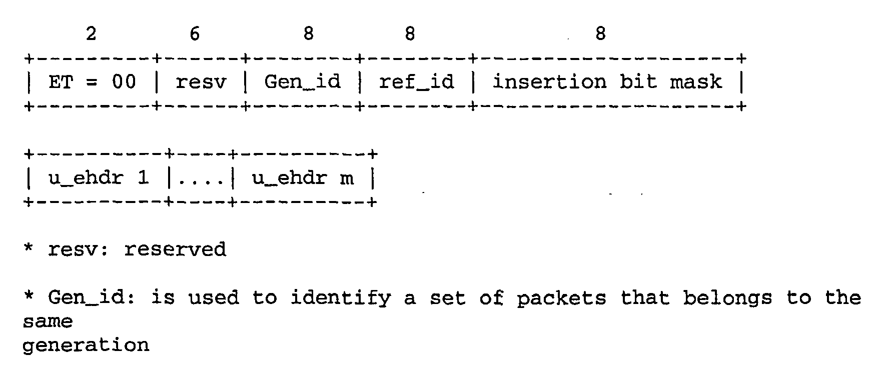

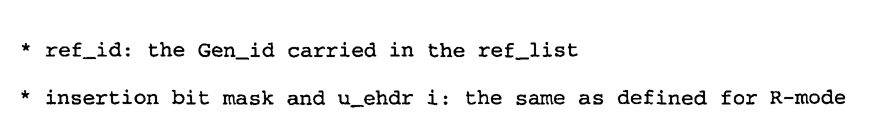

### 5.8.2.3.2.2 Removal Only Scheme

### 5.8.2.3.2.2.1 R-mode

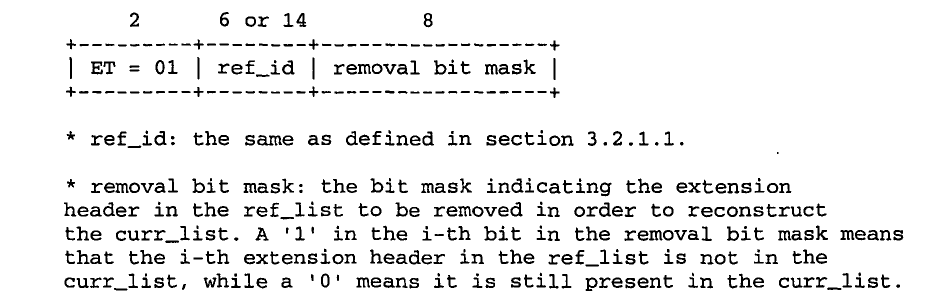

The length of insertion bit mask can be 8 bits.

### 3.2.2.2 UO-mode

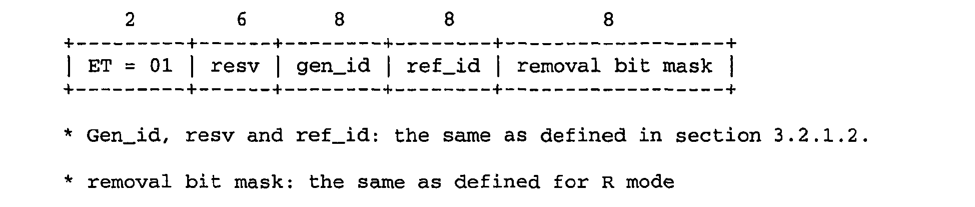

### 5.8.2.3.2.3 Content Change Only Scheme

### 5.8.2.3.2.3.1 R-mode

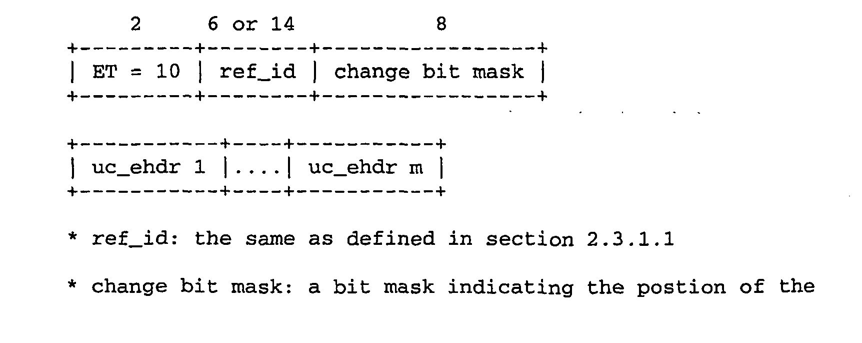

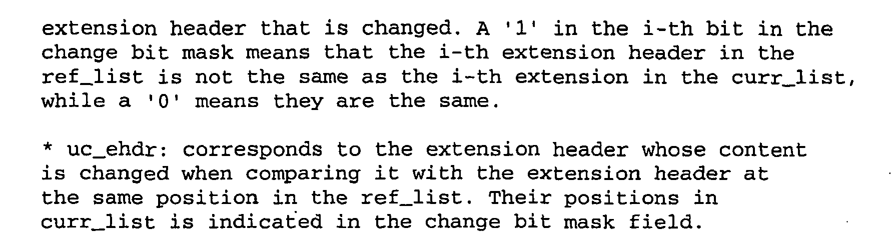

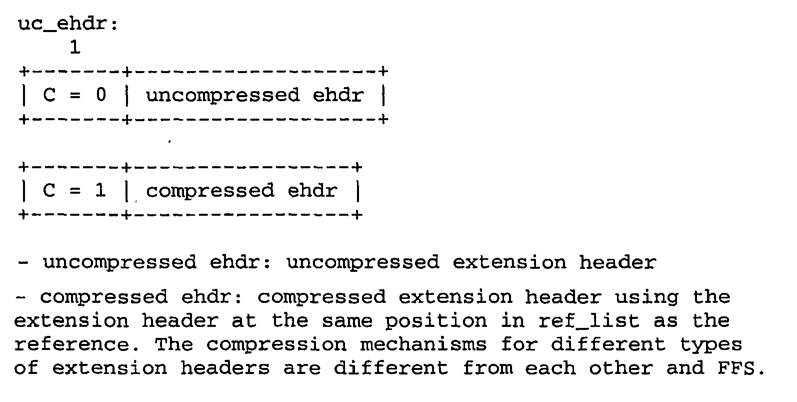

### 5.8.2.3.2.3.2 UO-mode

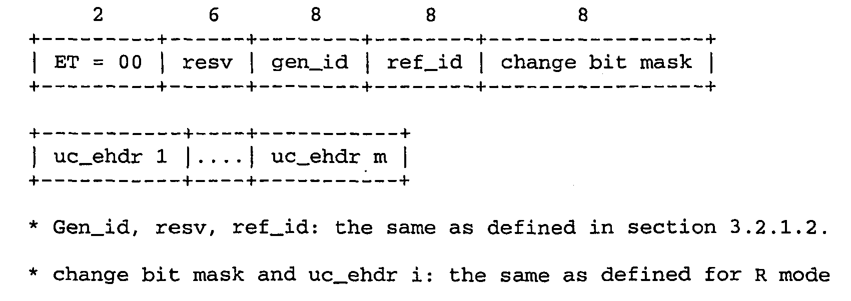

### 5.8.2.3.2.4 Uncompressed Scheme (common to R-mode and UO-modes)

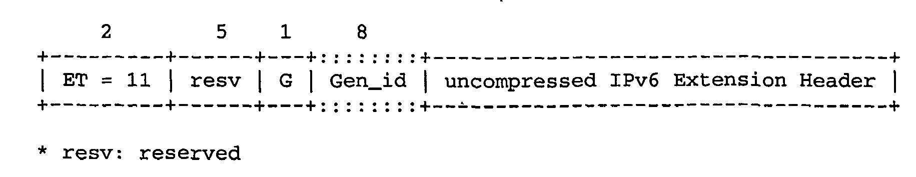

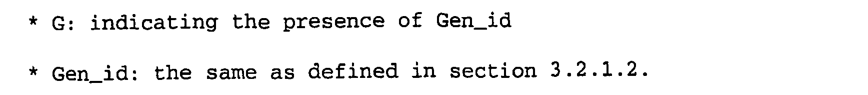

- In R-mode, gen_id is not present.
- During the transition from any mode to U-mode or O-mode, gen_id should not be sent. The list without gen_id should not be used as a reference to compress and decompress an extension header list.
- In UO-modes, gen_id is present if it may be used as a reference to compress or decompress the subsequent extension header list.

### 5.9. Header compression CRCs, coverage and polynomials

This chapter describes how to calculate the CRCs used in packet headers defined in this document.

### 5.9.1. IR & IR-DYN packet CRCs

The CRC in the IR and IR-DYN packet is calculated over the entire IR or IR-DYN packet, excluding Payload and including CID. For purposes of computing the CRC, the CRC field in the header is set to zero.

The initial content of the CRC register be preset to all 1's.

The CRC polynomial to be used is: $C ( x ) = 1 + x + x {}^{\hat{}} 2 + x {}^{\hat{}} 8$

### 5.9.2. CRCs in compressed packets

The CRC in compressed packets is calculated over the entire original header, before compression.

[[Editor's note: In the Pittsburgh WG meeting, we said that the CRC computation overhead can be reduced by computing the CRC over the static parts of the packet first and then over the dynamic parts. This needs to be specified here in detail.]]

The polynomial to be used for 3 bit CRC is: $C ( x ) = 1 + x + x ^ 3$

The polynomial to be used for 7 bit CRC is: $C ( x ) = ? ? ? [ to be defined ]$

### 6. Implementation issues

This document specifies mechanisms for the protocol, while much of the usage of these mechanisms is left to the implementers to decide upon. This chapter is aimed to give guidelines, ideas and suggestions for implementing the scheme.

### 6.1. Reverse decompression

This chapter describes an optional decompressor operation to reduce discarded packets due to an invalid context.

Once a context becomes invalid (e.g., in the case when more consecutive packet losses than expected has occurred), subsequent compressed packets cannot be decompressed correctly immediately. Reverse decompression aims at decompressing such packets later instead of discarding them, by storing them until the context has been updated and validated and then attempting decompression.

Let the sequence of stored packets be i, i+1, ..., i+k, where i is the first packet and I+k is the packet before the context was updated. The decompressor will attempt to recover the stored packets in reverse order, i.e., starting with i+k, and working towards i. When a stored packet has been reconstructed, its correctness is verified using its CRC. Packets not carrying a CRC must not be delivered to upper layers. Packets where the CRC succeeds, are delivered to upper layers in the original order, i.e., i, ..., i+k.

Note that this reverse decompression introduces buffering while waiting for the context to be validated and thereby introduces additional delay. Thus, it should be used only when some amount of delay is acceptable. For example, for video packets belonging to the same video frame, the delay of packet arrival time does not cause presentation time delay. Delay-insensitive streaming applications can also be tolerant to such delay. If the decompressor cannot determine if the application can tolerate delay, it should not do reverse decompression.

The following illustrates the decompression procedure in some detail:
1. The decompressor stores compressed packets that cannot be decompressed correctly due to an invalid context.
2. When the decompressor has received a context updating packet and the context has been validated, it starts to recover the stored packets in reverse order. Decompression is carried out followed by the last decompressed packet to its previous packet as if the two packets were reordered. After that, the decompressor checks the correctness of the reconstructed header using the CRC.
3. If the CRC indicates successful decompression, the decompressor stores the complete packet and attempts to decompress the preceeding packet. In this way, the stored packets are recovered until no compressed packets are left. For each packet, the decompressor checks the correctness of the decompressed headers using header compression CRC.
4. If the CRC indicates an incorrectly decompressed packet, the reverse decompression attempt must be terminated and all remaining uncompressed packets must be discarded.
5. Finally, the decompressor forwards all the correctly decompressed packets to upper layers in the original order.

### 6.2. RTCP

RTCP is the RTP Control Protocol, [RTP]. RTCP is based on periodic transmission of control packets to all participants in a session, using the same distribution mechanism as for data packets. Its primary function is to provide feedback from the data receivers on the quality of the data distribution. The feedback information may be used for issues related to congestion control functions, and directly useful for control of adaptive encodings.

In an RTP session there will be two types of packet streams; one with the RTP-header and application data, and a second stream with the RTCP control information. The difference between the streams at the transport level is the UDP port numbers, which is plus one for RTCP. The ROHC header compressor implementation has several ways at hand to handle the RTCP stream.
1. One compressor/decompressor entity for both streams and carried on the same channel using CIDs to distinguish between them. On the RTCP stream, basically only IP/UDP compression will be utilized.
2. Two compressor/decompressor entities, one for RTP and another one for RTCP, and the streams carried on their own channel. This means that they will not share the same CID number space.

### 7. Further work

(Editor: This section is ''further work_'' in particular as it needs to be integrated into the rest of the document.)

### 7.3. Tunneling

### 7.3.1. Header Compression for IPv4 Tunneling Header

In order to route the packets to the mobile node that is on a foreign link, the home agent of the mobile node may encapsulate the original packet into an IP header and tunnel the packet to the care-of address of the mobile node. In the case of foreign agent care-of address in Mobile IPv4, the tunneling header in each tunneled packet will be removed by the foreign agent before transferring it to the mobile node through the air interface; therefore there is no need for compression of tunneling header. In the case that mobile node uses collocated care-of address, the tunneled packet will be sent to mobile station through air interface, and compression needs to be applied to the tunneling header.

### 7.3.1.1. Mobile IPv4 Tunneling Header Fields Type

The table below summarizes classification of the various fields defined in different tunneling headers used in Mobile IPv4. In the column of Encapsulation Scheme (Enc. Scheme), three encapsulation methods are included - IP in IP Encapsulation (IIE), Minimum Encapsulation (ME), Generic Routing Encapsulation (GRE).

(Editor's note: Harmonize with the way this is described in ROHC document)

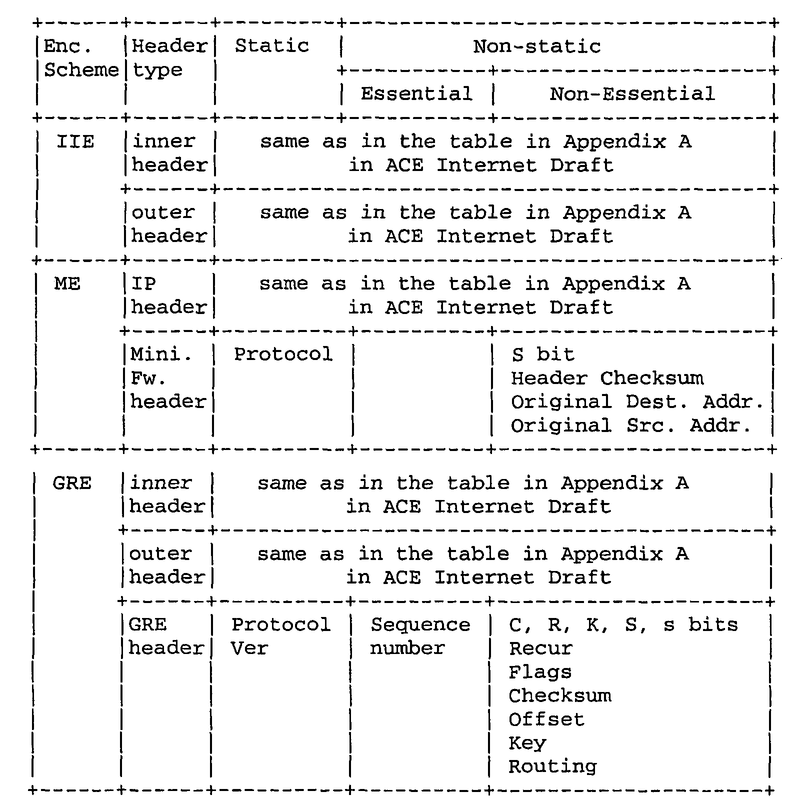

### 7.3.1.2. Compression of Tunneling Headers in MIPv4

Three encapsulation schemes have been specified in MIPv4. For different encapsulation scheme, the compression methods are different from each other.

### 7.3.1.2.1. IP in IP Encapsulation in IPv4

Using IP in IP Encapsulation, the original inner IP header is not modified at all and therefore can be compressed as if it is not encapsulated. The outer header is compressed at the IP level, while the inner header is compressed as defined in ROHC.

### 7.3.1.2.2. Minimum Encapsulation in IPv4

With Minimum Encapsulation, the original IP header is modified and the Minimal Forwarding Header is inserted between the modified IP header and the original IP payload. The modified IP header plus the the UDP/RTP headers is compressed as defined in ROHC.

The compression scheme for the Minimal Forwarding Header is similar to the scheme applied to the IP header. The static and changing non- essential fields in the Minimum Forwarding Header are sent in the Full Header and Refresh state. When any change happens to any non-essential field in the Minimum Forwarding Header, a compressed header with a bit mask indicating the change should be sent.

### 7.3.1.2.3. Generic Routing Encapsulation in IPv4

With Generic Routing Encapsulation, the original IP packet is encapsulated in an outer IP header. A GRE header is inserted between the inner header and the outer header. The original IP/UDP/RTP header is compressed as if there is no encapsulation. The outer IP header is compressed at the IP level.

The compression scheme for the GRE header is similar to the scheme applied to the IP header. All the static and changing non-essential fields in the GRE header are sent in the Full Header and refresh state. When any change happens to any non-essential field in the GRE header, a compressed header with a bit mask indicating the change should be sent. If the sequence number in the GRE header is present, the scheme to compress sequence number could be VLE, as defined in ACE draft.

### 7.4. non-RTP UDP traffic

(Editor's note: This is text from draft-koren-avt-crtp-enhance-01.txt to be added to rohc -- not yet consistent with the rest of the document)

[Micke's note: this should be a separate profile.]
[cabo's note: I'm not even sure we want to keep it in ROHC at all. The negative cache flag could simply be added to I/R, of course, e.g. as a profile.
Note that streams with odd port numbers should never be RTP streams, so this might be considered to simplify RTCP compression.

I'm not sure the case about e2e CRTP in tunnels applies to ROHC very much. We must explain REJECT packets better above.]

### 2.1 The negative cache stream flag

Certain streams, known or suspected to not be RTP, can be placed in a "negative cache" at the compressor, so only the IP and UDP headers are compressed. It is beneficial to notify the decompressor that the compressed stream is in the negative cache: for such streams the context is shorter - there is no need to include the RTP header, and all RTP-related calculations can be avoided.

In this enhancement, a new flag bit "N" is added to the FULL_HEADER packet that initializes a context at the decompressor. The bit occupied by the new flag was previously always set to zero. If the N flag is set to 1, this indicates that no COMPRESSED_RTP packets will be transmitted in this context. This flag is only an optimization and the decompressor may choose to ignore it.

[[Editor: The negative cache flag could be part of the profile information]]

### 2.2 Reject a new compressed stream

In a point to point link the two nodes can agree on the number of compressed sessions they are prepared to support for this link. In an end-to-end scheme a host may have compressed sessions with many hosts and eventually may run out of resources. When the end-to-end tunnel is negotiated, the number of contexts needed may not be predictable. This enhancement allows the negotiated number of contexts to be larger than could be accommodated if many tunnels are established.

Then, as context resources are consumed, an attempt to set up a new context may be rejected.

The compressor initiates a compression of a stream by sending a FULL_HEADER packet. Currently if the decompressor has insufficient resources to decompress the new stream, it can send a CONTEXT_STATE packet to invalidate the newly compressed stream. The compressor does not know the reason for the invalidation: usually this happens when the decompressor gets out of synchronization due to packet loss. The compressor will most likely reattempt to compress this stream by sending another FULL_HEADER.

This enhancement specifies that the decompressor may reject the compression of a stream by sending a REJECT message to the compressor. A REJECT message tells the compressor to stop compressing this stream.

The REJECT message is a [[feedback-4 of type REJECT]] with an additional flag:
Type code = 1 :CONTEXT_STATE for 8-bit CID streams
Type code = 2 : CONTEXT_STATE for16-bit CID streams

[[Editor: This will be handled by the REJECT feedback packet]]

The compressor may decide to wait for a while before attempting to compress additional streams destined to the rejecting host.

### 8. Section 8 has been removed.

### 9. Security considerations

Because encryption eliminates the redundancy that header compression schemes try to exploit, there is some inducement to forego encryption of headers in order to enable operation over low-bandwidth links. However, for those cases where encryption of data (and not headers) is sufficient, RTP does specify an alternative encryption method in which only the RTP payload is encrypted and the headers are left in the clear. That would still allow header compression to be applied.

ROHC compression is transparent with regards to the RTP sequence number and RTP timestamp fields, so the values of those fields can be trusted by payload encryption schemes.

A malfunctioning or malicious header compressor could cause the header decompressor to reconstitute packets that do not match the original packets but still have valid IP, UDP and RTP headers and possibly also valid UDP checksums. Such corruption may be detected with end-to-end authentication and integrity mechanisms which will not be affected by the compression. Moreover, this header compression scheme uses an internal checksum for verification of re-constructed headers. This reduces the probability of producing decompressed headers not matching the original ones without this being noticed.

Denial-of-service attacks are possible if an intruder can introduce (for example) bogus STATIC, DYNAMIC or FEEDBACK packets onto the link and thereby cause compression efficiency to be reduced. However, an intruder having the ability to inject arbitrary packets at the link layer in this manner raises additional security issues that dwarf those related to the use of header compression.

### 10. Acknowledgements

When designing this protocol, earlier header compression ideas described in [CJHC], [IPHC] and [CRTP] have been important sources of knowledge.

Thanks to Takeshi Yoshimura at NTT DoCoMo for providing the reverse decompression section (6.1). Thanks also to Anton Martensson for many valuable draft contributions and to Andreas Jonsson (Lulea University), who made a great job supporting this work in his study of header field change patterns. Thanks also to all others who have given comments.

### 11. Intellectual property considerations

(Editor's note: this section will go to www.ietf.org/ipr and be replaced by the standard reference to that, but for now it is left in the draft to simplify working on it.)

This proposal in is conformity with RFC 2026.

Telefonaktiebolaget LM Ericsson and its subsidiaries, in accordance with corporate policy, will for submissions rightfully made by its employees which are adopted or recommended as a standard by the IETF offer patent licensing as follows:

If part(s) of a submission by Ericsson employees is (are) included in a standard and Ericsson has patents and/or patent application(s) that are essential to implementation of such included part(s) in said standard, Ericsson is prepared to grant - on the basis of reciprocity (grant-back) - a license on such included part(s) on reasonable, non-discriminatory terms and conditions.

For the avoidance of doubt this general patent licensing undertaking applies to this proposal.

Nokia has filed patent applications that might possibly have technical relation to this contribution.

Matsushita has filed patent applications that might possibly have technical relation to this contribution.
If part(s) of the contribution by Matsushita employee is (are) included in a standard and Matsushita has patents and/or patent application(s) that are essential to implementation of such included part(s) in said standard, Matsushita is prepared to grant - on the basis of reciprocity (grantback) - a license on such included part(s) on reasonable, non-discriminatory terms and conditions (in according with paragraph 10.3.3 of the RFC 2026).

NTT DoCoMo, Inc. also declares this text may relevant to their patent, and offer patent licensing as follows:

If part(s) of this text provided by NTT DoCoMo employees is (are) included in a standard and NTT DoCoMo has patents and/or patent application(s) that are essential to implementation of such included part(s) in said standard, NTT DoCoMo is prepared to grant - on the basis of reciprocity (grant-back) - a license on such included part(s) on reasonable, non-discriminatory terms and conditions.

### 12. References

- [UDP]: Jon Postel, "User Datagram Protocol", RFC 768, August 1980.
- [IPv4]: Jon Postel, "Internet Protocol", RFC 791, September 1981.
- [IPv6]: Steven Deering, Robert Hinden, "Internet Protocol, Version 6 (IPv6) Specification", RFC 2460, December 1998.
- [RTP]: Henning Schulzrinne, Stephen Casner, Ron Frederick, Van Jacobson, "RTP: A Transport Protocol for Real-Time Applications", RFC 1889, January 1996.
- [HDLC]: William Simpson, "PPP in HDLC-like framing", RFC 1662, 1994.
- [VJHC]: Van Jacobson, "Compressing TCP/IP Headers for Low-Speed Serial Links", RFC 1144, February 1990.
- [IPHC]: Mikael Degermark, Bjorn Nordgren, Stephen Pink, "IP Header Compression", RFC 2507, February 1999.
- [CRTP]: Steven Casner, Van Jacobson, "Compressing IP/UDP/RTP Headers for Low-Speed Serial Links", RFC 2508, February 1999.
- [PPPHC]: Mathias Engan, Steven Casner, Carsten Bormann, "IP Header Compression over PPP", RFC 2509, February 1999.
- [CRTPC]: Mikael Degermark, Hans Hannu, Lars-Erik Jonsson, Krister Svanbro, "CRTP over cellular radio links", Internet Draft (work in progress), December 1999. <draft-degermark-crtp-cellular-01.txt>
- [REQ]: Mikael Degermark, "Requirements for robust IP/UDP/RTP header compression", Internet Draft (work in progress), June 2000. <draft-ietf-rohc-rtp-requirements-01.txt>
- [LLG]: Krister Svanbro, "Lower Layer Guidelines for Robust Header Compression", Internet Draft (work in progress), May 2000. <draft-ietf-rohc-lower-layer-guidelines-00.txt>
- [CELL]: Lars Westberg, Morgan Lindqvist, "Realtime traffic over cellular access networks", Internet Draft (work in progress), May 2000. <draft-westberg-realtime-cellular-02.txt>
- [WCDMA]: "Universal Mobile Telecommunications System (UMTS); Selection procedures for the choice of radio transmission technologies of the UMTS (UMTS 30.03 version 3.1.0)". ETSI TR 101 112 V3.0.1, November 1997.

### 13. Authors' addresses

| | |
|---|---|
| Carsten Bormann | Tel: +49 421 218 7024 |
| Universitaet Bremen TZI | Fax: +49 421 218 7000 |
| Postfach 330440 | EMail: cabo@tzi.org |
| D-28334 Bremen, GERMANY | |
| Mikael Degermark | Tel: +1 520 621-3498 |
| The University of Arizona | Fax: +1 520 621-4642 |
| Dept of Computer Science | Email: micke@cs.arizona.edu |
| P.O. Box 210077 | |
| Tucson, AZ 85721-0077, USA | |
| Lars-Erik Jonsson | Tel: +46 920 20 21 07 |
| Ericsson Erisoft AB | Fax: +46 920 20 20 99 |
| SE-971 28 Lulea, Sweden | EMail: lars-erik.jonsson@ericsson.com |
| Zhigang Liu | Tel: +1 972 894-5935 |
| Nokia Research Center | Fax: +1 972 894-4589 |
| 6000 Connection Drive | EMail: zhigang.liu@nokia.com |
| Irving, TX 75039, USA | |

### Appendix A. Detailed classification of header fields

Header compression is possible due to the fact that most header fields do not vary randomly from packet to packet. Many of the fields exhibit static behavior or changes in a more or less predictable way. When designing a header compression scheme, it is of fundamental importance to understand the behavior of the fields in detail.

In this appendix, all IP, UDP and RTP header fields are classified and analyzed in two steps. First, we have a general classification in A.1 where the fields are classified based on stable knowledge and assumptions. The general classification does not take into account the change characteristics of changing fields because those will vary more or less depending on the implementation and on the application used. A less stable but more detailed analysis considering the change characteristics is then done in A.2. Finally, A.3 summarizes this appendix with conclusions about how the various header fields should be handled by the header compression scheme to optimize compression and functionality.

### A.1. General classification

On a general level, the header fields are separated into 5 classes:
- INFERRED: These fields contain values that can be inferred from other values, for example the size of the frame carrying the packet, and thus does not have to be handled at all by the compression scheme.
- STATIC: These fields are expected to be constant throughout the lifetime of the packet stream. Static information must in some way be communicated once.
- STATIC-DEF: STATIC fields whose values define a packet stream. They are in general handled as STATIC.
- STATIC-KNOWN: These STATIC fields are expected to have well-known values and therefore do not need to be communicated at all.
- CHANGING: These fields are expected to vary in some way, either randomly, within a limited value set or range, or in some other manner.

In this section, each of the IP, UDP and RTP header fields is assigned to one of these classes. For all fields except those classified as CHANGING, the motives for the classification are also stated. CHANGING fields are in A.2 further examined and classified based on their expected change behavior.

### A.1.1. IPv6 header fields

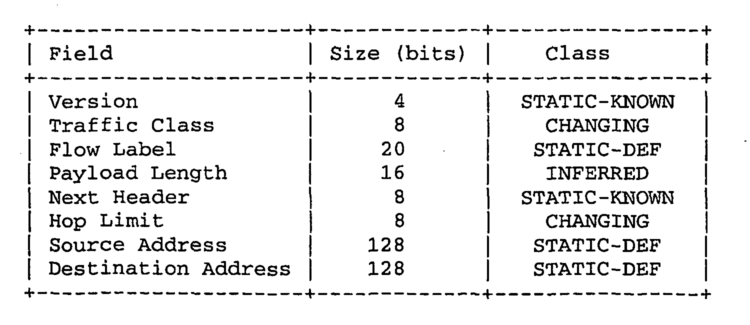

### Version

The version field states which IP version the packet is based on. Packets with different values in this field must be handled by different IP stacks. For header compression, different compression profiles must also be used. When compressor and decompressor have negotiated which profile to use, the IP version is also known to both parties. The field is therefore classified as STATIC-KNOWN.

### Flow Label

This field may be used to identify packets belonging to a specific packet stream. If not used, the value should be set to zero. Otherwise, all packets belonging to the same stream must have the same value in this field, it being one of the fields defining the stream. The field is therefore classified as STATIC-DEF.

### Payload Length

Information about the packet length (and then also payload length) is expected to be provided by the link layer. The field is therefore classified as INFERRED.

### Next Header

This field is expected to have the same value in all packets of a packet stream. As for the version number, a certain compression profile can only handle a specific next header which means that this value is known.when profile has been negotiated. The field is therefore classified as STATIC-KNOWN.

### Source and Destination addresses

These fields are part of the definition of a stream and must thus be constant for all packets in the stream. The fields are therefore classified as STATIC-DEF.

Summarizing the bits corresponding to the classes gives:

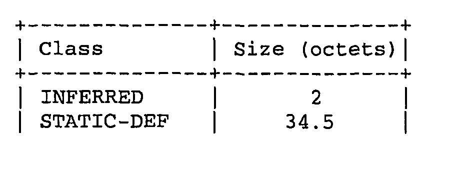

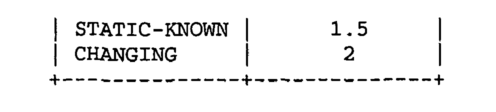

### A.1.2. IPv4 header fields

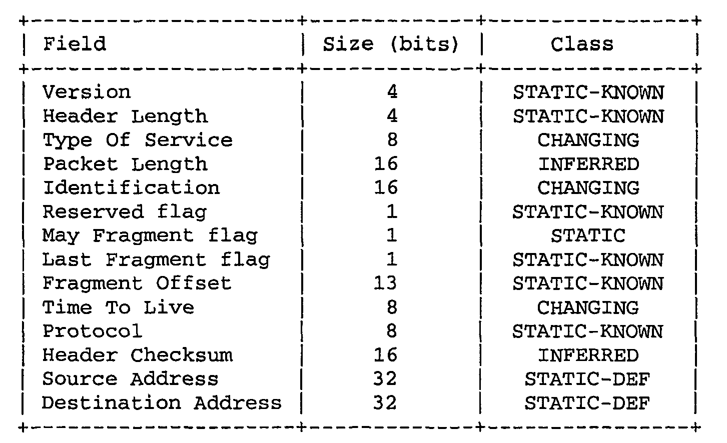

### Version

The version field states which IP version the packet is based on and packets with different values in this field must be handled by different IP stacks. For header compression, different compression profiles must also be used. When compressor and decompressor has negotiated which profile to use, the IP version is also well known to both parties. The field is therefore classified as STATIC-KNOWN.

### Header Length

As long as there are no options present in the IP header, the header length is constant and well known. If there are options, the fields would be STATIC, but we assume no options. The field is therefore classified as STATIC-KNOWN.

### Packet Length

Information about the packet length is expected to be provided by the link layer. The field is therefore classified as INFERRED.

### Flags

The Reserved flag must be set to zero and is therefore classified as STATIC-KNOWN. The May Fragment flag will be constant for all packets in a stream and is therefore classified as STATIC. Finally, the Last Fragment bit is expected to be zero because fragmentation is NOT expected, due to the small packet size expected. The Last Fragment bit is therefore classified as STATIC-KNOWN.

### Fragment Offset

With the assumption that no fragmentation occurs, the fragment offset is always zero. The field is therefore classified as STATIC-KNOWN.

### Protocol

This field is expected to have the same value in all packets of a packet stream. As for the version number, a certain compression profile can only handle a specific next header which means that this value is well known when profile has been negotiated. The field is therefore classified as STATIC-KNOWN.

### Header Checksum

The header checksum protects individual hops from processing a corrupted header. When almost all IP header information is compressed away, there is no need to have this additional checksum; instead it can be regenerate at the decompressor side. The field is therefore classified as INFERRED.

### Source and Destination addresses

These fields are part of the definition of a stream and must thus be constant for all packets in the stream. The fields are therefore classified as STATIC-DEF.

Summarizing the bits corresponding to the classes gives:

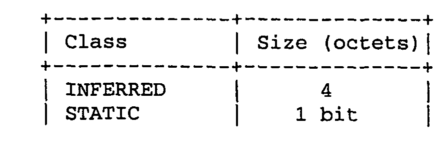

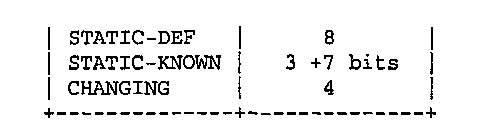

### A.1.3. UDP header fields

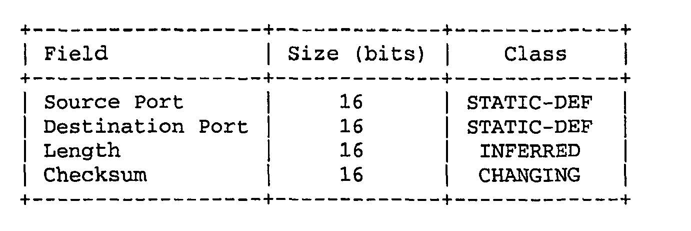

### Source and Destination ports

These fields are part of the definition of a stream and must thus be constant for all packets in the stream. The fields are therefore classified as STATIC-DEF.

### Length

This field is redundant and is therefore classified as INFERRED.

Summarizing the bits corresponding to the classes gives:

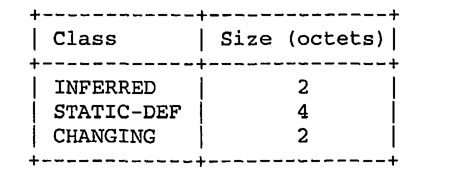

### A.1.4. RTP header fields

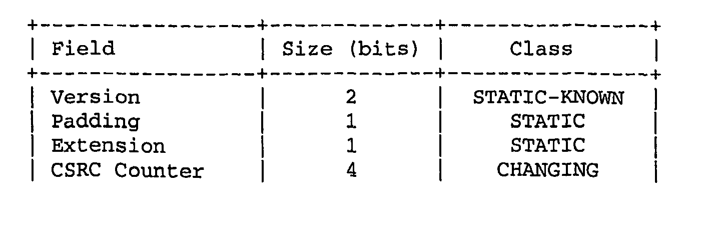

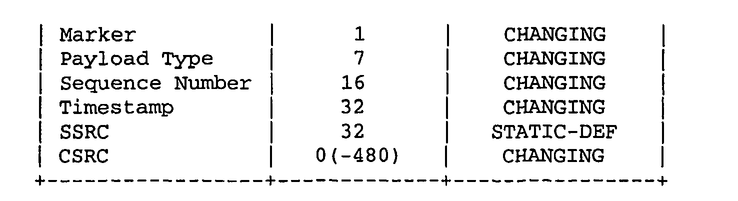

### Version

There exists only one working RTP version and that is version 2. The field is therefore classified as STATIC-KNOWN.

### Padding

The use of this field depends on the application, but when payload padding is used it is likely to be present in all packets. The field is therefore classified as STATIC.

### Extension

If RTP extensions is used by the application, it is likely to be an extension present in all packets (but use of extensions is very uncommon). However, for safety's sake this field is classified as STATIC and not STATIC-KNOWN.

### SSRC

This field is part of the definition of a stream and must thus be constant for all packets in the stream. The field is therefore classified as STATIC-DEF.

Summarizing the bits corresponding to the classes gives:

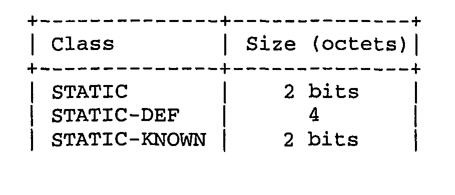

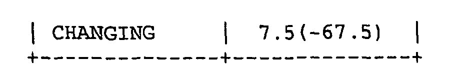

### A.1.5. Summary for IP/UDP/RTP

If we summarize this for IP/UDP/RTP we get:

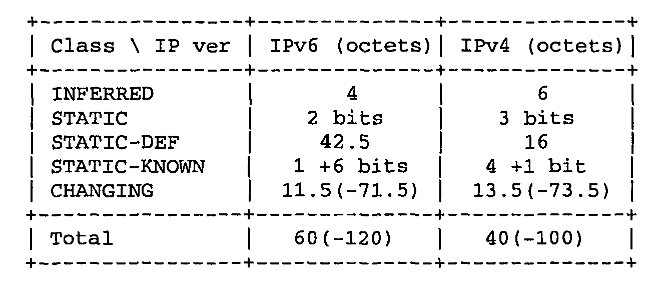

### A.2. Analysis of change patterns of header fields

To design suitable mechanisms for efficient compression of all header fields, their change patterns must be analyzed. For this reason, an extended classification is done based on the general classification in A.1, considering the fields which were labeled CHANGING in that classification. Different applications will use the fields in different ways, which may affect their behavior. When this is the case, typical behavior for conversational audio and video will be discussed.

The CHANGING fields are separated into five different subclasses:
- STATIC: These are fields that were classified as CHANGING on a general basis, but are classified as STATIC here due to certain additional assumptions.
- SEMISTATIC: These fields are STATIC most of the time. However, occasionally the value changes but reverts to its original value after a known number of packets.
- RARELY-CHANGING (RC): These are fields that change their values occasionally and then keep their new values.
- ALTERNATING: These fields alternate between a small number of different values.
- IRREGULAR: These, finally, are the fields for which no useful change pattern can be identified.

To further expand the classification possibilities without increasing complexity, the classification can be done either according to the values of the field and/or according to the values of the deltas for the field.

When the classification is done, other details are also stated regarding possible additional knowledge about the field values and/or field deltas, according to the classification. For fields classified as STATIC or SEMISTATIC, the case could be that the value of the field is not only STATIC but also well KNOWN a priori (two states for SEMISTATIC fields). For fields with non-irregular change behavior, it could be known that changes usually are within a LIMITED range compared to the maximal change for the field. For other fields, the values are completely UNKNOWN.

Table A.1 classifies all the CHANGING fields based on their expected change patterns, especially for conversational audio and video.

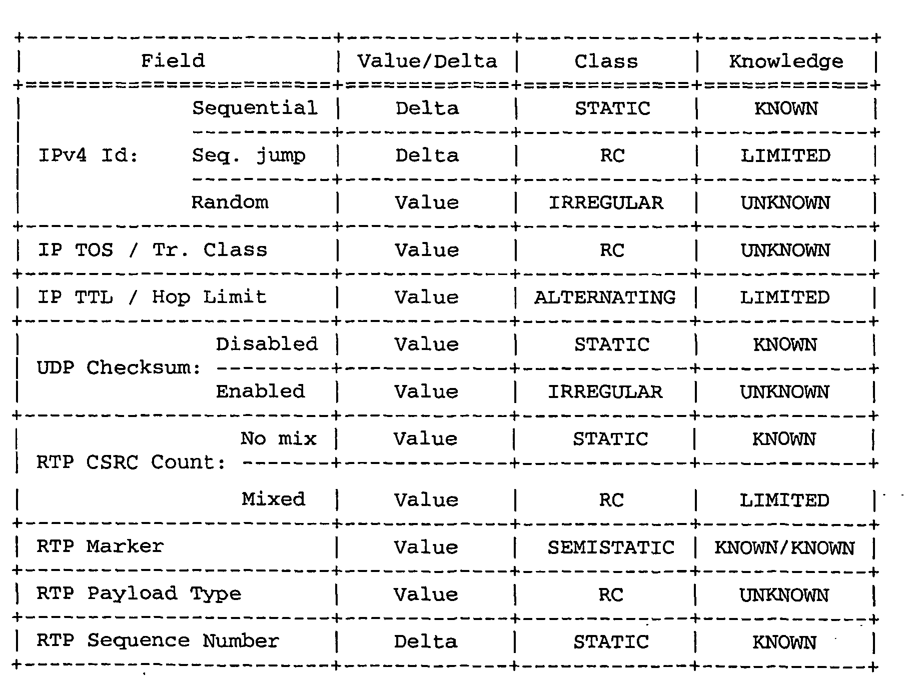

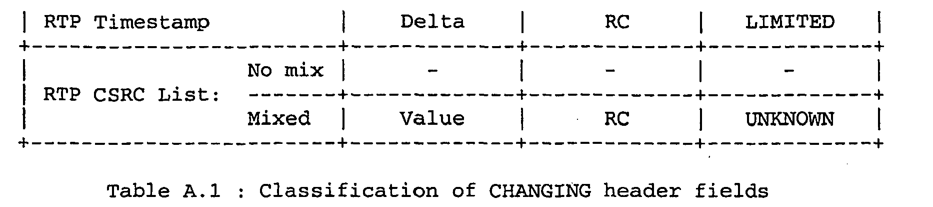

The following subsections discuss the various header fields in detail. Note that table A.1 and the discussions below do not consider changes caused by loss or reordering before the compression point.

### A.2.1. IPv4 Identification

The Identification field (IP ID) of the IPv4 header is there to identify which fragments constitute a datagram when reassembling fragmented datagrams. The IPv4 specification does not specify exactly how this field is to be assigned values, only that each packet should get an IP ID that is unique for the source-destination pair and protocol for the time the datagram (or any of its fragments) could be alive in the network. This means that assignment of IP ID values can be done in various ways, which we have separated into three classes.

### Sequential

This assignment policy keeps a separate counter for each outgoing packet stream and thus the IP ID value will increment by one for each packet in the stream. Therefore, the delta value of the field is constant and well known a priori. When RTP is used on top of UDP and IP, the IP ID value follows the RTP sequence number. This assignment policy is the most desirable for header compression purposes but its usage is not as common as it should be. The reason is that it can be realized only if UDP and IP are implemented together so that UDP, which separates packet streams by the port identification, can make IP use separate ID counters for each packet stream.

### Sequential jump

This is the most common assignment policy in today's IP stacks. The difference from the sequential method is that only one counter is used for all connections. When the sender is running more than one packet stream simultaneously, the IP ID can increase by more than one. The IP ID values will be much more predictable and require less bits to transfer than random values, and the packet-to-packet increment (determined by the number of active outgoing packet streams and sending frequencies) will usually be limited.

### Random

Some IP stacks assign IP ID values using a pseudo-random number generator. There is thus no correlation between the ID values of subsequent datagrams. Therefore there is no way to predict the IP ID value for the next datagram. For header compression purposes, this means that the IP ID field needs to be sent uncompressed with each datagram, resulting in two extra octets of header. IP stacks in cellular terminals SHOULD NOT use this IP ID assignment policy.

It should be noted that the ID is an IPv4 mechanism and is therefore not needed at all in IPv6 profiles. For IPv4 the ID could be handled in three different ways. Firstly, we have the inefficient but reliable solution where the ID field is sent as-is in all packets, increasing the compressed headers with two octets. This is the best way to handle the ID field if the sender uses random assignment of the ID field. Secondly, there can be solutions with more flexible mechanisms requiring less bits for the ID handling as long as sequential jump assignment is used. Such solutions will probably require even more bits if random assignment is used by the sender. Knowledge about the sender's assignment policy could therefore be useful when choosing between the two solutions above. Finally, even for IPv4, header compression could be designed without any additional information for the ID field included in compressed headers. To use such schemes, it must be known that the sender makes use of the pure sequential assignment policy for the ID field. That might not be possible to know, which implies that the applicability of such solutions is very uncertain. However, designers of IPv4 stacks for cellular terminals SHOULD use the sequential policy.

### A.2.2. IP Traffic-Class / Type-Of-Service

The Traffic-Class (IPv6) or Type-Of-Service (IPv4) field is expected to be constant during the lifetime of a packet stream or to change relatively seldom.

### A.2.3. IP Hop-Limit / Time-To-Live

The Hop-Limit (IPv6) or Time-To-Live (IPv4) field is expected to be constant during the lifetime of a packet stream or to alternate between a limited number of values due to route changes.

### A.2.4. UDP Checksum

The UDP checksum is optional. If disabled, its value is constantly zero and could be compressed away. If enabled, its value depends on the payload, which for compression purposes is equivalent to it changing randomly with every packet.

### A.2.5. RTP CSRC Counter

This is a counter indicating the number of CSRC items present in the CSRC list. This number is expected to be almost constant on a packet-to-packet basis and change by small amount. As long as no RTP mixer is used, the value of this field is zero.

### A.2.6. RTP Marker

For audio the marker bit should be set only in the first packet of a talkspurt while for video it should be set in the last packet of every picture. This means that in both cases the RTP marker is classified as SEMISTATIC with well-known values for both states.

### A.2.7. RTP Payload Type

Changes of the RTP payload type within a packet stream are expected to be rare. Applications could adapt to congestion by changing payload type and/or frame sizes, but that is not expected to happen frequently.

### A.2.8. RTP Sequence Number

The RTP sequence number will be incremented by one for each packet sent.

### A.2.9. RTP Timestamp

In the audio case:
As long as there are no pauses in the audio stream, the RTP timestamp will be incremented by a constant delta, corresponding to the number of samples in the speech frame. It will thus mostly follow the RTP sequence number. When there has been a silent period and a new talkspurt begins, the timestamp will jump in proportion to the length of the silent period. However, the increment will probably be within a relatively limited range.

In the video case:
The timestamp change between two consecutive packets will either be zero or increase by a multiple of a fixed value corresponding to the picture clock frequency. The timestamp can also decrease by a multiple of the fixed value if B-pictures are used. The delta interval, expressed as a multiple of the picture clock frequency, is in most cases very limited.

### A.2.10. RTP Contributing Sources (CSRC)

The participants in a session, which are identified by the CSRC fields, are expected to be almost the same on a packet-to-packet basis with relatively few additions or removals. As long as RTP mixers are not used, no CSRC fields are present at all.

### A.3. Header compression strategies

This section elaborates on what has been done in previous sections. Based in the classifications, recommendations are given on how to handle the various fields in the header compression process. Seven different actions are possible and these are listed together with the fields to which each action applies.

### A.3.1. Do not send at all

The fields that have well known values a priori do not have to be sent at all. These are:
- IP Version
- IPv6 Payload Length
- IPv6 Next Header
- IPv4 Header Length
- IPv4 Reserved Flag
- IPv4 Last Fragment Flag
- IPv4 Fragment Offset
- IPv4 Protocol
- UDP Checksum (if disabled)
- RTP Version

### A.3.2. Transmit only initially

The fields that are constant throughout the lifetime of the packet stream have to be transmitted and correctly delivered to the decompressor only once. These are:
- IP Source Address
- IP Destination Address
- IPv6 Flow Label
- IPv4 May Fragment Flag
- UDP Source Port
- UDP Destination Port
- RTP Padding Flag
- RTP Extension Flag
- RTP SSRC

### A.3.3. Transmit initially, but be prepared to update

The fields that are changing only occasionally must be transmitted initially but there must also be a way to update these fields with new values if they change. These fields are:
- IPv6 Traffic Class
- IPv6 Hop Limit
- IPv4 Type Of Service (TOS)
- IPv4 Time To Live (TTL)
- RTP CSRC Counter
- RTP Payload Type
- RTP CSRC List

### A.3.4. Be prepared to update or send as-is frequently

For fields that normally are either constant or whose values can be deduced from some other field but frequently diverge from that behavior, there must be an efficient way to update the field value or send it as-is in some packets. Those fields are:
- IPv4 Identification (if not sequentially assigned)
- RTP Marker
- RTP Timestamp

### A.3.5. Guarantee continuous robustness

Fields that behave like a counter with a fixed delta for ALL packets, the only requirement on the transmission encoding is that packet losses between compressor and decompressor must be tolerable. If more than one such field exists, all these can be communicated together. Such fields can also be used to interpret the values for fields listed in the previous section. Fields that have this counter behavior are:
- IPv4 Identification (if sequentially assigned)
- RTP Sequence Number

### A.3.6. Transmit as-is in all packets

Fields that have completely random values for each packet must be included as-is in all compressed headers. Those fields are:
- IPv4 Identification (if randomly assigned)
- UDP Checksum (if enabled)

### A.3.7. Establish and be prepared to update delta

Finally, there is a field that is usually increasing by a fixed delta and is correlated to another field. For this field it would make sense to make that delta part of the context state. The delta must then be possible to initiate and update in the same way as the fields listed in A.3.3. The field to which this applies is:
- RTP Timestamp

### Appendix E - Encoding Examples

### [[Editor's note: Need to update this with current terminology.]]

### E.1. Basic VLE

The examples below illustrate the operation of VLE under various scenarios. The field values used in the examples could correspond to any fields that we wish to compress. The examples illustrate the scenario where the compressed field has resolution of one bit.

Example 1: Normal operation (no packet loss prior to compressor, no reodering prior to compressor).

Suppose packets with header fields 279, 280, 281, 282, and 283 have been sent, and 279 and 283 are fields of potential reference packets.

The current VLE window is {279, 283}.
and a packet with field value = 284 is received next, VLE computes the following values

| New Value | VMax | VMin | r | # LSBs |
|---|---|---|---|---|
| 284 | 283 | 279 | max[\|284-279\|, \|284-283\|]=5 | 4 |

The window is unmodified if we assuming the new packet {284} is not a potential reference. The field is encoded using 4 bits in this case, and the actual encoded value is the 4 least significant bits of 284 (10011100) which = 1100.

### Example 2: Packet Loss prior to compressor.

Suppose packets with header fields 279, 280, 281, 282, and 283 have been sent, and 279 and 283 are fields of potential reference packets such that the VSW is again {279, 283}.

If a packet with field value = 290 is received next, VLE computes the following values

| New Value | VMax | VMin | r | # LSBs |
|---|---|---|---|---|
| 290 | 283 | 279 | max[\|290-283\|,\|290-279\|]=11 | 5 |

So the field is encoded using 5 bits. Actual encoded value is the 5 LSBs of 290 (100100010) which = 00010.

If we assume the new value is a potential reference, the new VSW is {279, 283, 290}.

### Example 3: Packet Misordering prior to compressor.

Suppose packets with header fields 279, 280, 281, 282, and 283 have been sent, and 279 and 283 are fields of potential reference packets such that the VSW is again {279, 283}.

If a packet with field value = 278 is received next, VLE computes the following values

| New Value | VMax | VMin | r | # LSBs |
|---|---|---|---|---|
| 278 | 283 | 279 | max[\|278-283\|,\|278-279\|]=5 | 4 |

So the field is encoded using 4 bits. Actual encoded value is the 4 LSBs of 278 (10010110) which = 0110.

If we assume the new value is a potential reference, the new VSW is {283, 290, 278}.

In any case, the VLE encoded fields must be accompanied by some bits in order to identify the different possible encoded field sizes. Sizes of this bit field can vary depending on the number of different sizes one wishes to allow. The approach in ACE is to allow only a few different sizes for byte-aligned header formats. Huffman coding of the length is used to achieve some additional efficiency, based on the expected frequency of needing the different sizes. 1 or 2 additional bits are actually sent in the ACE compressed header.

The decompressor behavior in all the example cases is the same- it uses as a reference a specific decompressed header field value. The header to use might be indicated by the presence of a checksum in the compressed header packet, or by other means. They must by definition be one of the values in the compressor's window.

For example let's assume that the last correctly decompressed packet which qualifies as a reference was the packet with header field = 291. Now suppose the encoded field value of 303 (10001111) is received and = 01111. The two values closest values to 291 which have LSBs = 01111 are 271 and 303. 303 is closest, therefore it is correctly selected as the uncompressed field value.

### E.2. Timer-Based VLE

As a an example of operation, consider the case of a voice codec (20 ms), such that TS_stride = 160. Assume T_current and p_TS_current are 357 and 351, respectively, and that we have sliding window TSW which contains the following values 4 entries:

| j | T_j | p_TS_j |
|---|---|---|
| 1 | 9 | 7 |
| 2 | 8 | 6 |
| 3 | 7 | 4 |
| 4 | 3 | 1 |

j above is the packet number.

In this case we have
Network_jitter(1)=|(357-9)-(351-7)| =4 (80 ms Network Jitter)
Network_jitter(2)=|(357-8)-(351-6)| =4 (80 ms Network Jitter)
Network_jitter(3)=|(357-7)-(351-4)| =3 (60 ms Network Jitter)
Network_jitter(4)=|(357-3)-(351-1)| =4 (80 ms Network Jitter)

So Max_Network_Jitter = 4.

We assume a maximum CD-CC jitter of 2 (40 ms); the total jitter to be handled in this case is then $J = 4 + 2 + 2 = 8 packets ( 160 ms )$ and k = 5 bits (since 2 * 5 + 1 < 2^5). The compressor sends the 5 LSBs of p_TS_current to the decompressor (351 = 101011111, so the encoded TS value = 11111).

When the decompressor receives this value, it first attempts to estimate the timestamp by computing the time difference between the last reference established and the current packet

T_current - T_ref, where T_ref is the value of the wall clock time at which the reference headers was received by the decompressor

That value is added to p_TS_ref, the packed RTP TS of the reference header, to get the estimate.

Assume that at the decompressor packet #3 is used as the reference:
- T_current = 359
- T_ref = 7
- p_TS_ref = 4

### Note:

T_current is picked here as any value; the difference between it and T_ref represents the length of the silence interval as observed at the decompressor. Then: $T _current - T _ref = 359 - 7 = 352$$p _ T S _current ( estimate ) = 352 + 4 = 356$

The decompressor searches for the closest value to 356 which has, in this case, LSBs = 11111. The value in this case is 351, the original p_TS.

If instead the compressor were to send the timestamp jump as simply the difference in consecutive packed RTP Timestamps, that value would be $p _ T S _current - p _ T S _ref = 351 - 4 = 347 = 101011011$

So over twice as many bits would be sent for a silence interval of $347 ( 20 ms ) = 6.94 seconds$

Due to basic conversational real-time requirements, the cumulative jitter in normal operation is expected to be at most only a few times T stride for voice. For this reason, the FO payload formats in section 4.3 are optimized (in terms of representing different k-length encoded TS values) for the case of k=4 (handles up to 16 discrepencies in the timestamp). The remaining formats allow a wide range of jitter conditions (outside of just voice) to be handled as well.

This Internet-Draft expires March 17, 2001.

## Claims

1. A method for compressing a Real Time Protocol, RTP, packet stream arriving at a compressor comprising:
acquiring a pattern at the compressor, the pattern comprising a timestamp, TS, function, a marker bit, M-bit, function, a quotierit and a TS increment;
making sure a decompressor is synchronized with the compressor according to the pattern, the step of making sure comprising sending the pattern to the decompressor; and
sending a compressed packet according to the pattern, the method being **characterised in that**:
acquiring the pattern comprises expressing the TS function as a staircase function of the packet sequence number, SN, the staircase function having at least one staircase step.

2. The method for compressing of claim 1 wherein the pattern comprises a M-bit function wherein the M-bit is set for a last packet of the staircase step

3. The method for compressing of claim 2 wherein the M-bit is set only for the last packet of the staircase step.

4. The method of claim 3 wherein the step of making sure further comprises receiving an indication having a marker bit set.

5. The method of claim 3 wherein the step of making sure further comprises:
receiving a first ack; and
receiving a second ack.

6. The method of claim 3 wherein the step of making sure further comprises pattern detecting at least two packets.

7. The method of claim 6 wherein the step of pattern detecting comprises acknowledging the at least two packets.

8. The method of claim 6 wherein the at least two packets comprise a first packet and a second packet and the steps prior to pattern detecting comprise:
receiving a first acknowledgement having at least the first packet; and
receiving a second acknowledgement having at least the second packet.

9. The method of claim 3 wherein the RTP packet stream comprises a first packet having a first sequence number and a first M bit, said stream comprising a second packet having a second sequence number and a second M bit, the method further comprises:
acquiring the first packet and the second packet; and
detecting that the second sequence number is one more than the first
sequence number and that the first M bit and the second M bit are set.

10. The method for compressing of claim 3 wherein the step of sending the pattern further comprises explicitly sending the pattern from the compressor to the decompressor.

11. A compressor for compressing a Real Time Protocol, RTP, packet stream comprising:
means for acquiring a pattern at the compressor, the pattern comprising a timestamp, TS, function, a marker bit, M-bit, function, a quotient and a TS increment:
means for making sure a decompressor is synchronized with the compressor according to the pattern, the means for making sure comprising means for sending the pattern to the decompressor; and
means for sending a compressed packet according to the pattern;
the compressor being **characterised by**:
the means for acquiring the pattern being adapted to express the TS function as a staircase function of the packet sequence number, SN, the staircase function having at least one staircase step.

12. The compressor for compressing of claim 11 wherein the pattern comprises a M-bit function wherein the M-bit is set for a last packet of the staircase step

13. The compressor for compressing of claim 12 wherein the M-bit is set only for the last packet of the staircase step.

14. The compressor of claim 13 wherein the means for making sure further comprises a means for receiving an indication having a marker bit set.

15. The compressor of claim 13 wherein the a means for making sure further comprises:
a means for receiving a first ack; and
a means for receiving a second ack.

16. The compressor of claim 13 wherein the means for making sure further comprises a means for pattern detecting at least two packets.

17. The compressor of claim 16 wherein the means for pattern detecting comprises a means for acknowledging the at least two packets.

18. The compressor of claim 16 wherein the at least two packets comprise a first packe and a second packet further comprise:
a means for receiving a first acknowledgement having at least the first packet; and
a means for receiving a second acknowledgement having at least the second packet.

19. The compressor of claim 13 wherein the RTP packet stream comprises a first packet having a first sequence number and a first M bit, said stream comprising a second packet having a second sequence number and a second M bit, the compressor further comprises:
a means for acquiring the first packet and the second packet; and
a means for detecting that the second sequence number is one more than the first sequence number and that the first M bit and the second M bit are set.

20. The compressor for compressing of claim 13 wherein the means for sending the pattern further comprises a means for explicitly sending the pattern from the compressor to the decompressor.

## Patentansprüche

1. Verfahren zum Komprimieren eines Echtzeitprotokoll-, RTP,-Paketdatenstroms, welcher an einer Komprimierungseinrichtung eintrifft, umfassend:
Erhalten eines Musters an der Komprimierungseinrichtung, wobei das Muster eine Zeitstempel-,TS,-Funktion, eine Markierungs-Bit-, M-bit, Funktion, einen Quotienten und eine TS-Schrittgröße umfasst;
Sicherstellen, dass eine Dekomprimierungseinrichtung mit der Komprimierungseinrichtung gemäß dem Muster synchronisiert ist, wobei der Schritt des Sicherstellens ein Senden des Musters an die Dekomprimierungseinrichtung umfasst; und
Senden eines komprimierten Pakets gemäß dem Muster, wobei das Verfahren **dadurch gekennzeichnet ist, dass**
das Erhalten des Musters umfasst, die TS-Funktion als eine Treppenfunktion der Paketsequenznummer, SN, auszudrücken, wobei die Treppenfunktion mindestens eine Treppenstufe aufweist.

2. Verfahren zum Komprimieren nach Anspruch 1, wobei das Muster eine M-bit-Funktion umfasst, wobei das M-bit für ein letztes Paket der Treppenstufe gesetzt wird.

3. Verfahren zum Komprimieren nach Anspruch 2, wobei das M-bit nur für das letzte Paket der Treppenstufe gesetzt wird.

4. Verfahren nach Anspruch 3, wobei der Schritt des Sicherstellens weiter ein Empfangen einer Angabe umfasst, welche ein Markierungsbit gesetzt hat.

5. Verfahren nach Anspruch 3, wobei der Schritt des Sicherstellens weiter umfasst:
Empfangen einer ersten Bestätigung; und
Empfangen einer zweiten Bestätigung.

6. Verfahren nach Anspruch 3, wobei der Schritt des Sicherstellens weiter umfasst, eine Mustererkennung von mindestens zwei Paketen auszuführen.

7. Verfahren nach Anspruch 6, wobei der Schritt der Mustererkennung umfasst, die mindestens zwei Pakete zu bestätigen.

8. Verfahren nach Anspruch 6, wobei die mindestens zwei Pakete ein erstes Paket und ein zweites Paket umfassen und die Schritte vor der Mustererkennung umfassen:
Empfangen einer ersten Bestätigung mit mindestens dem ersten Paket; und
Empfangen einer zweiten Bestätigung mit mindestens dem zweiten Paket.

9. Verfahren nach Anspruch 3, wobei der RTP-Paketdatenstrom ein erstes Paket umfasst, welches eine erste Sequenznummer und ein erstes M-bit aufweist, wobei der Datenstrom ein zweites Paket umfasst, welches eine zweite Sequenznummer und ein zweites M-bit aufweist, wobei das Verfahren weiter umfasst:
Erhalten des ersten Pakets und des zweiten Pakets; und
Erkennen, dass die zweite Sequenznummer um eins größer als die erste Sequenznummer ist, und dass das erste M-bit und das zweite M-bit gesetzt sind.

10. Verfahren zum Komprimieren nach Anspruch 3, wobei der Schritt des Sendens des Musters weiter umfasst, explizit das Muster von der Komprimierungseinrichtung an die Dekomprimierungseinrichtung zu senden.

11. Komprimierungseinrichtung zum Komprimieren eines Echtzeitprotokoll-, RTP Paketdatenstroms, umfassend:
Mittel zum Erhalten eines Musters an der Komprimierungseinrichtung, wobei das Muster eine Zeitstempel-, TS,-Funktion, eine Markierungsbit, M-bit, -Funktion, einen Quotienten und eine TS-Schrittgröße umfasst;
Mittel zum Sicherstellen, dass eine Dekomprimierungseinrichtung mit der Komprimierungseinrichtung gemäß dem Muster synchronisiert ist, wobei die Mittel zum Sicherstellen Mittel umfassen, um das Muster an die Dekomprimierungseinheit zu senden; und
Mittel zum Senden eines komprimierten Pakets gemäß dem Muster;
wobei die Komprimierungseinrichtung **dadurch gekennzeichnet ist, dass**
die Mittel zum Erhalten des Musters angepasst sind, um die TS-Funktion als eine Treppenfunktion der Paketsequenznummer SN auszudrücken, wobei die Treppenfunktion mindestens eine Treppenstufe aufweist.

12. Komprimierungseinrichtung zum Komprimieren nach Anspruch 11, wobei das Muster eine M-bit-Funktion umfasst, wobei das M-bit für ein letztes Paket der Treppenstufe gesetzt ist.

13. Komprimierungseinrichtung zum Komprimieren nach Anspruch 12, wobei das M-bit nur für das letzte Paket der Treppenstufe gesetzt ist.

14. Komprimierungseinrichtung nach Anspruch 13, wobei das Mittel zum Sicherstellen weiter ein Mittel zum Empfangen einer Angabe mit einem gesetzten Markierungs-bit umfasst.

15. Komprimierungseinrichtung nach Anspruch 13, wobei das Mittel zum Sicherstellen weiter umfasst:
ein Mittel zum Empfangen einer ersten Bestätigung; und
ein Mittel zum Empfangen einer zweiten Bestätigung.

16. Komprimierungseinrichtung nach Anspruch 13, wobei das Mittel zum Sicherstellen weiter ein Mittel zur Mustererkennung von mindestens zwei Paketen umfasst.

17. Komprimierungseinrichtung nach Anspruch 16, wobei das Mittel zur Mustererkennung ein Mittel zum Bestätigen der mindestens zwei Pakete umfasst.

18. Komprimierungseinrichtung nach Anspruch 16, wobei die mindestens zwei Pakete ein erstes Paket und ein zweites Paket umfassen, weiter umfassend:
ein Mittel zum Empfangen einer ersten Bestätigung mit mindestens dem ersten Paket; und
ein Mittel zum Empfangen einer zweiten Bestätigung mit mindestens dem zweiten Paket.

19. Komprimierungseinrichtung nach Anspruch 13, wobei der RTP-Paketdatenstrom ein erstes Paket umfasst, welches eine erste Sequenznummer und ein erstes M-bit aufweist,
wobei der Datenstrom ein zweites Paket umfasst, welches eine zweite Sequenznummer und ein zweites M-bit aufweist, wobei die Komprimierungseinrichtung weiter umfasst:
ein Mittel zum Erhalten des ersten Pakets und des zweiten Pakets; und
ein Mittel zum Erkennen, dass die zweite Sequenznummer um eins größer als die erste Sequenznummer ist und dass das erste M-bit und das zweite M-bit gesetzt sind.

20. Komprimierungseinrichtung zum Komprimieren nach Anspruch 13, wobei das Mittel zum Senden des Musters weiter ein Mittel umfasst, um explizit das Muster von der Komprimierungseinrichtung an die Dekomprimierungseinrichtung zu senden.

## Revendications

1. Procédé de compression d'un flux RTP (Protocole Temps Réel) en paquets arrivant sur un compresseur, comprenant les étapes consistant à :
acquérir une configuration au compresseur, la, configuration comprenant un horodateur (fonction TS), un élément binaire marqueur (fonction élément binaire M), un quotient et un incrément de TS ;
s'assurer qu'un décompresseur est synchronisé avec le compresseur en conformité avec la configuration, l'étape d'assurance comprenant l'envoi de la configuration au décompresseur ; et
adresser un paquet comprimé en conformité avec la configuration, le procédé étant **caractérisé en ce que** :
l'acquisition de la configuration comprend l'expression de la fonction TS sous la forme d'une fonction en escalier du nombre SN de séquence du paquet, la fonction en escalier ayant au moins une marche d'escalier.

2. Procédé de compression selon la revendication 1, dans lequel la configuration, comprend une fonction élément binaire M dans laquelle 1'élément binaire M est fixé pour un dernier paquet de la marche d'escalier.

3. Procédé de compression selon la revendication 2, dans lequel l'élément binaire M n'est fixé que pour le dernier paquet de la marche d'escalier.

4. Procédé selon la revendication 3, dans lequel l'étape d'assurance comprend en outre la réception d'une indication comportant la fixation d'un élément binaire de marqueur.

5. Procédé selon la revendication 3, dans lequel l'étape d'assurance comprend en outre :
la réception d'un premier accusé de réception ; et
la réception d'un deuxième accusé de réception.

6. Procédé selon la revendication 3, dans lequel l'étape d'assurance comprend en outre une détection de configuration sur au moins deux paquets.

7. Procédé selon la revendication 6, dans lequel l'étape de détection de configuration comprend un accusé de réception d'au moins deux paquets.

8. Procédé selon la revendication 6, dans lequel les au moins deux paquets comprennent un premier paquet et un deuxième paquet et les étapes antérieures à la détection de configuration comprennent :
la réception d'un premier accusé de réception comportant au moins le premier paquet ; et
la réception d'un deuxième accusé de réception comportant au moins le deuxième paquet.

9. Procédé selon la revendication 3, dans lequel le flux de paquets RTP comprend un premier paquet ayant un premier nombre de séquence et un premier élément binaire M, ledit flux comprenant un deuxième paquet ayant un deuxième nombre de séquence et un deuxième élément binaire M, le procédé comprenant en outre :
l'acquisition du premier paquet et du deuxième paquet ; et
la détection du fait que le deuxième nombre de séquence est supérieur de un au premier nombre de séquence et que le premier élément binaire M et le deuxième élément binaire M sont fixés.

10. Procédé de compression selon la revendication 3, dans lequel l'étape consistant à adresser la configuration comprend en outre l'envoi explicite de la configuration du compresseur au décompresseur.

11. Compresseur destiné à comprimer un flux RTP (Protocole Temps Réel) en paquets comprenant :
un moyen d'acquisition d'une configuration au compresseur, la configuration comprenant un horodateur (fonction TS), un élément binaire marqueur (fonction élément binaire M), un quotient et un incrément de TS ;
un moyen de s'assurer qu'un décompresseur est synchronisé avec le compresseur en conformité avec la configuration, le moyen d'assurance comprenant un moyen d'envoi de la configuration au décompresseur ; et
un moyen d'adresser un paquet comprimé en conformité avec la configuration ;
le compresseur étant **caractérisé en ce que** :
le moyen d'acquisition de la configuration est adapté à exprimer la fonction TS sous la forme d'une fonction en escalier du nombre SN de séquence du paquet, la fonction en escalier ayant au moins une marche d'escalier.

12. Compresseur pour compression selon la revendication 11, dans lequel la configuration comprend une fonction élément binaire M dans laquelle l'élément binaire M est fixé pour un dernier paquet de la marche d'escalier.

13. Compresseur pour compression selon la revendication 12, dans lequel l'élément binaire M n' est fixé que pour le dernier paquet de la marche d'escalier.

14. Compresseur selon la revendication 13, dans lequel le moyen d'assurance comprend en outre un moyen de recevoir une indication comportant la fixation d'un élément binaire de marqueur.

15. Compresseur selon la revendication 13, dans lequel le moyen d'assurance comprend en outre :
un moyen de réception d'un premier accusé de réception ; et
un moyen de réception d'un deuxième accusé de réception.

16. Compresseur selon la revendication 13, dans lequel le moyen d'assurance comprend en outre un moyen de détection de configuration sur au moins deux paquets.

17. Compresseur selon la revendication 16, dans lequel le moyen de détection de configuration comprend un moyen d'accusé de réception d'au moins deux paquets.

18. Compresseur selon la revendication 16, dans lequel les au moins deux paquets comprennent un premier paquet et un deuxième paquet comprennent en outre :
un moyen de réception d'un premier accusé de réception comportant au moins le premier paquet ;et
un moyen de réception d'un deuxième accusé de réception comportant au moins le deuxième paquet.

19. Compresseur selon la revendication 13, dans lequel le flux de paquets RTP comprend un premier paquet ayant un premier nombre de séquence et un premier élément binaire M, ledit flux comprenant un deuxième paquet ayant un deuxième nombre de séquence et un deuxième élément binaire M, le compresseur comprenant en outre :
un moyen d'acquisition du premier paquet et du deuxième paquet ; et
un moyen de détection du fait que le deuxième nombre de séquence est supérieur de un au premier nombre de séquence et que le premier élément binaire M et le deuxième élément binaire M sont fixés.

20. Compresseur pour compression selon la revendication 13, dans lequel le moyen d'envoi de la configuration comprend en outre un moyen d'envoi explicite de la configuration du compresseur au décompresseur.
